# EUROPEAN PATENT APPLICATION

(11) **EP 4 290 309 A1**
(43) Date of publication of application: **13.12.2023**
(21) Application number: 23178037.0
(22) Date of filing: 07.06.2023
(51) Int. Cl.: G03F 7/09

(54) **RESIST UNDERLAYER FILM MATERIAL, PATTERNING PROCESS, AND METHOD FOR FORMING RESIST UNDERLAYER FILM**

(30) Priority: 10.06.2022 JP 2022094363
(71) Applicant: SHIN-ETSU CHEMICAL CO., LTD., Tokyo 1000005 (JP)
(72) Inventor: Nakahara, Takayoshi, Niigata (JP); Biyajima, Yusuke, Niigata (JP); Kori, Daisuke, Niigata (JP); Niida, Keisuke, Niigata (JP); Harada, Yuji, Niigata (JP)
(74) Representative: Sonnenhauser, Thomas Martin

(57) **Abstract**

The present invention is a resist underlayer film material, including: (A) a compound or resin having a phenolic hydroxy group; (B) a base generator; and (C) an organic solvent. By the above configuration, the present invention provides: a resist underlayer film material that can form a resist underlayer film having excellent planarizing ability and film formability even on a substrate to be processed having a portion with particular difficulty in planarization, such as a wide trench structure, and that yields a resist underlayer film having an appropriate etching characteristic in a fine patterning process with a multilayer resist method in a semiconductor apparatus manufacturing process; and a patterning process and method for forming a resist underlayer film using the above material.

## Description

### TECHNICAL FIELD

The present invention relates to a resist underlayer film material usable for fine patterning with a multilayer resist method in semiconductor apparatus manufacturing process, a patterning process using this material, and a method for forming a resist underlayer film.

### BACKGROUND ART

As higher integration and higher speed of LSI have been achieved, the pattern size has been rapidly miniaturized. With this miniaturization, lithography techniques have achieved formation of the fine pattern by shortening a wavelength of a light source and appropriately selecting a resist composition corresponding to the wavelength. The center of the resist composition is a positive-type photoresist composition used for a single layer. This single-layer positive-type photoresist composition has a resist resin containing a skeleton having etching resistance against dry etching with chlorine-based or fluorine-based gas plasma, and has a switching mechanism so that an exposed portion is dissolved to form a pattern by dissolving the exposed portion. While using the remained resist pattern as an etching mask, a substrate to be processed is processed by dry etching.

However, miniaturing the pattern, that is reducing the pattern width, with keeping a thickness of the used photoresist film causes a problem of deteriorating resolution performance of the photoresist film. In addition, pattern-developing such a photoresist film with a developer results in an excessively high "aspect ratio", and this consequently causes a problem of pattern collapse. To prevent the problem, the photoresist film has been thinned as the pattern has been miniaturized.

Meanwhile, commonly used for processing a substrate to be processed is a method of processing the substrate by dry etching while using a patterned photoresist film as an etching mask. However, there is realistically no dry etching method that can have complete etching selectivity between the photoresist film and the substrate to be processed. Thus, there is a problem of collapse of the resist film with damaged during the substrate processing to fail to precisely transfer the resist pattern to the substrate to be processed. Accordingly, as the pattern has been miniaturized, the photoresist composition is required to have higher dry etching resistance. However, on the other hand, a resin used for the photoresist composition is required to have a small light absorption at the exposure wavelength to improve the resolution. Thus, as the wavelength of the exposure light has become shorter to i-line, KrF, and ArF, the resin has also changed to a novolac resin, polyhydroxystyrene, and a resin having an aliphatic polycyclic skeleton. However, the etching rate under the dry etching condition during the substrate processing has become realistically high, and recent photoresist compositions having high resolution rather tend to have weak etching resistance.

Thus, the substrate to be processed is required to be processed by dry etching with the photoresist film having a smaller thickness and weaker etching resistance. It is important to achieve a material and process for this processing.

One of methods to solve such a problem is a multilayer resist method. This method is of:
interposing an intermediate film having etching selectivity differing from etching selectivity of a photoresist film (that is, a resist upper layer film) between the resist upper layer film and a substrate to be processed; obtaining a pattern in the resist upper layer film; then transferring the pattern to the intermediate film by dry etching while using the resist upper layer film pattern as a dry etching mask; and
further transferring the pattern to the substrate to be processed by dry etching while using the intermediate film as a dry etching mask.

One of the multilayer resist methods is a three-layer resist method that can be performed by using a common resist composition used for the single-resist method. In this three-layer resist method, for example, an organic film of a novolac resin, etc. is formed on a substrate to be processed as a resist underlayer film, a silicon-containing film is formed thereon as a resist intermediate film, and a common organic photoresist film is formed thereon as a resist upper layer film. The organic resist upper layer film can have good etching selectivity to the silicon-containing resist intermediate film when the dry etching is performed with fluorine-based gas plasma. Thus, the resist upper layer film pattern can be transferred to the silicon-containing resist intermediate film by dry etching with the fluorine-based gas plasma. According to this method, the pattern can be transferred to the silicon-containing film (resist intermediate film) even by using a resist composition that is difficult to form a pattern having a film thickness sufficient for directly processing the substrate to be processed or by using a resist composition that has dry etching resistance insufficient for processing the substrate. Subsequently transferring the pattern by dry etching with oxygen-based or hydrogen-based gas plasma can yield an organic film (resist underlayer film) pattern of the novolac resin, etc. that has dry etching resistance sufficient for processing the substrate. As the aforementioned resist underlayer film, many materials including, for example, materials described in Patent Document 1, have been already known.

In recent years, investigation for manufacturing semiconductor apparatuses having novel structures such as a multi-gate structure has been activated, and corresponding thereto, excellent planarizing ability and filling ability to the resist underlayer film compared with conventional ones have been increasingly demanded. For example, when a substrate to be processed being a base has a fine-pattern structure such as a hole, a trench, and a fin, required is gap-filling ability for filling the pattern with the resist underlayer film without a void. When a substrate to be processed being a base has a step or when a substrate to be processed being a base has a pattern-dense region and a patternless region in one wafer, the film surface is needed to be planarized with the resist underlayer film. The planarization of the underlayer film surface can inhibit variation of a film thickness of the resist intermediate film and resist upper layer film, which are formed thereon, and can reduce decrease in focus margin of the lithography or margin in a subsequent step of processing the substrate to be processed.

The organic film material having excellent filling/planarizing ability can be widely applied for not only the underlayer film for the multilayer resist but also, for example, a planarizing material for semiconductor apparatus manufacturing, such as substrate planarization prior to patterning with nanoimprinting. Although CMP process is commonly used for global planarization in the semiconductor apparatus manufacturing process at present, the CMP is high-cost process, and the above organic film material is promising also for a material for the global planarization instead of the CMP.

For forming a planarizing film for planarizing a semiconductor substrate having a concavity and convexity, proposed is a resist underlayer film material containing a compound having a low viscosity and high thermal flowability (Patent Document 2). This material, however, has a problem of considerably decreased wetting ability to a hydrophobic substrate treated with, for example, hexamethyldisilazane (hereinafter, referred to as HMDS) to be likely to cause a pinhole or deterioration in a film edge. Furthermore, in the latest devices, the resist underlayer film also becomes thin by thinning of the resist upper layer film with the pattern miniaturization, which makes it difficult to achieve the wetting ability. To improve the wetting ability of the underlayer film material, it is effective to improve adhesive force to the substrate, and proposed is a resist underlayer film material having a constituent of an amide structure as a polar functional group (Patent Document 3). Although having both of wetting ability on a silicon substrate and planarizing ability, this resist underlayer film material has insufficient wetting ability to a hydrophobic substrate. As noted above, required are: an underlayer film material having all of excellent planarizing ability, excellent wetting ability to a hydrophobic substrate, and sufficient etching resistance; and a patterning process using this material.

As noted above, the substrate to be processed has had a complex structure. In addition, for a surface of the substrate to be processed, a novel material using strained silicon or gallium-arsenic with high electron mobility or ultrathin polysilicon controlled in angstrom level have been investigated, and the underlayer film material is forecasted to be formed on various surface shapes and materials of the substrates to be processed. Thus, important properties to achieve the process margin are not only excellent planarizing ability but also film formability without dependency on the material and shape of the substrate to be processed.

### CITATION LIST

### PATENT LITERATURE

Patent Document 1: JP 2004-205685 A
Patent Document 2: JP 2017-119670 A
Patent Document 3: JP 2021-196467 A

### SUMMARY OF INVENTION

### TECHNICAL PROBLEM

The present invention has been made in view of the above circumstances. An object of the present invention is to provide a resist underlayer film material: that can form a resist underlayer film having excellent planarizing ability and film formability even on a substrate to be processed having a portion with particular difficulty in planarization, such as a wide trench, in the fine patterning process with the multilayer resist method in the semiconductor apparatus manufacturing process; and that yields a resist underlayer film having further appropriate etching characteristic. In addition, an object of the present invention is to provide a patterning process and method for forming a resist underlayer film using the above material.

### SOLUTION TO PROBLEM

To solve the above problem, the present invention provides a resist underlayer film material comprising:
(A) a compound or resin having a phenolic hydroxy group;
(B) a base generator; and
(C) an organic solvent.

Such a resist underlayer film material can form a resist underlayer film having excellent planarizing ability and film formability even on a substrate to be processed having a portion with difficulty in planarization in the fine patterning process with the multilayer resist method. This underlayer film further has appropriate etching property, and a resist underlayer film having excellent film formability to a hydrophobic substrate such as, for example, an HMDS-treated substrate, can be formed.

The component (A) preferably has a weight-average molecular weight of 3,000 or less in terms of polystyrene.

Such a resist underlayer film material, which has a low viscosity and high thermal flowability, can form a resist underlayer film having both of excellent planarizing ability and excellent film formability to a hydrophobic substrate.

The base generator (B) is preferably a compound to exhibit basicity by pyrolysis.

Such a resist underlayer film material is presumed to have excellent film formability because ionicity of the phenolic hydroxy group increases an interaction with the substrate while baking the film. Regulating the addition amount can achieve both of the thermal flowability and the interaction with the substrate.

The base generator (B) is preferably any one represented by the following general formulae (1), (2), and (3),

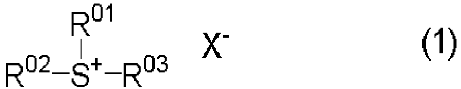

R⁰⁴-I⁺-_{R}⁰⁵ X⁻ (2)

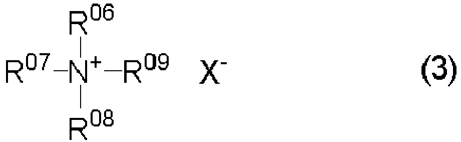

wherein R⁰¹ to R⁰³ each independently represent a linear, branched, or cyclic alkyl group or alkenyl group having 1 to 10 carbon atoms, optionally substituted with a heteroatom or optionally having an interposed heteroatom, or represent an aryl group or aralkyl group having 6 to 18 carbon atoms, optionally substituted with a heteroatom or optionally having an interposed heteroatom; any two of R⁰¹, R⁰², and R⁰³ are optionally bonded to each other to form a ring together with the sulfur atom in the formula; X⁻ represents an organic or inorganic anion to be a counterion, X⁻ excluding OH⁻; R⁰⁴ and R⁰⁵ each independently represent an aryl group having 6 to 20 carbon atoms, and a part or all of hydrogen atoms thereof are optionally substituted with a linear, branched, or cyclic alkyl group or alkoxy group having 1 to 10 carbon atoms; R⁰⁴ and R⁰⁵ are optionally bonded to each other to form a ring together with the iodine atom in the formula; R⁰⁶, R⁰⁷, R⁰⁸, and R⁰⁹ each independently represent a hydrogen atom, or a linear, branched, or cyclic alkyl group or alkenyl group having 1 to 20 carbon atoms, optionally substituted with a heteroatom or optionally having an interposed heteroatom, or represent an aryl group or aralkyl group having 6 to 18 carbon atoms, optionally substituted with a heteroatom or optionally having an interposed a heteroatom; any two or more of R⁰⁶, R⁰⁷, R⁰⁸, and R⁰⁹ are optionally bonded to each other to form a ring together with the nitrogen atom in the formula.

X⁻ in the general formulae (1), (2), and (3) more preferably represents an anion selected from the group consisting of a chloride ion, a bromide ion, an iodide ion, a fluoride ion, a cyanide ion, a nitride ion, a nitrite ion, and any anions represented by the following general formulae (4), (5), and (6),

R¹⁰-COO⁻ (4)

R¹¹-SO₃⁻ (5)

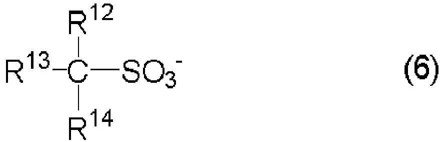

wherein R¹⁰ represents a linear, branched, or cyclic hydrocarbon group having 1 to 20 carbon atoms selected from an alkyl group, an alkenyl group, an aralkyl group, and an aryl group, the hydrocarbon group optionally having an ether group, an ester group, or a carbonyl group, and optionally substituted one or more of hydrogen atoms thereof with a halogen atom, a hydroxy group, a carboxyl group, an amino group, and a cyano group; R¹¹ represents an aryl group having 1 to 20 carbon atom, and optionally substituted one or more of hydrogen atoms thereof with a halogen atom, a hydroxy group, a carboxyl group, an amino group, and a cyano group; R¹², R¹³, and R¹⁴ each independently represent a hydrogen atom, a halogen atom other than a fluorine atom, or a linear, branched, or cyclic hydrocarbon group having 1 to 20 carbon atoms selected from an alkyl group, an alkenyl group, an aralkyl group, and an aryl group, the hydrocarbon group optionally having an ether group, an ester group, or a carbonyl group, and optionally substituted one or more of hydrogen atoms thereof with a halogen atom, a hydroxy group, a carboxyl group, an amino group, and a cyano group; and two or more of R¹², R¹³, and R¹⁴ are optionally bonded to each other to form a ring.

A conjugate acid of X⁻, X-H, in the general formulae (1), (2), and (3) further preferably has a boiling point of 200°C or lower.

Appropriately selecting such base generators to exhibit basicity with pyrolysis (thermal base generator) can exhibit basicity corresponding to the baking temperature of the resist underlayer film material and can achieve both of the film formability and the planarizing ability. In addition, since the entirety of the thermal base generator is decomposed or evaporated during the baking and no thermal base generator remains in the baked film, properties other than the film formability are not adversely affected. The boiling point herein is a value under 1 atm (1013 hPa).

The compound (A) having a phenolic hydroxy group is preferably represented by the following general formula (7), 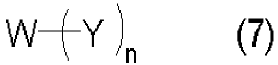
wherein W represents an n-valent organic group having 2 to 50 carbon atoms; Y represents a terminal group structure represented by the following general formula (8) or general formula (9); proportions of structures represented by the formula (8) and (9) satisfy relationships of a + b = 1.0, 0.70 ≤ a ≤ 0.99, and 0.01 ≤ b ≤ 0.30, where "a" represents a proportion of the structure represented by the formula (8) and "b" represents a proportion of the structure represented by the formula (9); and "n" represents an integer of 1 to 10, 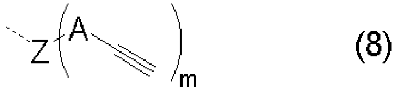
wherein a broken line represents a bond; Z represents an (m + 1)-valent aromatic group having 6 to 20 carbon atoms; A represents a single bond or -O-(CH₂)ₚ-; "m" represents an integer of 1 to 5; and "p" represents an integer of 1 to 10, 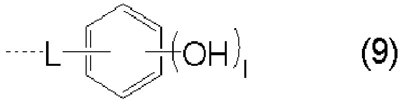
wherein a broken line represents a bond; L represents a single bond or -(CH₂)ᵣ-; "l" represents 2 or 3; and "r" represents an integer of 1 to 5.

Such a resist underlayer film material can form a resist underlayer film having excellent planarizing ability and film formability even on a substrate to be processed having a portion with particular difficulty in planarization such as a wide trench. In addition, the resist underlayer film material having "a" and "b" satisfying the above relationships can form a resist underlayer film having both of the planarizing ability and the film formability.

A in the general formula (8) preferably represents -OCH₂- .

Such a resist underlayer film material reduces film shrinkage due to the thermal curing, and can form a resist underlayer film having excellent planarizing ability.

The general formula (8) is preferably any one of the following formulae (10), (11), and (12), 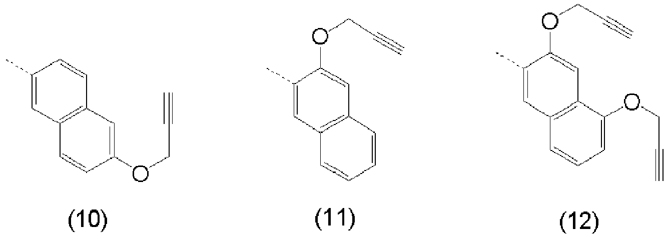 wherein a broken line represents a bond.

Such a resist underlayer film material can impart not only the effect of improving the planarizing ability with the reduction in the shrinkage but also properties such as heat resistance and etching resistance, and can form a resist underlayer film having excellent process margin.

The general formula (9) is preferably the following formula (13) or (14), 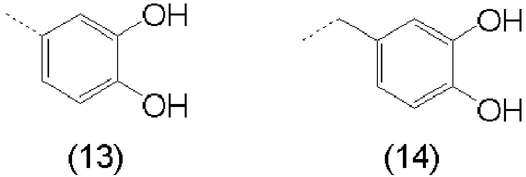 wherein a broken line represents a bond.

Introducing such a terminal group structure into the resist underlayer film material can impart adhesiveness to the substrate, and can yield remarkable effect of improving the film formability with combining the thermal base generator. In particular, the terminal group structure is effective to inhibit deterioration in the film edge.

W in the general formula (7) is preferably represented by the following general formula (15), 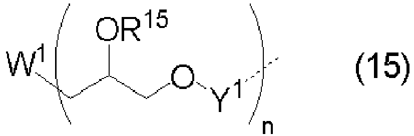 wherein a broken line represents a bond; R¹⁵ represents a hydrogen atom, or one hydrocarbon group of an alkyl group or acyl group, the group having 1 to 20 carbon atoms and optionally having an oxygen atom or a nitrogen atom; W¹ represents an n-valent organic group having 1 to 47 carbon atoms; Y¹ represents a single bond or a carbonyl group; and "n" represents an integer of 1 to 10.

W¹ in the general formula (15) more preferably represents a structure represented by any one of the following formulae, 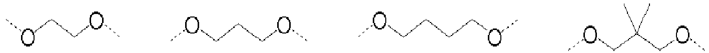 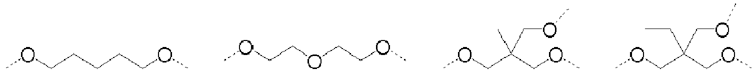 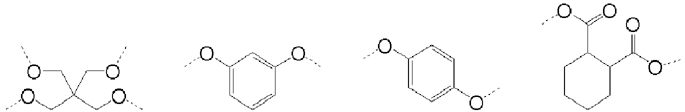 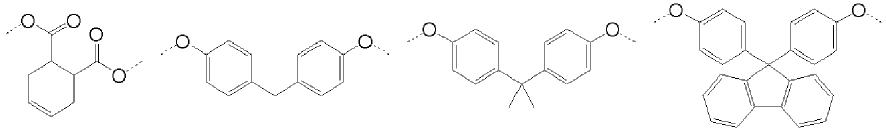 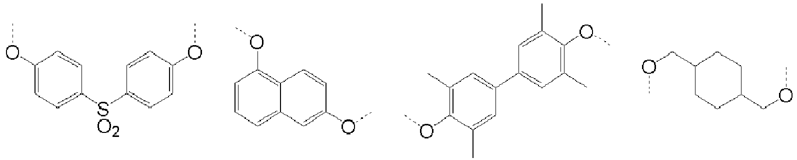 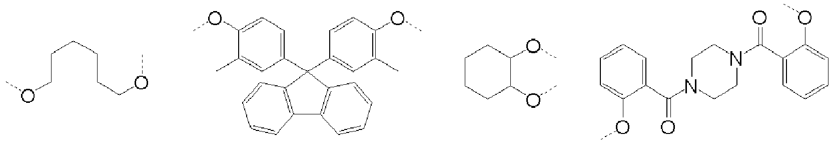 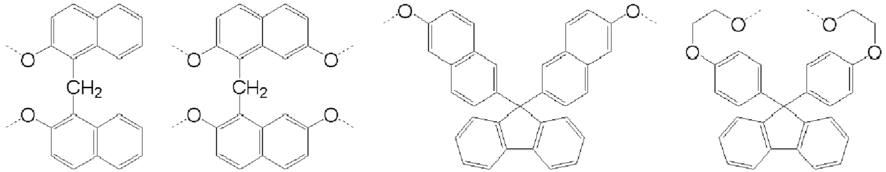 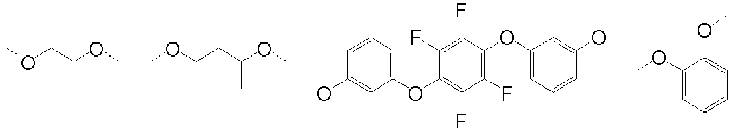 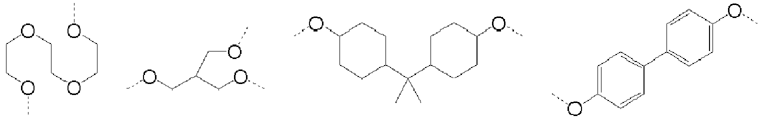 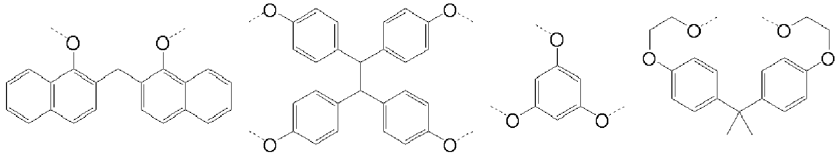 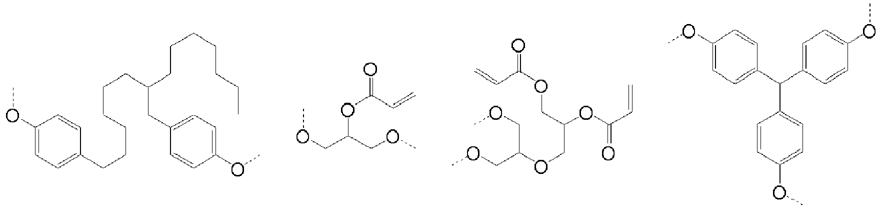 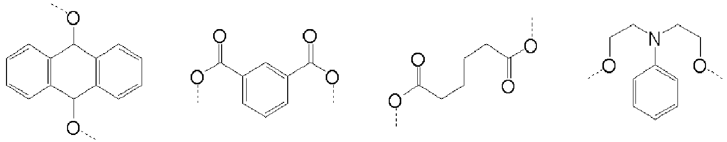 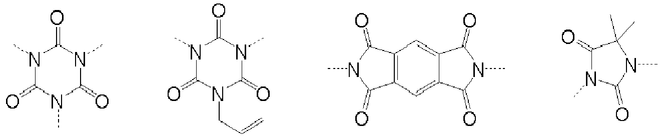 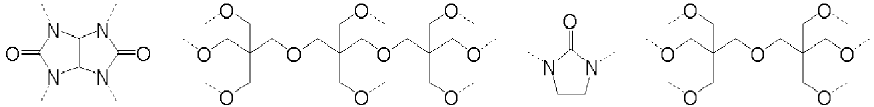 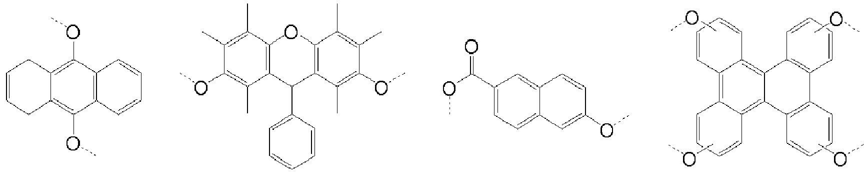 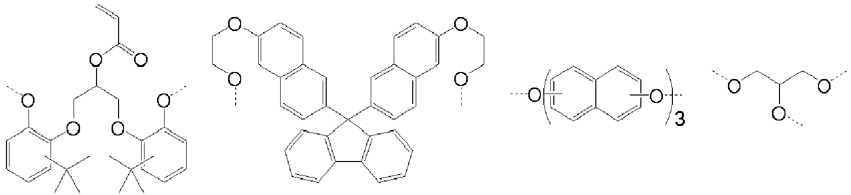 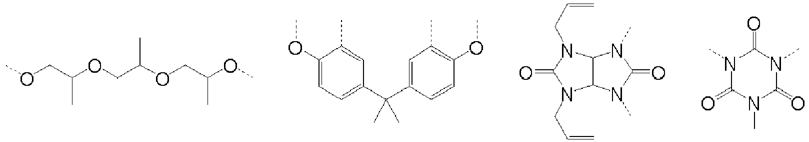 wherein a broken line represents a bond.

Such a resist underlayer film material can form a resist underlayer film having excellent film formability and planarizing ability, and can be particularly easily manufactured.

The organic solvent (C) is preferably a mixture of one or more kinds of organic solvents having a boiling point of lower than 180°C and one or more kinds of organic solvents having a boiling point of 180°C or higher.

Such a resist underlayer film material can yield further better planarizing ability of the resist underlayer film to be formed regardless of design of the substrate to be processed, such as sparsity and density of patterns.

The inventive resist underlayer film material can further comprise one or more of (D) a surfactant, (E) a crosslinker, (F) a plasticizer, and (G) a colorant.

As above, into the inventive resist underlayer film material, the surfactant (D) can be added to improve coatability with spin-coating, the crosslinker (E) can be added to further promote the crosslinking curing reaction, the plasticizer (F) can be added to further improve the filling/planarizing ability, and the colorant (G) can be added to regulate a light-absorption characteristic. Presence or absence of and selecting these additives can finely regulate required performances such as film formability, curability, filling ability, and optical property, which is practically preferable.

The crosslinker (E) is preferably a compound represented by the following general formula (16), 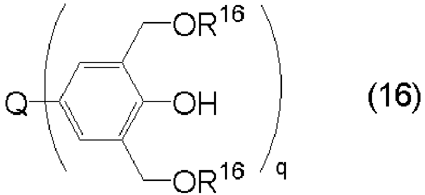 wherein Q represents a single bond or a q-valent hydrocarbon group having 1 to 20 carbon atoms; R¹⁶ represents a hydrogen atom or an alkyl group having 1 to 20 carbon atoms; and "q" represents an integer of 1 to 5.

Such a crosslinker can proceed the crosslinking reaction without adding an acid generator, and can improve the curability without impairing the effect of improving the film formability by the base generator. In addition, since the crosslinker of the general formula (16) itself has a phenolic hydroxy group, a higher effect of improving the film formability is expected with the action of the base generator.

The present invention also provides a patterning process for forming a pattern on a substrate to be processed, comprising steps of:
(I-1) applying the above resist underlayer film material on a substrate to be processed, and then heat-treating the material to form a resist underlayer film;
(I-2) forming a resist upper layer film on the resist underlayer film by using a photoresist material;
(I-3) pattern-exposing the resist upper layer film, and then developing the exposed resist upper layer film with a developer to form a pattern in the resist upper layer film;
(I-4) transferring the pattern to the resist underlayer film by dry etching while using the patterned resist upper layer film as a mask; and
(I-5) forming a pattern on the substrate to be processed by processing the substrate while using the patterned resist underlayer film as a mask.

The present invention also provides a patterning process for forming a pattern on a substrate to be processed, comprising steps of:
(II-1) applying the above resist underlayer film material on a substrate to be processed, and then heat-treating the material to form a resist underlayer film;
(II-2) forming a resist intermediate film on the resist underlayer film;
(II-3) forming a resist upper layer film on the resist intermediate film by using a photoresist material;
(II-4) pattern-exposing the resist upper layer film, and then developing the exposed resist upper layer film with a developer to form a pattern in the resist upper layer film;
(II-5) transferring the pattern to the resist intermediate film by dry etching while using the patterned resist upper layer film as a mask;
(II-6) transferring the pattern to the resist underlayer film by dry etching while using the resist intermediate film having the transferred pattern as a mask; and
(II-7) forming a pattern on the substrate to be processed by processing the substrate while using the resist underlayer film having the transferred pattern as a mask.

The present invention also provides a patterning process for forming a pattern on a substrate to be processed, comprising steps of:
(III-1) applying the above resist underlayer film material on a substrate to be processed, and then heat-treating the material to form a resist underlayer film;
(III-2) forming an inorganic hard mask intermediate film selected from a silicon oxide film, a silicon nitride film, and a silicon oxynitride film on the resist underlayer film;
(III-3) forming an organic thin film on the inorganic hard mask intermediate film;
(III-4) forming a resist upper layer film on the organic thin film by using a photoresist material;
(III-5) pattern-exposing the resist upper layer film, and then developing the exposed resist upper layer film with a developer to form a pattern in the resist upper layer film;
(III-6) transferring the pattern to the organic thin film and the inorganic hard mask intermediate film by dry etching while using the patterned resist upper layer film as a mask;
(III-7) transferring the pattern to the resist underlayer film by dry etching while using the inorganic hard mask intermediate film having the transferred pattern as a mask; and
(III-8) forming a pattern on the substrate to be processed by processing the substrate while using the resist underlayer film having the transferred pattern as a mask.

As noted above, the inventive resist underlayer film material can be suitably used for various patterning processes such as the two-layer resist process, the three-layer resist process using the resist intermediate film, and the four-layer resist process using the organic thin film in addition thereto. These patterning processes can effectively relax a concavity and convexity and a step on the substrate to be processed with formation of the resist underlayer film, and are suitable for photolithography with the resist upper layer film.

In the inventive patterning process, the inorganic hard mask intermediate film can be formed by a CVD method or an ALD method.

The inventive patterning process can combine: the inorganic hard mask intermediate film formed by a CVD method or an ALD method; and the resist underlayer film formed by a spin-coating method.

In the inventive patterning process, a substrate having a structure or step with 30 nm or more in height can be used as the substrate to be processed.

In the inventive patterning process, a substrate having a static contact angle with respect to water of 50° or more can be used as the substrate to be processed.

Since having excellent filling/planarizing ability and film formability to a hydrophobic substrate, the inventive resist underlayer film material is particularly useful for finely processing a substrate having such a structure or a step.

The present invention also provides a method for forming a resist underlayer film as an organic planarizing film used in a semiconductor apparatus manufacturing process, comprising:
applying the above resist underlayer film material on a substrate to be processed by spin-coating; and
heat-treating the substrate coated with the resist underlayer film material within a range at a temperature of 100°C or higher and 600°C or lower for 10 to 600 seconds for curing to form a resist underlayer film.

The present invention also provides a method for forming a resist underlayer film as an organic planarizing film used in a semiconductor apparatus manufacturing process, comprising:
applying the above resist underlayer film material on a substrate to be processed by spin-coating; and
heat-treating the substrate coated with the resist underlayer film material in an atmosphere with an oxygen concentration of 1 vol% or more and 21 vol% or less for curing to form a resist underlayer film.

Such a method can promote the crosslinking reaction during the formation of the resist underlayer film, and can further highly inhibit intermixing with the upper layer film. In addition, appropriately regulating the temperature, time, and oxygen concentration in the heat treatment within the above ranges can yield filling/planarizing ability and curing ability of the resist underlayer film suitable for the purpose.

The present invention also provides a method for forming a resist underlayer film as an organic planarizing film used in a semiconductor apparatus manufacturing process, comprising:
applying the above resist underlayer film material on a substrate to be processed by spin-coating; and
heat-treating the substrate coated with the resist underlayer film material in an atmosphere with an oxygen concentration of less than 1 vol% for curing to form a resist underlayer film.

Such a method can promote the crosslinking reaction during the formation of the resist underlayer film without deterioration of the substrate to be processed even when the substrate to be processed contains a material unstable for heating under an oxygen atmosphere, and can further highly inhibit intermixing with the upper layer film, which is useful.

A substrate having a structure or step with 30 nm or more in height can be used as the substrate to be processed.

A substrate having a static contact angle with respect to water of 50° or more can be used as the substrate to be processed.

Since using the inventive resist underlayer film material that can form a resist underlayer film having excellent filling/planarizing ability and excellent film formability to a hydrophobic substrate, the inventive method for forming a resist underlayer film is particularly suitable for forming the resist underlayer film on a substrate having such a structure or a step.

### ADVANTAGEOUS EFFECTS OF INVENTION

As described above, the inventive resist underlayer film material, patterning process, and method for forming a resist underlayer film are particularly suitably used for the multilayer resist process including planarizing a substrate to be processed having a step or a concavity and convexity, and extremely useful for the fine patterning for semiconductor apparatus manufacturing. In particular, in the fine patterning process with the multilayer resist method in the semiconductor apparatus manufacturing process, the present invention can provide: a resist underlayer film material that can form a resist underlayer film having excellent planarizing ability and film formability without dependency on a substrate even on a substrate to be processed having a portion with particular difficulty in planarization such as a wide trench without an acid generator, and further having appropriate etching characteristic and optical characteristic; and a patterning process and method for forming a resist underlayer film using the above material. In particular, since a base generated with the baking, etc. acts with the phenolic hydroxy group to increase its ionicity and increase the interaction with the substrate surface, generation of a pinhole or edge shrinkage (deterioration) can be inhibited even when a resist underlayer is formed on a hydrophobically treated wafer, such as an HMDS-treated wafer.

### BRIEF DESCRIPTION OF DRAWINGS

FIG. 1 is an explanatory view of an example of a patterning process of the inventive three-layer resist process.
FIG. 2 is an explanatory view of a method for evaluating edge deterioration in Example.
FIG. 3 is an explanatory view of a method for evaluating filling ability in Example.
FIG. 4 is an explanatory view of a method for evaluating planarizing ability in Example.

### DESCRIPTION OF EMBODIMENTS

As noted above, in the fine patterning process with the multilayer resist method in the semiconductor apparatus manufacturing process, there have been demands of: a resist underlayer film material that can form a resist underlayer film having excellent film formability and planarizing ability even on a substrate to be processed having a portion with particular difficulty in planarization such as a wide trench, and having further excellent filling ability and appropriate etching characteristic and optical characteristic; and a patterning process and method for forming a resist underlayer film using the above material.

The present inventors have researched various resist underlayer film materials and patterning processes to achieve high filling/planarization with the underlayer film formation and excellent formability in the multilayer lithography using the resist underlayer film. As a result, the present inventors have found that a resist underlayer film material containing a compound or resin having a phenolic hydroxy group and a base generator as main components, a patterning process and method for forming a resist underlayer film using the above material are significantly effective. This finding has led to complete the present invention.

Specifically, the present invention is a resist underlayer film material, comprising:
(A) a compound or resin having a phenolic hydroxy group;
(B) a base generator; and
(C) an organic solvent.

Hereinafter, the present invention will be described in detail, but the present invention is not limited thereto.

### <Resist Underlayer Film Material>

The inventive resist underlayer film material is usable for the multilayer resist method, as above. The inventive resist underlayer film material comprises:
(A) a compound or resin having a phenolic hydroxy group;
(B) a base generator; and
(C) an organic solvent.

### (A) Compound or Resin Having Phenolic Hydroxy Group

The inventive resist underlayer film material contains a compound or resin having a phenolic hydroxy group to have excellent affinity with a substrate, and it is considered that a resist underlayer film having excellent film formability can be formed even on a substrate to be processed having a complex fine structure or various surface materials. In particular, the resist underlayer film material has excellent film formability on an HMDS-treated hydrophobic substrate.

A formulation weight of the compound (A) having a phenolic hydroxy group is preferably 300 to 3,000, and particularly preferably 500 to 2,500. When the molecular weight is 300 or more, the formability becomes excellent and there is no risk of increase in a sublimate during the curing to contaminate the apparatus. When the molecular weight is 3,000 or less, a complex viscosity of the resin decreases during the baking to exhibit high thermal flowability and excellent planarizing/filling ability. In the present invention, the molecular weight can be a weight-average molecular weight (Mw) in terms of polystyrene by gel permeation chromatography (GPC) with tetrahydrofuran as an eluent. A number-average molecular weight (Mn) and a dispersion degree (Mw/Mn) can also be determined as above. A dispersion degree of the component (A) can be 1.0 to 2.5, and a dispersion degree of the compound having a phenolic hydroxy group is preferably 1.0 to 1.5.

Examples of the compound (A) having a phenolic hydroxy group include phenol, o-cresol, m-cresol, p-cresol, 2,3-dimethylphenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-tert-butylphenol, 3-tert-butylphenol, 4-tert-butylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, hydroquinone, 4-tert-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-tert-butyl-5-methylphenol, pyrogallol, thymol, isothymol, 4,4'-(9H-fluoren-9-ylidene)bisphenol, 2,2'-dimethyl-4,4'-(9H-fluoren-9-ylidene)bisphenol, 2,2'-diallyl-4,4'-(9H-fluoren-9-ylidene)bisphenol, 2,2'-difluoro-4,4'-(9H-fluoren-9-ylidene)bisphenol, 2,2'-diphenyl-4,4'-(9H-fluoren-9-ylidene)bisphenol, 2,2'-dimethoxy-4,4'-(9H-fluoren-9-ylidene)bisphenol, 1-naphthol, 2-naphthol, 2-methyl-1-naphthol, 4-methoxy-1-naphthol, 7-methoxy-2-naphthol, dihydroxynaphthalenes such as 1,5-dihydroxynaphthalene, 1,7-dihydroxynaphthalene, and 2,6-dihydroxynaphthalene, hydroxyanthracene, bisphenol, trisphenol, and a compound having a partial structure thereof. Examples of the resin having a phenolic hydroxy group include a novolac resin whose raw material is the above compound, a polyhydroxystyrene polymer, a naphthol-dicyclopentadiene copolymer described in JP 2004-205685 A, a fluorenebisphenol novolac resin described in JP 2005-128509 A, a fullerene having a phenol group described in JP 2006-227391 A, a bisphenol compound and a novolac resin thereof described in JP 2006-293298 A, a novolac resin of an adamantanephenol compound described in JP 2006-285095 A, and a bisnaphthol compound and a novolac resin thereof described in JP 2010-122656 A.

The compound (A) having a phenolic hydroxy group is preferably represented by the following general formula (7), 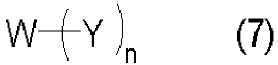
wherein W represents an n-valent organic group having 2 to 50 carbon atoms; Y represents a terminal group structure represented by the following general formula (8) or general formula (9); proportions of structures represented by the formula (8) and (9) satisfy relationships of a + b = 1.0, 0.70 ≤ a ≤ 0.99, and 0.01 ≤ b ≤ 0.30, where "a" represents a proportion of the structure represented by the formula (8) and "b" represents a proportion of the structure represented by the formula (9); and "n" represents an integer of 1 to 10, 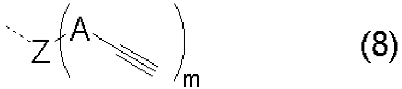
wherein a broken line represents a bond; Z represents an (m + 1)-valent aromatic group having 6 to 20 carbon atoms; A represents a single bond or -O-(CH₂)ₚ-; "m" represents an integer of 1 to 5; and "p" represents an integer of 1 to 10, 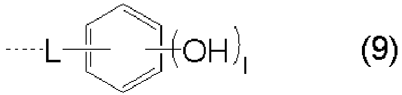
wherein a broken line represents a bond; L represents a single bond or -(CH₂)ᵣ-; "l" represents 2 or 3; and "r" represents an integer of 1 to 5.

In the general formula (8), a broken line represents a bond. Z represents an (m + 1)-valent aromatic group having 6 to 20 carbon atoms. Z represents an (m + 1)-valent group having a structure in which (m + 1) hydrogen atoms are removed from an aromatic compound having 6 to 20 carbon atoms. In this case, examples of the aromatic compound having 6 to 20 carbon atoms include benzene, naphthalene, phenanthrene, anthracene, pyrene, biphenyl, toluene, xylene, methylnaphthalene, and fluorene. From the viewpoint of imparting the thermal flowability and easily availability of the raw material, benzene and naphthalene are preferable. "m" represents an integer of 1 to 5, and "m" is preferably 1 to 3 to yield good planarization. A represents a single bond or -O-(CH2)ₚ-, and "p" represents an integer of 1 to 10. To yield good planarization, A preferably represents -O-CH₂- with p = 1.

Examples of preferable structures of the general formula (8) include the following structures.

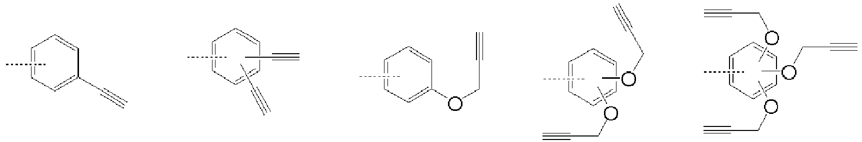

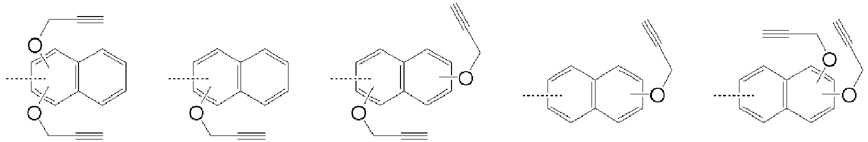

Examples of particularly preferable structures of the general formula (8) include the following formulae (10) to (12).

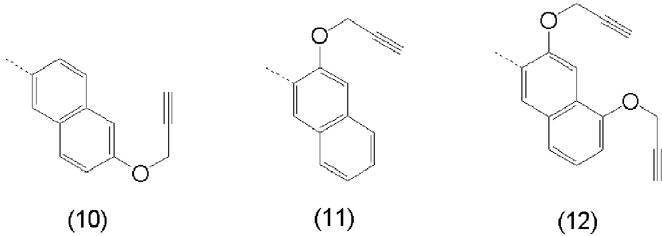

In the inventive resist underlayer film material, the terminal group structure of the general formula (8) functions as a thermally curing group. When the substituent A satisfies p = 1 and is present at a beta position of the naphthalene, as the formulae (10) to (12) exemplified as the particularly preferable structures, presumed mechanism is thermal curing via a cyclic structure represented by the following reaction formula. In this case, the terminal group structure before the curing contributes as a substituent imparting the thermal flowability, and proceeds the curing reaction via the rigid cyclic structure during the curing. Thus, contrary characteristics of the thermal flowability and heat resistance can be achieved. Since the curing reaction proceeds without an acid generator, the effect of the base generator can be maximized.

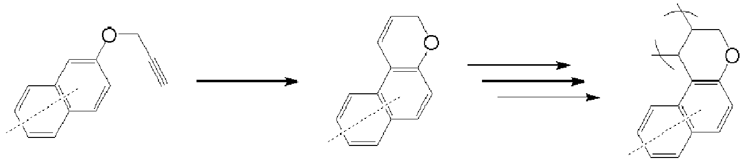

In the general formula (9), a broken line represents a bond. L represents a single bond or - (CH₂)ᵣ-, and preferably, L represents a single bond or r = 1. "l" represents 2 or 3, and "l" preferably represents 2 from the viewpoint of achievement of imparting both of the planarizing ability and the adhesiveness.

Examples of preferable structures of the general formula (9) include the following structures.

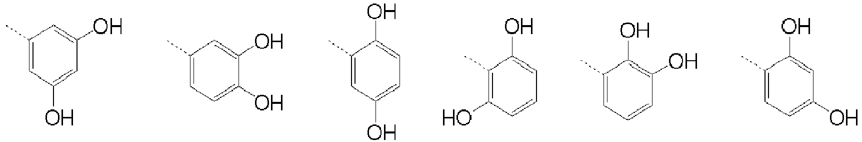

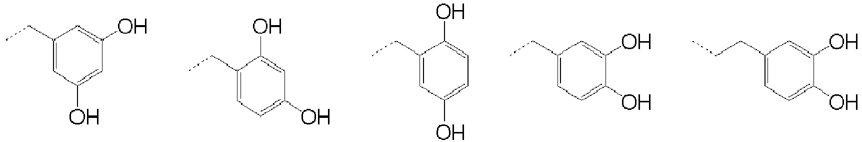

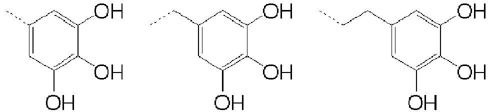

Examples of particularly preferable structures of the general formula (9) include the following formulae (13) and (14).

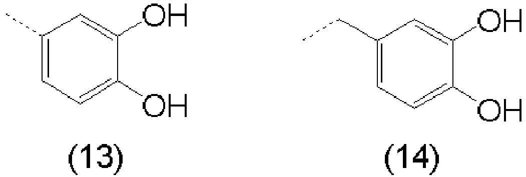

In the inventive resist underlayer film material, the terminal group structure of the general formula (9) functions as an adhesive group and a film-formability auxiliary group. When the component (A) has the catechol-type terminal group structure of the formula (13) or (14), exemplified as the particularly preferable structure, the affinity with the substrate increases to exhibit good planarization, and increase in adhesiveness to the substrate can prevent generation of a pinhole, removal of the film from the substrate, and deterioration (shrinkage) of a film edge that occur during the film formation.

In addition, "a" represents a proportion of the structure (terminal group proportion) represented by the following formula (8) and "b" represents a proportion of the structure (terminal group proportion) represented by the following formula (9), these structures constituting the Y, "a" and "b" need to satisfy relationships of a + b = 1.0, 0.70 ≤ a ≤ 0.99, and 0.01 ≤ b ≤ 0.30 (when a + b = 100, 70 ≤ a ≤ 99 and 1 ≤ b ≤ 30). It is more preferable that 0.75 ≤ a ≤ 0.97 and 0.03 ≤ b ≤ 0.25, and it is further preferable that 0.80 ≤ a ≤ 0.95 and 0.05 ≤ b ≤ 0.20. Regulating the terminal group proportions within the above ranges can achieve both of the planarization and the film formability with maintaining the thermal curability. The terminal group proportion can be calculated with ¹H-NMR as a ratio of "a triple-bond-containing terminal group / a phenolic-hydroxy-group-containing terminal group".

In the general formula (7), W represents an n-valent organic group having 2 to 50 carbon atoms. Since "n" represents an integer of 1 to 10, W represents a monovalent to decavalent organic group in which 1 to 10 hydrogen atoms are removed from an organic compound having 2 to 50 carbon atoms. The compound having a structure in which 1 to 10 hydrogen atoms are added into W and having the organic group W having 2 to 50 carbon atoms has at least each of one or more of the terminal groups represented by the general formulae (8) and (9). The organic group represented by W optionally has a linear, branched, or cyclic saturated or unsaturated hydrocarbon group, an aromatic group, a heteroaromatic group, an ether group, a hydroxy group, an ester group, a keto group, an amino group, a halogen group, a sulfide group, a carboxyl group, a sulfo group, an imide group, a cyano group, an aldehyde group, an imino group, a urea group, a carbamate group, a carbonate group, a nitro group, a sulfone group, etc. In terms of achievement of both of good planarization and the sufficient thermal curability, "n" more preferably represents 2 to 4.

Appropriately selecting W, Y, and "n" in the compound of the general formula (7) according to the usage can regulate characteristics of the resist underlayer film material, such as etching resistance, heat resistance, optical characteristic, polarity, and flexibility. On the optical characteristic among these characteristics, when the resist underlayer film material has an appropriate optical characteristic at a wavelength of 193 nm, reflective light during exposure in a multilayer ArF lithography can be inhibited to yield excellent resolution. Preferable optical constants of the resist underlayer film material to inhibit the reflective light are a refractive index "n" of within a range of approximately 1.4 to 1.9 and an extinction coefficient "k" of within a range of approximately 0.1 to 0.5.

W in the general formula (7) is preferably an organic group represented by the following general formula (15), 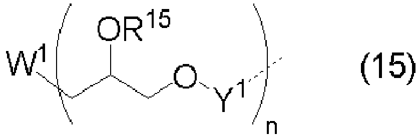 wherein a broken line represents a bond; R¹⁵ represents a hydrogen atom, or one hydrocarbon group of an alkyl group or acyl group, the group having 1 to 20 carbon atoms and optionally having an oxygen atom or a nitrogen atom; W¹ represents an n-valent organic group having 1 to 47 carbon atoms; Y¹ represents a single bond or a carbonyl group; and "n" represents an integer of 1 to 10.

When W in the general formula (7) has the partial structure represented by the general formula (15), the thermal flowability is imparted to the inventive resist underlayer film material. Thus, good planarization can be imparted.

In the general formula (15), examples of R¹⁵ include a hydrogen atom, a methyl group, a methoxymethyl group, a 1-ethoxyethyl group, a 1-(2-ethylhexyloxy)ethyl group, a 2-tetrahydropyranyl group, an allyl group, a benzyl group, a propargyl group, a formyl group, an acetyl group, a propionyl group, a butyryl group, a hexanoyl group, an icosanoyl group, an acryloyl group, a methacryloyl group, a propioloyl group, a methoxyacetyl group, a benzoyl group, a 4-acetoamidobenzoyl group, a carbamoyl group, an N-methylcarbamoyl group, and an N,N-dimethylcarbamoyl group. Among these, a hydrogen atom, an acetyl group, and an acryloyl group are preferable, and a hydrogen atom is particularly preferable.

In the general formula (15), Y¹ represents a single bond or a carbonyl group, and Y¹ more preferably represents a carbonyl group.

In the general formula (15), W¹ represents an n-valent organic group having 1 to 47 carbon atoms. The organic group represented by W¹ and having 1 to 47 carbon atoms optionally has a linear, branched, or cyclic saturated or unsaturated hydrocarbon group, an aromatic group, a heteroaromatic group, an ether group, a hydroxy group, an ester group, a keto group, an amino group, a halogen group, a sulfide group, a carboxyl group, a sulfo group, an imide group, a cyano group, an aldehyde group, an imino group, a urea group, a carbamate group, a carbonate group, a nitro group, and a sulfone group. "n" represents an integer of 1 to 10, and "n" more preferably represents 2 to 4 in terms of achievement of both of good planarization and sufficient thermal curability.

In the general formula (15), examples of preferable W¹ include the following formulae.

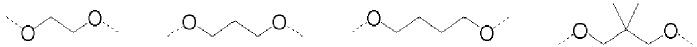

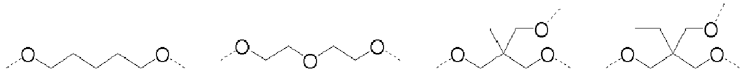

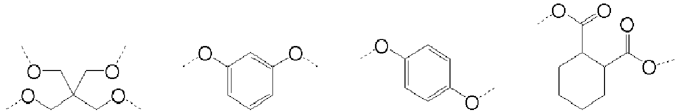

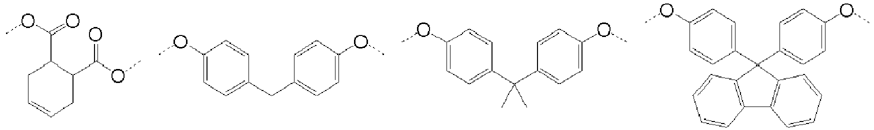

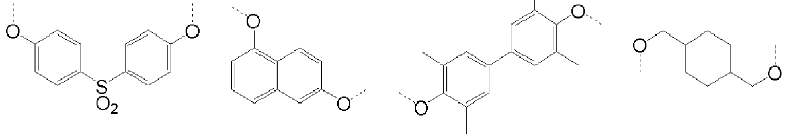

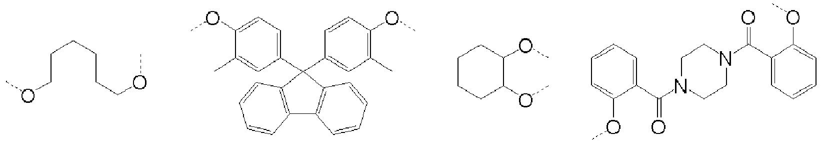

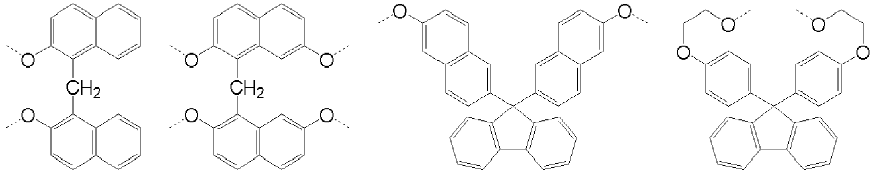

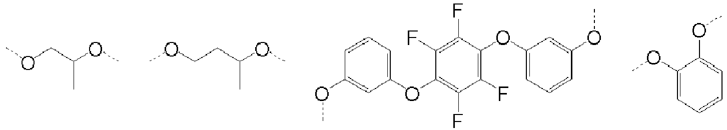

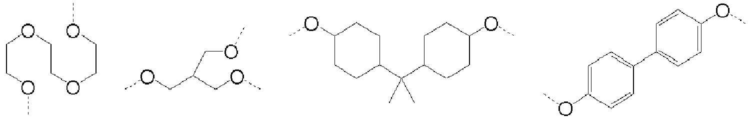

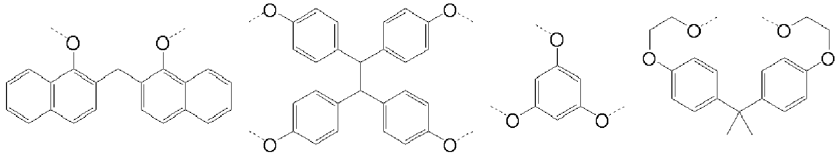

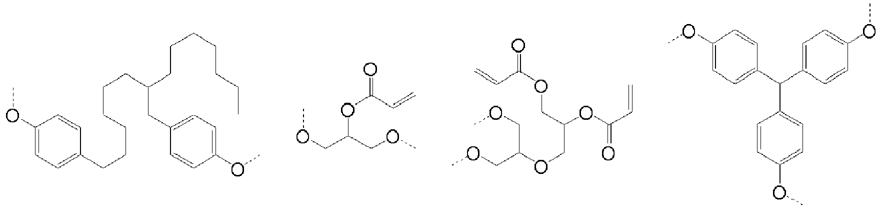

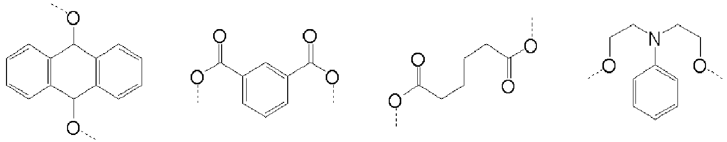

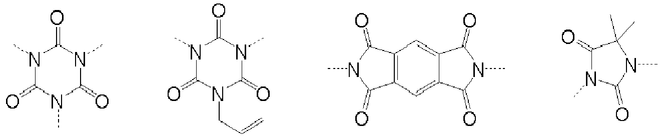

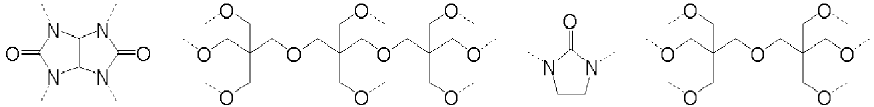

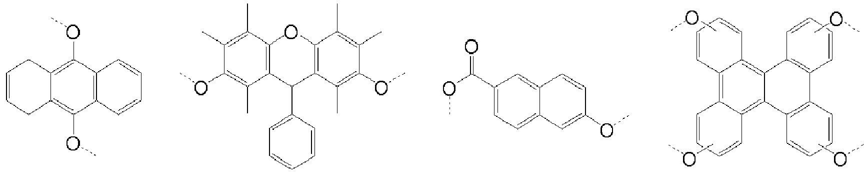

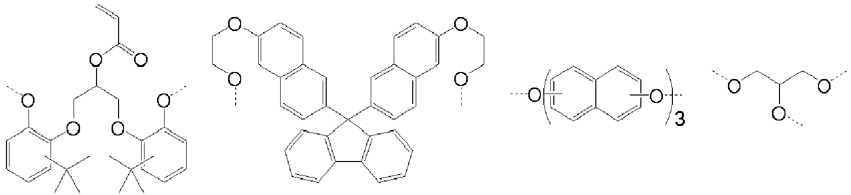

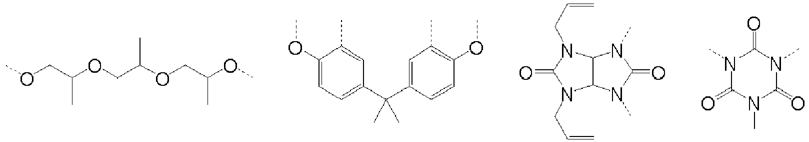

In the formulae, a broken line represents a bond.

Appropriately selecting R¹⁵, W¹, Y¹, and "n" according to the required performance and usage of the present invention can regulate characteristics, such as etching resistance, heat resistance, optical characteristic, polarity, flexibility, and curability.

In the present invention, the compound of the general formula (7) may be used singly, or two or more kinds thereof may be mixed to use. The compound represented by the general formula (7) may also be used as a mixture containing the compound. When the compound is used as the mixture, a proportion of the compound represented by the general formula (7) in all the solid contents of the resist underlayer film material excluding a solvent is preferably 10 mass% or more, and more preferably 20 mass% or more. When the proportion is 10 mass% or more, sufficient blending effect can be obtained.

Since such a resist underlayer film material can sufficiently yield the effect of combination with the base generator, a resist underlayer film having excellent planarizing ability and film formability can be formed, and can be particularly easily manufactured.

With the inventive resist underlayer film material, another substance can be blended in addition to the compound represented by the general formula (7). The substance for blending have a role for improving the film formability with spin-coating or the filling ability of a substrate having a step by blending with the compound represented by the general formula (7). The substance that can be mixed in this case is not particularly limited, and known substances can be used. Specifically, preferable are an acrylic resin, a styrene resin, a phenol resin, a polyether resin, an epoxy resin, and a compound having a phenolic hydroxy group. A blending amount of the substance for blending is preferably 1 to 100 parts by mass, and more preferably 2 to 50 parts by mass with respect to 100 parts by mass of the compound represented by the general formula (7).

Note that, in the inventive resist underlayer film material, a blending amount of the component (A) can be 3 to 15 mass%.

### (B) Base Generator

The inventive resist underlayer film material contains the base generator to enable to form a resist underlayer film having excellent film formability even on an HMDS-treated hydrophobic substance, for example. To maximize the effect of the base generator, an acid generator is preferably not used.

In the present invention, the base generator is referred to a compound that changes in its chemical structure by external stimulation such as light and heat to generate a base, and also referred to "latent base", "base precursor", etc. The base to be generated may be not only a general base such as ammonia and amines but also a chemical species having a function to increase ionicity of the phenolic hydroxy group in the component (A), which is a polarizer.

The base generator of the component (B) is not particularly limited, and known base generators can be used as necessary. Since the inventive resist underlayer film material is heated during the film formation and the phenolic hydroxy group in the component (A) has ionicity during the heating and increases the interaction with the substrate. This presumably improves the film formability, so that the base generator (B) is preferably a compound to exhibit basicity with pyrolysis. This is because the resist underlayer film material containing such a component (B) can achieve both the thermal flowability of the film and the interaction with the substrate by regulating the addition amount of the component (B).

When such a base generator to exhibit basicity with pyrolysis (also referred to as a thermal base generator) is used as the component (B), the base to be generated is an excess cation in the system with evaporation or decomposition of an anion. Specific examples thereof include a triphenylsulfonium cation and a tetrabutylammonium cation. These cations increase ionicity (polarity) of the phenolic hydroxy group in the component (A), which act as ionicity (polarity) improver, and even on a hydrophobically treated substrate, such as an HMDS-treated substrate, the phenolic hydroxy group interacts with a polar group present on the surface, such as a silanol group, to improve wetting ability of the resist underlayer film material on the substrate, and to inhibit deterioration (shrinkage) of the film edge, etc. Meanwhile, the above action does not occur before the heating, that is before the base generation, and thereby the resist underlayer film material maintains its original flowability. Accordingly, a resist underlayer film having excellent film formability can be formed.

The base generator (B) is preferably any one represented by the following general formulae (1), (2), and (3),

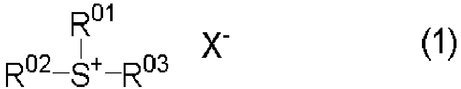

R⁰⁴-I⁺-R⁰⁵ X⁻ (2)

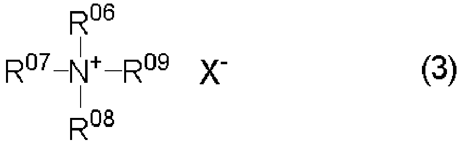

wherein R⁰¹ to R⁰³ each independently represent a linear, branched, or cyclic alkyl group or alkenyl group having 1 to 10 carbon atoms, optionally substituted with a heteroatom or optionally having an interposed heteroatom, or represent an aryl group or aralkyl group having 6 to 18 carbon atoms, optionally substituted with a heteroatom or optionally having an interposed heteroatom; any two of R⁰¹, R⁰², and R⁰³ are optionally bonded to each other to form a ring together with the sulfur atom in the formula; X⁻ represents an organic or inorganic anion to be a counterion, X⁻ excluding OH⁻; R⁰⁴ and R⁰⁵ each independently represent an aryl group having 6 to 20 carbon atoms, and a part or all of hydrogen atoms thereof are optionally substituted with a linear, branched, or cyclic alkyl group or alkoxy group having 1 to 10 carbon atoms; R⁰⁴ and R⁰⁵ are optionally bonded to each other to form a ring together with the iodine atom in the formula; R⁰⁶, R⁰⁷, R⁰⁸, and R⁰⁹ each independently represent a hydrogen atom, or a linear, branched, or cyclic alkyl group or alkenyl group having 1 to 20 carbon atoms, optionally substituted with a heteroatom or optionally having an interposed heteroatom, or represent an aryl group or aralkyl group having 6 to 18 carbon atoms, optionally substituted with a heteroatom or optionally having an interposed a heteroatom; and any two or more of R⁰⁶, R⁰⁷, R⁰⁸, and R⁰⁹ are optionally bonded to each other to form a ring together with the nitrogen atom in the formula.

Specific examples of R⁰¹, R⁰², and R⁰³ in the general formula (1) include: alkyl groups, such as a methyl group, an ethyl group, an n-propyl group, an isopropyl group, an n-butyl group, a tert-butyl group, a cyclopropyl group, a cyclopentyl group, a cyclohexyl group, a cyclopropylmethyl group, a 4-methylcyclohexyl group, a cyclohexylmethyl group, a norbornyl group, and an adamantyl group; alkenyl groups, such as a vinyl group, an allyl group, a propenyl group, a butenyl group, a hexenyl group, and a cyclohexenyl group; aryl groups, such as a phenyl group, a naphthyl group, and a thienyl group; and aralkyl groups, such as a benzyl group, a 1-phenylethyl group, and a 2-phenylethyl group. Aryl groups are preferable. A part of hydrogen atoms in these groups is optionally substituted with a heteroatom, such as an oxygen atom, a sulfur atom, a nitrogen atom, and a halogen atom. A heteroatom such as an oxygen atom, a sulfur atom, and a nitrogen atom is optionally interposed. As a result, optionally formed or interposed are a hydroxy group, a cyano group, a carbonyl group, an ether bond, an ester bond, a sulfonate ester bond, a carbonate bond, a lactone ring, a sultone ring, a carboxylic anhydride, a haloalkyl group, etc.

When any two of R⁰¹, R⁰², and R⁰³ are bonded to each other directly, or via an oxygen atom, a methylene group, a sulfone group, or a carbonyl group, examples of the partial structure include a dibenzothiophene skeleton, a phenoxathiin skeleton, and partial structures represented as below, but the partial structure is not limited thereto. In the following formulae, the aromatic ring optionally has a substituent at any position.

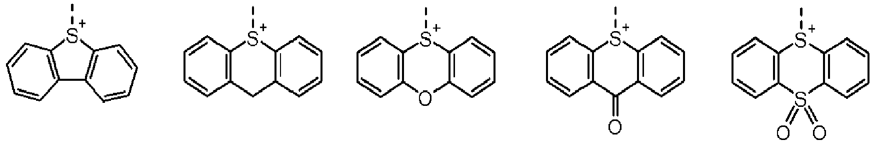

More specifically, examples of the sulfonium cations include triphenylsulfonium, 4-hydroxyphenyldiphenylsulfonium, bis(4-hydroxyphenyl)phenylsulfonium, tris(4-hydroxyphenyl)sulfonium 4-tert-butoxyphenyldiphenylsulfonium, bis(4-tert-butoxyphenyl)phenylsulfonium, tris(4-tert-butoxyphenyl)sulfonium, 3-tert-butoxyphenyldiphenylsulfonium, bis(3-tert-butoxyphenyl)phenylsulfonium, tris(3-tert-butoxyphenyl)sulfonium, 4-tert-butylphenyldiphenylsulfonium, tris(4-tert-butylphenyl)sulfonium, 3,4-di-tert-butoxyphenyldiphenylsulfonium, bis(3,4-di-tert-butoxyphenyl)phenylsulfonium, tris(3,4-di-tert-butoxyphenyl)sulfonium, diphenyl(4-thiophenoxyphenyl)sulfonium, 10-phenylphenoxathiinium, S-phenyldibenzothiophenium, 4-tert-butoxycarbonylmethyloxyphenyldiphenylsulfonium, tris(4-tert-butoxycarbonylmethyloxyphenyl)sulfonium, (4-tert-butoxyphenyl)bis(4-dimethylaminophenyl) sulfonium, tris(4-dimethylaminophenyl)sulfonium, 2-naphthyldiphenylsulfonium, (4-hydroxy-3,5-dimethylphenyl)diphenylsulfonium, and (4-n-hexyloxy-3,5-dimethylphenyl)diphenylsulfonium. Examples thereof further include 4-methacryloyloxyphenyldiphenylsulfonium, 4-acryloyloxyphenyldiphenylsulfonium, 4-methacryloyloxyphenyldimethylsulfonium, 4-acryloyloxyphenyldimethylsulfonium, (4-methacryloyloxy-3,5-dimethylphenyl)diphenylsulfonium, and (4-acryloyloxy-3,5-dimethylphenyl)diphenylsulfonium. More preferable examples thereof include triphenylsulfonium, 4-tert-butylphenyldiphenylsulfonium, 4-tert-butoxyphenyldiphenylsulfonium, 10-phenylphenoxathiinium, and S-phenyldibenzothiophenium. Among these, more preferable are triphenylsulfonium, 4-tert-butylphenyldiphenylsulfonium, and 4-tert-butoxyphenyldiphenylsulfonium.

Specific examples of R⁰⁴ and R⁰⁵ in the general formula (2) include a phenyl group, a naphthyl group, a tolyl group, a xylyl group, a trimethylphenyl group, an ethylphenyl group, an isopropylphenyl group, a tert-butylphenyl group, a 1-adamantylphenyl group, a triisopropylphenyl group, a tricyclohexylphenyl group, a methoxyphenyl group, an ethoxyphenyl group, a butoxyphenyl group, a hydroxyphenyl group, a dihydroxyphenyl group, a trimethoxyphenyl group, a methylthiophenyl group, a biphenyl group, a fluorophenyl group, a difluorophenyl group, a bromophenyl group, an iodophenyl group, an N,N-diphenylaminophenyl group, an acetoxyphenyl group, an acetylaminophenyl group, a 2,2,2-trifluoroethoxyphenyl group, a (2-methoxyethoxy)phenyl group, a hydroxynaphthyl group, a dihydroxynaphthyl group, a 2,2,2-trifluoroethoxynaphthyl group, and (2-methoxyethoxy)naphthyl group, and these groups optionally have a substituent at any position. The R⁰⁴ and R⁰⁵ are not limited thereto.

Preferable R⁰⁴ and R⁰⁵ are an unsubstituted phenyl group or a phenyl group having a substituent at a para position of an iodine atom, the substituent being selected from a halogen atom, an alkyl group, and an alkoxy group. In particular, a phenyl group, a 4-tert-butylphenyl group, and a 4-fluorophenyl group are preferable.

When R⁰⁴ and R⁰⁵ are bonded to each other directly, or via an oxygen atom, a methylene group, a sulfone group, or a carbonyl group, examples of the partial structure include the following partial structures, but the partial structure is not limited thereto. In the following formulae, the aromatic ring optionally has a substituent at any position.

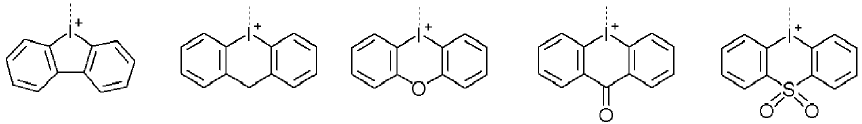

More specifically, examples of the iodonium cation include the following cations, but the iodonium cation is not limited thereto. In the formulae, tBu represents a tert-butyl group, and Ph represents a phenyl group.

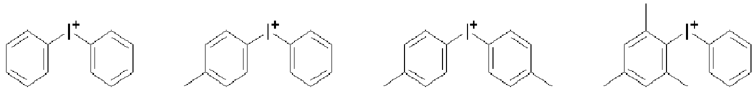

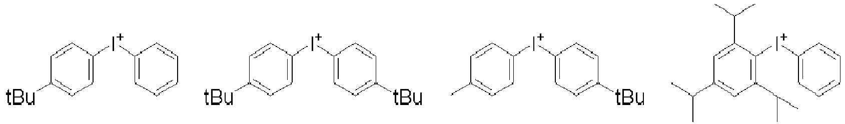

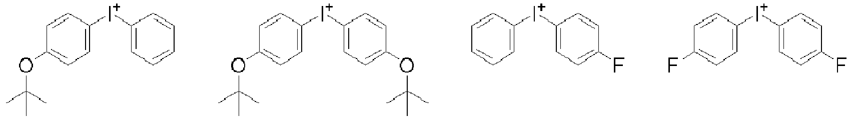

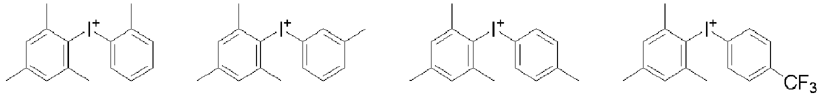

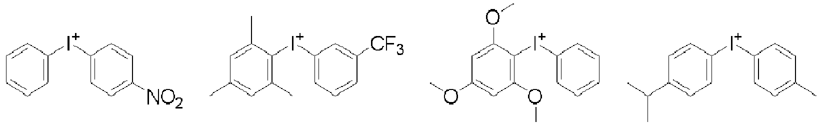

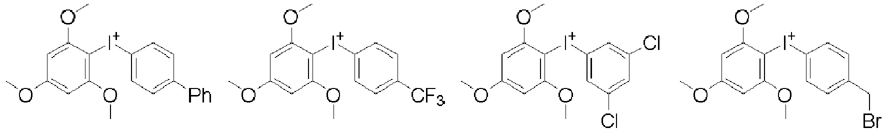

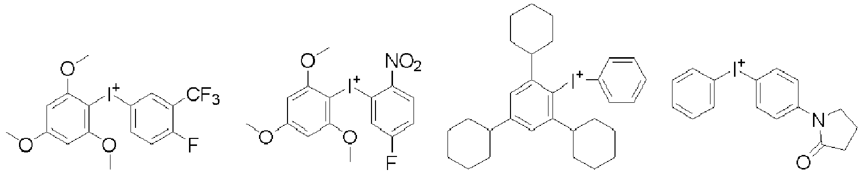

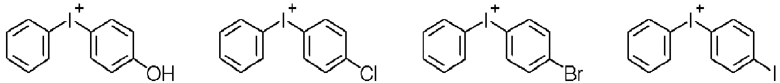

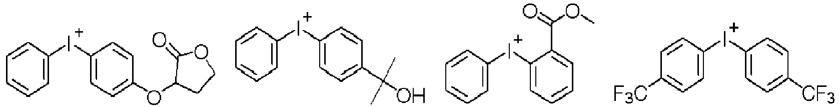

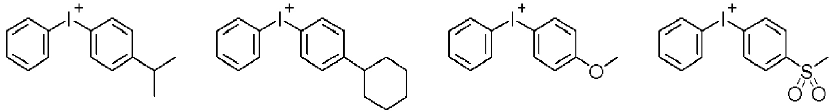

Examples of the ammonium cation represented by the general formula (3) include: ammonium cations having a protonated nitrogen atom of ammonia, primary, secondary, or tertiary aliphatic amines, mixed amines, aromatic amines, heterocyclic amines, nitrogen-containing compounds having a carboxy group, nitrogen-containing compounds having a sulfonyl group, nitrogen-containing compounds having a hydroxy group, nitrogen-containing compounds having a hydroxyphenyl group, alcoholic nitrogen-containing compounds, etc.; and quaternary ammonium cations.

Specifically, examples of the primary aliphatic ammoniums include methylammonium, ethylammonium, n-propylammonium, isopropylammonium, n-butylammonium, isobutylammonium, sec-butylammonium, tert-butylammonium, pentylammonium, tert-amylammonium, cyclopentylammonium, hexylammonium, cyclohexylammonium, heptylammonium, octylammonium, nonylammonium, decylammonium, dodecylammonium, cetylammonium, aminomethylammonium, and 2-aminoethylammonium. Examples of the secondary aliphatic ammoniums include dimethylammonium, diethylammonium, di-n-propylammonium, diisopropylammonium, di-n-butylammonium, diisobutylammonium, di-sec-butylammonium, dipentylammonium, dicyclopentylammonium, dihexylammonium, dicyclohexylammonium, diheptylammonium, dioctylammonium, dinonylammonium, didecylammonium, didodecylammonium, dicetylammonium, methyl(methylamino)methylammonium, and methyl-2-(methylamino)ethylammonium. Examples of the tertiary aliphatic ammoniums include trimethylammonium, triethylammonium, tri-n-propylammonium, triisopropylammonium, tri-n-butylammonium, triisobutylammonium, tri-sec-butylammonium, tripentylammonium, tricyclopentylammonium, trihexylammonium, tricyclohexylammonium, triheptylammonium, trioctylammonium, trinonylammonium, tridecylammonium, tridodecylammonium, tricetylammonium, dimethyl(dimethylamino)methylammonium, and dimethyl(2-dimethylaminoethyl) ammonium.

Examples of the mixed ammoniums include dimethylethylammonium, methylpropylammonium, benzylammonium, phenethylammonium, and benzyldimethylammonium. Specific examples of the aromatic ammoniums and the heterocyclic ammoniums include anilinium derivatives (for example, anilinium, N-methylanilinium, N-ethylanilinium, N-propylanilinium, N,N-dimethylanilinium, 2-methylanilinium, 3-methylanilinium, 4-methylanilinium, an ethylanilinium with any substitution position, a propylanilinium with any substitution position, a trimethylanilinium with any substitution position, 2-nitroanilinium, 3-nitroanilinium, 4-nitroanilinium, 2,4-dinitroanilinium, 2,6-dinitroanilinium, 3,5-dinitroanilinium, and an N,N-dimethyltoluidinium with any substitution position), diphenyl(p-tolyl)ammonium, methyldiphenylammonium, triphenylammonium, an aminophenylammonium with any substitution position, naphthylammonium, an aminonaphthylammonium with any substitution position, pyrrolinium derivatives (for example, pyrrolinium, 2H-pyrrolinium, 1-methylpyrrolinium, 2,4-dimethylpyrrolinium, 2,5-dimethylpyrrolinium, and N-methylpyrrolinium), oxazolium derivatives (for example, oxazolium and isoxazolium), thiazolium derivatives (for example, thiazolium and isothiazolium), imidazolium derivatives (for example, imidazolium, 4-methylimidazolium, and 4-methyl-2-phenylimidazolium), pyrazolium derivatives, furazanium derivatives, pyrrolinium derivatives (for example, pyrrolinium and 2-methyl-1-pyrrolinium), pyrrolidinium derivatives (for example, pyrrolidinium, N-methylpyrrolidinium, pyrrolidinonium, and N-methylpyrrolidonium), imidazolinium derivatives, imidzolidinium derivatives, pyridinium derivatives (for example, pyridinium, methylpyridinium, ethylpyridinium, propylpyridinium, butylpyridinium, 4-(1-butylpentyl)pyridinium, dimethylpyridinium, trimethylpyridinium, triethylpyridinium, phenylpyridinium, 3-methyl-2-phenylpyridinium, 4-tert-butylpyridinium, diphenylpyridinium, benzylpyridinium, methoxypyridinium, butoxypyridinium, dimethoxypyridinium, 4-pyrrolidinopyridinium, 2-(1-ethylpropyl)pyridinium, aminopyridinium, and dimethylaminopyridinium), pyridazinium derivatives, pyrimidinium derivatives, pyrazinium derivatives, pyrazolinium derivatives, pyrazolidinium derivatives, piperidinium derivatives, piperazinium derivatives, morpholinium derivatives, indolinium derivatives, isoindolinium derivatives, 1H-indazolinium derivatives, quinolinium derivatives (for example, quinolinium), isoquinolinium derivatives, cinnolinium derivatives, quinazolinium derivatives, quinoxalinium derivatives, phthalazinium derivatives, purinium derivatives, pteridinium derivatives, carbazolium derivatives, phenanthrynium derivatives, acridinium derivatives, fenadinium derivatives, and 1,10-phenanthrolinium derivatives.

Examples of the nitrogen-containing compound having a carboxy group include carboxyphenylammonium, carboxyindolinium, and amino acid derivatives (for example, protonated products of nicotinic acid, alanine, arginine, aspartic acid, glutamic acid, glycine, histidine, isoleucine, glycylleucine, leucine, methionine, phenylalanine, threonine, lysine, 3-aminopyradine-2-carboxylic acid, and methoxyalanine). Examples of the nitrogen-containing compound having a sulfonyl group include 3-pyridiniumsulfonic acid. Examples of the nitrogen-containing compound having a hydroxy group, the nitrogen-containing compound having a hydroxyphenyl group, and the alcoholic nitrogen-containing compound include 2-hydroxypyridinium, a hydroxyanilinium with any substitution position, a hydroxy-methyl-anilinium with any substitution position, hydroxyquinolinium, dihydroxyquinolinium, 2-hydroxyethylammonium, bis(2-hydroxyethyl)ammonium, tris(2-hydroxyethyl)ammonium, ethylbis(2-hydroxyethyl)ammonium, diethyl(2-hydroxyethyl)ammonium, hydroxypropylammonium, bis(hydroxypropyl)ammonium, tris(hydroxypropyl)ammonium, 4-(2-hydroxyethyl)morpholinium, 2-(2-hydroxyethyl)pyridinium, 1-(2-hydroxyethyl)piperazinium, 1-[2-(2-hydroxyethoxy)ethyl]piperazinium, (2-hydroxyethyl)piperazinium, 1-(2-hydroxyethyl)pyrrolidinium, 1-(2-hydroxyethyl)-2-pyrrolidinonium, 2,3-dihydroxypropylpiperidinium, 2,3-dihydroxypropylpyrrolidinium, 8-hydroxyjulolidine, and 3-hydroxyquinuclidinium.

Specific examples of the quaternary ammonium salt include tetramethylammonium, triethylmethylammonium, tetraethylammonium, tetrabutylammonium, tetraoctylammonium, didecyldimetylammonium, tridecylmethylammonium, hexadecyltrimethylammonium, stearyltrimethylammonium, benzyltrimethylammonium, benzyltriethylammonium, benzyltributylammonium, and 2-hydroxyethyltrimethylammonium.

As the ammonium cation, a quaternary ammonium cation is preferable, and a tetramethylammonium cation, a tetraethylammonium cation, and a tetrabutylammonium cation are particularly preferable.

In this case, X⁻ in the general formulae (1), (2), and (3) more preferably represents an anion selected from the group consisting of a chloride ion, a bromide ion, an iodide ion, a fluoride ion, a cyanide ion, a nitride ion, a nitrite ion, and any anions represented by the following general formulae (4), (5), and (6),

R¹⁰-COO⁻ (4)

R¹¹-SO₃⁻ (5)

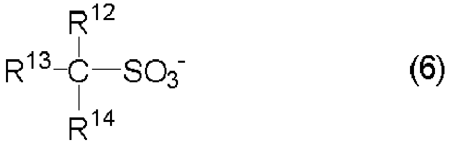

wherein R¹⁰ represents a linear, branched, or cyclic hydrocarbon group having 1 to 20 carbon atoms selected from an alkyl group, an alkenyl group, an aralkyl group, and an aryl group, the hydrocarbon group optionally having an ether group, an ester group, or a carbonyl group, and optionally substituted one or more of hydrogen atoms thereof with a halogen atom, a hydroxy group, a carboxyl group, an amino group, and a cyano group; R¹¹ represents an aryl group having 1 to 20 carbon atom, and optionally substituted one or more of hydrogen atoms thereof with a halogen atom, a hydroxy group, a carboxyl group, an amino group, and a cyano group; R¹², R¹³, and R¹⁴ each independently represent a hydrogen atom, a halogen atom other than a fluorine atom, or a linear, branched, or cyclic hydrocarbon group having 1 to 20 carbon atoms selected from an alkyl group, an alkenyl group, an aralkyl group, and an aryl group, the hydrocarbon group optionally having an ether group, an ester group, or a carbonyl group, and optionally substituted one or more of hydrogen atoms thereof with a halogen atom, a hydroxy group, a carboxyl group, an amino group, and a cyano group; and two or more of R¹², R¹³, and R¹⁴ are optionally bonded to each other to form a ring.

Specific examples of the carboxylate anion represented by the general formula (4) include a formate anion, an acetate anion, a propionate anion, a butyrate anion, an isobutyrate anion, a valerate anion, an isovalerate anion, a pivalate anion, a hexanoate anion, an octanoate anion, a cyclohexanecarboxylate anion, a cyclohexylacetate anion, a laurate anion, a myristate anion, a palmitate anion, a stearate anion, a phenylacetate anion, a diphenylacetate anion, a phenoxyacetate anion, a mandelate anion, a benzoylformate anion, a cinnamate anion, a dihydroxycinnamate anion, a benzoate anion, a methylbenzoate anion, a salicylate anion, a naphthalenecarboxylate anion, an anthracenecarboxylate anion, an anthraquinonecarboxylate anion, a hydroxyacetate anion, a pivalate anion, a lactate anion, a methoxyacetate anion, a 2-(2-methoxyethoxy)acetate anion, a 2-(2-(2-methoxyethoxy)ethoxy)acetate anion, a diphenolate anion, a monochloroacetate anion, a dichloroacetate anion, a trichloroacetate anion, a trifluoroacetate anion, a pentafluoropropionate anion, a heptafluorobutyrate anion, and a 2-hydroxy-2,2-bis(trifluoromethyl)acetate anion. Examples thereof also include monoanions of dicarboxylic acids, such as succinic acid, tartaric acid, glutaric acid, pimelic acid, sebacic acid, phthalic acid, isophthalic acid, terephthalic acid, naphthalenedicarboxylic acid, cyclohexanedicarboxylic acid, and cyclohexenedicarboxylic acid.

Specific examples of the arenesulfonate anion represented by the general formula (5) include benzenesulfonate, 4-toluenesulfonate, 2-toluenesulfonate, a xylenesulfonate with any substitution position, trimethylbenzenesulfonate, mesitylenesulfonate, 4-methoxybenzenesulfonate, 4-ethylbenzenesulfonate, 2,4,6-triisopropylbenzenesulfonate, 1-naphthalenesulfonate, 2-naphthalenesulfonate, anthraquinone-1-sulfonate, anthraquinone-2-sulfonate, 4-(4-methylbenzenesulfonyloxy)benzenesulfonate, 3,4-bis(4-methylbenzenesulfonyloxy)benzenesulfonate, 6-(4-methylbenzenesulfonyloxy)naphthalene-2-sulfonate, 4-phenyloxybenzenesulfonate, 4-diphenylmethylbenzenesulfonate, 2,4-dinitrobenzenesulfnate, and dodecylbenzenesulfonate.

Specific examples of the alkanesulfonate anion represented by the general formula (6) include methanesulfonate, ethanesulfonate, propanesulfonate, butanesulfonate, pentanesulfonate, hexanesulfonate, cyclohexanesulfonate, octanesulfonate, and 10-camphorsulfonate.

A conjugate acid of X⁻, X-H, in the general formulae (1), (2), and (3) more preferably has a boiling point of 200°C or lower.

X⁻ in the general formulae (1), (2), and (3) particularly preferably represents a trifluoroacetate anion, a pentafluoropropionate anion, a 2-hydroxy-2,2-bis(trifluoromethyl)acetate anion, a chloride ion, or a nitride ion.

Examples of the base generator (B) include any combination of the aforementioned specific examples of the cation and specific examples of the anion, but the base generator (B) is not limited thereto. Examples of the preferable structure include the following structures. In the following formulae, tBu represents a tert-butyl group.

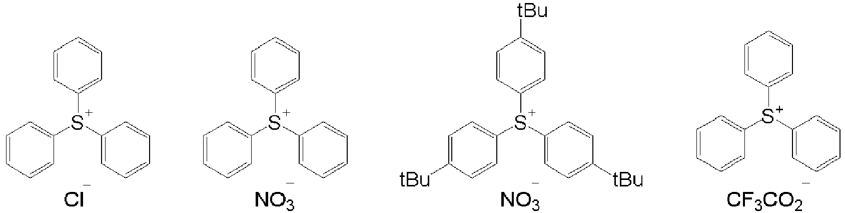

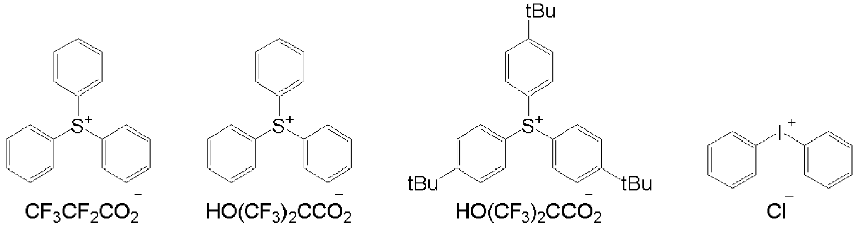

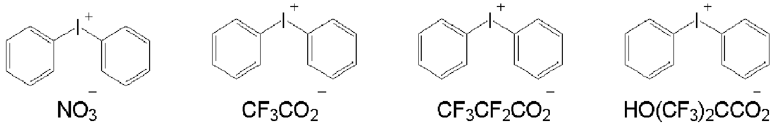

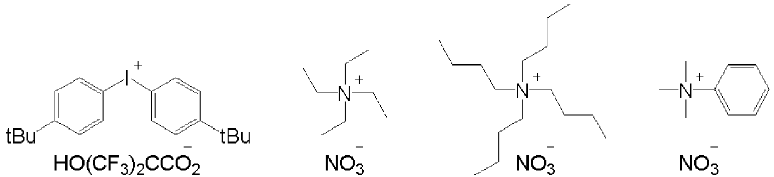

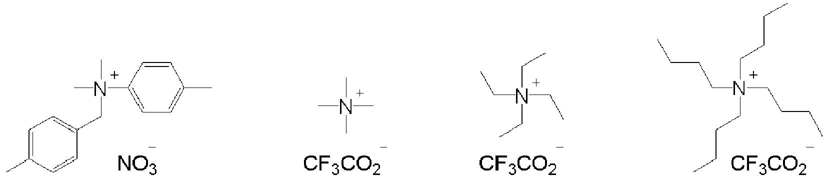

Using the base generator (B) singly or in combination of two or more kinds thereof can exhibit basicity according to the baking temperature of the resist underlayer film material, and can appropriately regulate the balance between the film formability for a hydrophobic substrate and planarizing ability. When the base generator is added, the addition amount is preferably 0.1 to 10 parts by mass, and more preferably 0.3 to 3 parts by mass, relative to 100 parts by mass of the compound or resin of the above (A) (component (A)). The addition amount of the base generator within the above range can yield a sufficient effect of improving the film formability, and there is no risk of deterioration in in-plane uniformity due to decomposition and sublimation and decrease in the curability of the compound or resin due to the basicity.

### (C) Organic Solvent

The organic solvent (C) usable for the inventive resist underlayer film material is not particularly limited as long as the organic solvent can dissolve one or more kinds of the compound or resin having a phenolic hydroxy group (A) and the base generator (B). The organic solvent can preferably dissolve a surfactant (D), a crosslinker (E), a plasticizer (F), and a colorant (G), described later.

Specifically, solvents described in paragraphs [0091] to [0092] of JP 2007-199653 A can be added. More specifically, preferably used are propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more kinds thereof.

A blending amount of the organic solvent, which is desirably regulated according to a target film thickness of the resist underlayer film, is typically within a range of 100 to 50,000 parts by mass relative to 100 parts by mass of (A) the compound or resin having a phenolic hydroxy group (component (A)).

In the inventive resist underlayer film material, the organic solvent (C) is preferably a mixture of one or more kinds of organic solvents having a boiling point of lower than 180°C and one or more kinds of organic solvents having a boiling point of 180°C or higher (hereinafter, also referred to as "high boiling-point solvent").

Specific examples of the organic solvent having a boiling point of lower than 180°C include propylene glycol monomethyl ether acetate, propylene glycol monomethyl ether, propylene glycol monoethyl ether, propylene glycol monopropyl ether, 2-heptanone, cyclopentanone, and cyclohexanone.

The organic solvent having a boiling point of 180°C or higher is not particularly limited to hydrocarbons, alcohols, ketones, esters, ethers, and chlorine-based solvents as long as the organic solvent can dissolve each component of the inventive resist underlayer film material. Specific examples thereof include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol monomethyl ether acetate, dipropylene glycol methyl n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, and dibutyl adipate. These solvents may be used singly, or may be mixed to use.

The organic solvent having a boiling point of 180°C or higher is appropriately selected from, for example, the above according to a temperature at which the inventive resist underlayer film material is heat-treated. The boiling point of the organic solvent having a boiling point of 180°C or higher is preferably 180°C to 300°C, and further preferably 200°C to 300°C. Such a boiling point has no risk of exceedingly fast evaporation during baking (heat treatment) due to an exceedingly low boiling point, and yields the sufficient thermal flowability during the film formation. Thus, it is considered that a resist underlayer film having excellent filling/planarizing ability can be formed. In addition, such a boiling point eliminates failure to remain the nonvolatile solvent in the film even after the baking due to an exceedingly high boiling point, and thereby has no risk of an adverse effect on the film properties such as etching resistance.

When the organic solvent having a boiling point of 180°C or higher is used, a blending amount thereof is preferably 1 to 30 parts by mass relative to 100 parts by mass of the solvent having a boiling point of lower than 180°C. Such a blending amount is preferable because of no risk of: failure to impart the sufficient thermal flowability during the baking due to an exceedingly small blending amount; and remaining of the solvent in the film leading to deterioration in the film properties such as etching resistance due to an exceedingly large blending amount.

### (D) Surfactant

In the inventive resist underlayer film material, a surfactant (D) can be added to improve the coatability by spin-coating. For the surfactant, surfactants described in [0142] to [0147] of JP 2009-269953 A can be used, for example. When the surfactant is added, the addition amount is preferably 0.001 to 20 parts by mass, and more preferably 0.01 to 10 parts by mass, relative to 100 parts by mass of the component (A).

### (E) Crosslinker

In the inventive resist underlayer film material, a crosslinker (E) can be added to improve the curability and to further inhibit intermixing with the upper layer film. The crosslinker is not particularly limited, and known various types of crosslinkers can be widely used. An example of the crosslinker includes a melamine-based crosslinker, a glycoluril-based crosslinker, a benzoguanamine-based crosslinker, a urea-based crosslinker, a β-hydroxyalkylamide-based crosslinker, an isocyanurate-based crosslinker, an aziridine-based crosslinker, an oxazoline-based crosslinker, an epoxy-based crosslinker, or a phenol-based crosslinker (for example, a methylol-based or alkoxymethyl-based polynuclear phenol-based crosslinker). When the crosslinker is added, the amount thereof is preferably 1 to 60 parts by mass, and more preferably 10 to 50 parts by mass, relative to 100 parts by mass of the component (A) .

Specific examples of the melamine-based crosslinker include hexamethoxymethylmelamine, hexabutoxymethylmelamine, alkoxy- and/or hydroxy-substituted derivatives thereof, and partially self-condensed products thereof. Specific examples of the glycoluril-based crosslinker include tetramethoxymethylglycoluril, tetrabutoxymethylglycoluril, alkoxy- and/or hydroxy-substituted derivatives thereof, and partially self-condensed products thereof. Specific examples of the benzoguanamine-based crosslinker include tetramethoxymethylbenzoguanamine, tetrabutoxymethylbenzoguanamine, alkoxy- and/or hydroxy-substituted derivatives thereof, and partially self-condensed products thereof. Specific examples of the urea-based crosslinker include dimethoxymethyldimethoxyethylene urea, alkoxy- and/or hydroxy-substituted derivatives thereof, and partially self-condensed products thereof. Specific examples of the β-hydroxyalkylamide-based crosslinker include N,N,N',N'-tetra(2-hydroxyethyl)adipic amide. Specific examples of the isocyanurate-based crosslinker include triglycidylisocyanurate and triallylisocyanurate. Specific examples of the aziridine-based crosslinker include 4,4'-bis(ethyleneiminocarbonylamino)diphenylmethane and 2,2-bishydroxymethylbutanol-tris[3-(1-azirlidinyl)propionate]. Specific examples of the oxazoline-based crosslinker include 2,2'-isopropylidinebis(4-benzyl-2-oxazoline), 2,2'-isoprolylidenebis(4-phenyl-2-oxazoline), 2,2'-methylenebis-4,5-diphenyl-2-oxazoline, 2,2'-metylenebis-4-phenyl-2-oxazoline, 2,2'-methylenebis-4-tert-butyl-2-oxazoline, 2,2'-bis(2-oxazoline), 1,3-phenylenebis(2-oxazoline), 1,4-phenylenebis(2-oxazoline), and a 2-isopropenyloxazoline copolymer. Specific examples of the epoxy-based crosslinker include diglycidyl ether, ethylene glycol diglycidyl ether, 1,4-butanediol diglycidyl ether, 1,4-cyclohexanedimethanol diglycidyl ether, poly(glycidyl methacrylate), trimethylolethane triglycidyl ether, trimethylolpropane triglycidyl ether, and pentaerythritol tetraglycidyl ether.

To maximize the effect of the base generator, the polynuclear phenol-based crosslinker, which proceeds the crosslinking reaction without an acid generator, is more preferable. In addition, since the polynuclear phenol-based crosslinker itself has a phenolic hydroxy group, expected is a further higher effect of improving the film formability by an action of the base generator. Specific examples of the polynuclear phenol-based crosslinker include compounds represented by the following general formula (16), 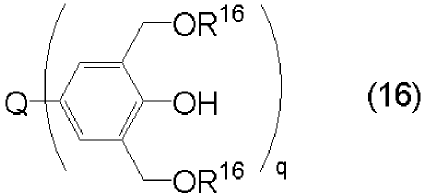 wherein Q represents a single bond or a q-valent hydrocarbon group having 1 to 20 carbon atoms; R¹⁶ represents a hydrogen atom or an alkyl group having 1 to 20 carbon atoms; and "q" represents an integer of 1 to 5.

Q represents a single bond or a q-valent hydrocarbon group having 1 to 20 carbon atoms. "q" represents an integer of 1 to 5, and more preferably 2 or 3. Specific examples of Q include groups obtained by removing "q" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, or icosane. R¹⁶ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an icosanyl group. R¹⁶ is preferably a hydrogen atom or a methyl group.

Specific examples of the compound represented by the general formula (16) include the following compounds. Among these, hexamethoxymethylated derivatives of triphenolmethane, triphenolethane, 1,1,1-tris(4-hydroxyphenyl)ethane, and tris(4-hydroxyphenyl)-1-ethyl-4-isopropylbenzene are preferable from the viewpoint of improvements of the curability of the resist underlayer film and the uniformity of the film thickness.

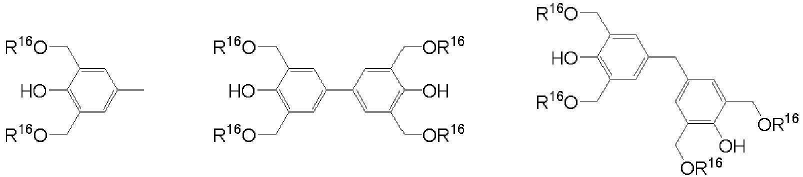

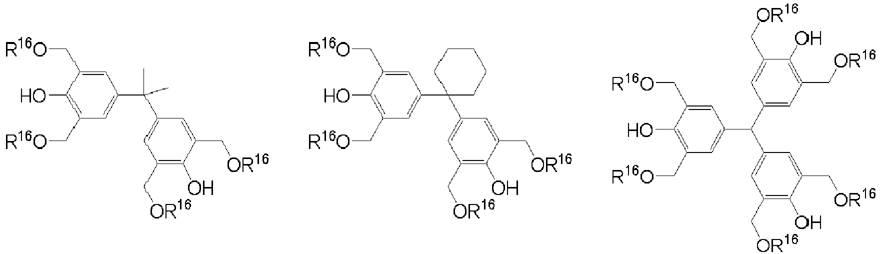

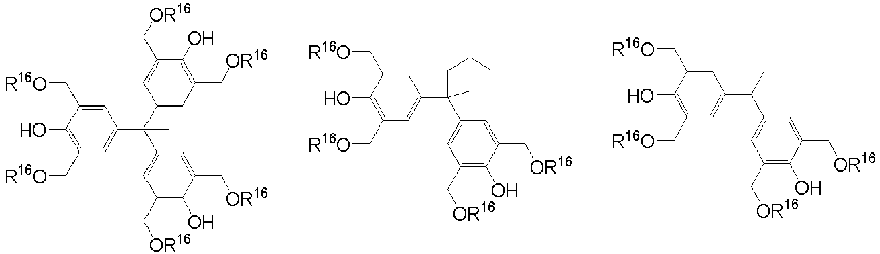

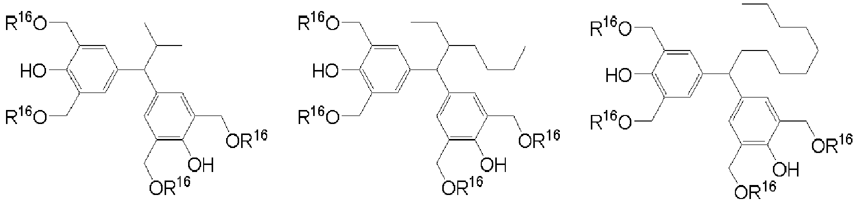

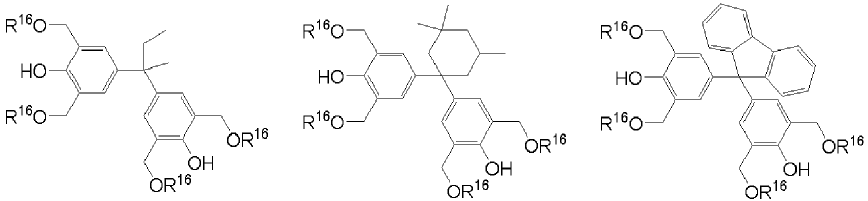

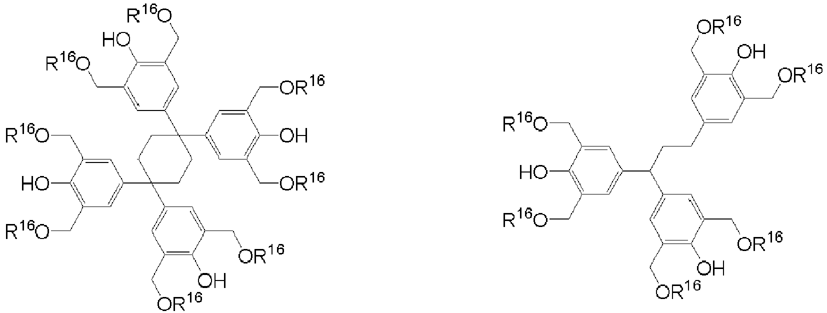

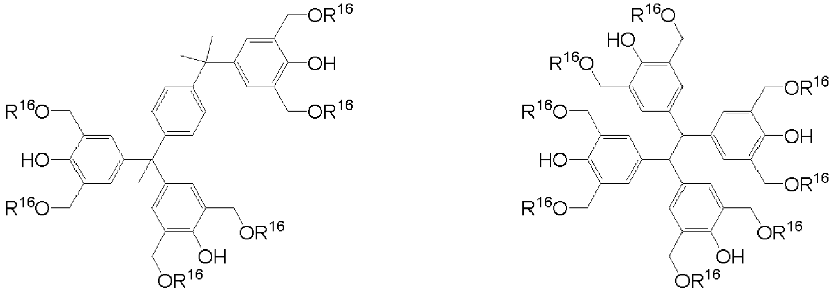

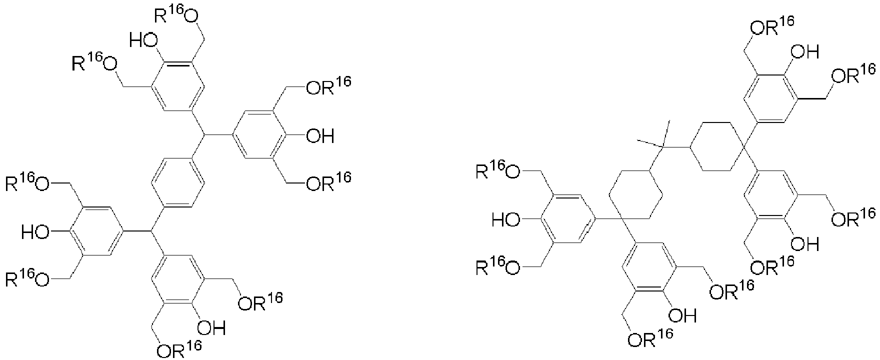

In the formulae, R¹⁶ represents the same as above.

### (F) Plasticizer

In the inventive resist underlayer film material, a plasticizer (F) can be added to further improve the planarizing/filling ability. The plasticizer is not particularly limited, and known various types of plasticizers can be widely used. An example of the plasticizer includes: low molecular-weight compounds such as phthalate esters, adipate esters, phosphate esters, trimellitate esters, and citrate esters; and polymers such as polyether polymers, polyester polymers, and polyacetal polymers described in JP 2013-253227 A. When the plasticizer is used, the addition amount is preferably 5 to 500 parts by mass, and more preferably 10 to 200 parts by mass, relative to 100 parts by mass of the component (A).

### (G) Colorant

In the inventive resist underlayer film material, a colorant (G) can be added to further improve the resolution with patterning of the multilayer lithography. The colorant is not particularly limited as long as the colorant is a compound having appropriate absorption at the exposure wavelength, and known various compounds can be widely used. An example thereof includes benzenes, naphthalenes, anthracenes, phenanthrenes, pyrenes, isocyanuric acids, and triazines. When the colorant is added, the addition amount is preferably 0.01 to 10 parts by mass, and more preferably 0.1 to 5 parts by mass, relative to 100 parts by mass of the component (A).

### <Patterning Process>

The present invention also provides a patterning process (two-layer resist process) for forming a pattern on a substrate to be processed, comprising steps of:
(I-1) applying the above resist underlayer film material on a substrate to be processed, and then heat-treating the material to form a resist underlayer film;
(I-2) forming a resist upper layer film on the resist underlayer film by using a photoresist material;
(I-3) pattern-exposing the resist upper layer film, and then developing the exposed resist upper layer film with a developer to form a pattern in the resist upper layer film;
(I-4) transferring the pattern to the resist underlayer film by dry etching while using the patterned resist upper layer film as a mask; and
(I-5) forming a pattern on the substrate to be processed by processing the substrate while using the patterned resist underlayer film as a mask.

The present invention also provides a patterning process (three-layer resist process) for forming a pattern on a substrate to be processed, comprising steps of:
(II-1) applying the above resist underlayer film material on a substrate to be processed, and then heat-treating the material to form a resist underlayer film;
(II-2) forming a resist intermediate film on the resist underlayer film;
(II-3) forming a resist upper layer film on the resist intermediate film by using a photoresist material;
(II-4) pattern-exposing the resist upper layer film, and then developing the exposed resist upper layer film with a developer to form a pattern in the resist upper layer film;
(II-5) transferring the pattern to the resist intermediate film by dry etching while using the patterned resist upper layer film as a mask;
(II-6) transferring the pattern to the resist underlayer film by dry etching while using the resist intermediate film having the transferred pattern as a mask; and
(II-7) forming a pattern on the substrate to be processed by processing the substrate while using the resist underlayer film having the transferred pattern as a mask.

The present invention further provides a patterning process (four-layer resist process) for forming a pattern on a substrate to be processed, comprising steps of:
(III-1) applying the above resist underlayer film material on a substrate to be processed, and then heat-treating the material to form a resist underlayer film;
(III-2) forming an inorganic hard mask intermediate film selected from a silicon oxide film, a silicon nitride film, and a silicon oxynitride film on the resist underlayer film;
(III-3) forming an organic thin film on the inorganic hard mask intermediate film;
(III-4) forming a resist upper layer film on the organic thin film by using a photoresist material;
(III-5) pattern-exposing the resist upper layer film, and then developing the exposed resist upper layer film with a developer to form a pattern in the resist upper layer film;
(III-6) transferring the pattern to the organic thin film and the inorganic hard mask intermediate film by dry etching while using the patterned resist upper layer film as a mask;
(III-7) transferring the pattern to the resist underlayer film by dry etching while using the inorganic hard mask intermediate film having the transferred pattern as a mask; and
(III-8) forming a pattern on the substrate to be processed by processing the substrate while using the resist underlayer film having the transferred pattern as a mask.

A thickness of the resist underlayer film used in the present invention, which is appropriately selected, is preferably 2 to 20,000 nm, particularly preferably 50 to 15,000 nm. In a case of the resist underlayer film for the three-layer process, a silicon-containing resist intermediate film (intermediate layer film) and a silicon-free resist upper layer film can be formed thereon. In a case of the resist underlayer film for the two-layer process, a silicon-containing resist upper layer film or a silicon-free resist upper layer film can be formed thereon.

The inventive patterning process is suitably used for the multilayer resist process such as: the silicon-containing two-layer resist process; the three-layer resist process using a silicon-containing intermediate film; the four-layer resist process using the silicon-containing intermediate film and the organic thin film; and the silicon-free two-layer resist process.

### Three-Layer Resist Process

The inventive patterning process will be described below with an example of the three-layer resist process, but is not limited to this process. In this case, a pattern can be formed on a substrate by: forming a resist underlayer film by using the above resist underlayer film material on a substrate; forming a resist intermediate film on the resist underlayer film by using a resist intermediate film material containing a silicon atom; forming a resist upper layer film above the resist intermediate film by using a resist upper layer film material being a photoresist composition to form a multilayer resist film; exposing a pattern-circuit region in the resist upper layer film; then developing the exposed resist upper layer film with a developer to form a resist pattern in the resist upper layer film; etching the resist intermediate film while using the patterned resist upper layer film as a mask; etching the resist underlayer film while using the patterned resist intermediate film as a mask; and further processing the substrate while using the patterned resist underlayer film as a mask.

Since the resist intermediate film containing a silicon atom has etching resistance against oxygen gas or hydrogen gas, the etching of the underlayer film performed while using the resist intermediate film as a mask is preferably performed by using an etching gas mainly composed of oxygen gas or hydrogen gas, as above.

In the inventive patterning process, a pattern can be formed on a substrate by at least: forming a resist underlayer film by using the above resist underlayer film material on a substrate; forming an inorganic hard mask intermediate film selected from a silicon oxide film, a silicon nitride film, and a silicon oxynitride film on the resist underlayer film; forming a resist upper layer film above the inorganic hard mask intermediate film by using a resist upper layer film material composed of a photoresist composition; exposing a pattern-circuit region in the resist upper layer film; then developing the exposed resist upper layer film with a developer to form a resist pattern in the resist upper layer film; etching the inorganic hard mask intermediate film while using the obtained resist pattern as an etching mask; etching the resist underlayer film while using the obtained inorganic hard mask intermediate film pattern as an etching mask; and processing the substrate while using the obtained resist underlayer film pattern as a mask.

When the inorganic hard mask intermediate film is formed on the resist underlayer film as noted above, the silicon oxide film, the silicon nitride film, or the silicon oxynitride film (SiON film) is formed by a CVD method, an ALD method, etc. A method for forming the nitride film is described in JP 2002-334869 A and WO 2004/066377. A film thickness of the inorganic hard mask is 5 to 200 nm, and preferably 10 to 100 nm. Among these, the SiON film, which is highly effective as an anti-reflective film, is most preferably used for ArF exposure use.

As the silicon-containing resist intermediate film in the three-layer resist process, a polysilsesquioxane-based intermediate film can be suitably used. An anti-reflective effect is easily imparted to the polysilsesquioxane-based intermediate film in excimer exposure, which yields an advantage that reflective light can be reduced during the pattern-exposure of the resist upper layer film to have excellent resolution. In particular, using a material for 193-nm exposure containing a large amount of aromatic groups as the resist underlayer film increases the k-value to increase reflection on the substrate. However, the resist intermediate film reduces the reflection, resulting in the substrate reflection of 0.5% or less. Preferably used for the resist intermediate film having the anti-reflective effect is anthracene for 248-nm or 157-nm exposure, and a polysilsesquioxane crosslinkable with an acid or heat for 193-nm exposure. The polysilsesquioxane has a light absorption group having a phenyl group or silicon-silicon bond at the pendant structure.

In this case, forming the silicon-containing resist intermediate film by a spin-coating method is more convenient than a CVD method, and has a cost merit.

The resist upper layer film in the three-layer resist process may be any of positive-type or negative-type, and a material same as commonly used photoresist compositions can be used. When the resist upper layer film is formed with the photoresist composition, the spin-coating method is preferably used, similarly to the formation of the resist underlayer film. After the photoresist composition is applied by spin-coating, the prebake is performed. The prebake is preferably performed within a range at 60 to 180°C for 10 to 300 seconds. Thereafter, the exposure, then post exposure bake (PEB), and development are performed in accordance with a common method to obtain the resist pattern. A thickness of the resist upper layer film is not particularly limited, and preferably 30 to 500 nm, particularly preferably 50 to 400 nm.

Examples of the exposure light include high-energy ray having a wavelength of 300 nm or less, and specifically, excimer laser with 248 nm, 193 nm, or 157 nm, soft X-ray with 3 to 20 nm, electron beam, and X-ray having a wavelength of less than 3 nm.

Then, etching is performed while using the obtained resist pattern as a mask. The etching of the resist intermediate film in the three-layer process is performed by using a fluorocarbon-based gas while using the resist pattern as a mask. Subsequently, the resist underlayer film is processed by etching using oxygen gas or hydrogen gas while using the resist intermediate film as a mask.

The subsequent etching of the substrate to be processed can be performed in accordance with a common method. For example, when the substrate is a SiO₂-based, SiN-based, or silica-based low dielectric-constant insulative film, the etching is performed mainly using a fluorocarbon-based gas. When the substrate is p-Si, Al, or W, the etching is performed mainly using a chlorine-based gas or a bromine-based gas. When the substrate is processed by etching with the fluorocarbon-based gas, the silicon-containing resist intermediate film in the three-layer resist process is simultaneously removed with the substrate processing. When the substrate is etched by using the chlorine-based or bromine-based gas, a dry etching removal using the fluorocarbon-based gas, etc. is required to be separately performed after the substrate processing in order to remove the silicon-containing resist intermediate film.

As the substrate to be processed, a layer to be processed is formed on a substrate. The substrate is not particularly limited, and used is a material of Si, α-Si, p-Si, SiO₂, SiN, SiON, W, TiN, Al, etc., which differs form a material of the layer to be processed. As the layer to be processed, various low-k films such as Si, SiO₂, SiON, SiN, p-Si, α-Si, W, TiN, W-Si, Al, Cu, and Al-Si, and stopper films thereof are used. The layer to be processed is formed to have a thickness of typically preferably 50 to 10,000 nm, particularly 100 to 5,000 nm. In addition, a substrate having a static contact angle with respect to water of 50° or more can be suitably used as the substrate to be processed.

The inventive patterning process is also suitable for processing a stepped substrate having a structure or step with 30 nm or more in height. Since forming the inventive resist underlayer film on the stepped substrate for filling/planarizing enables to uniformize a film thickness of the resist intermediate film and resist upper layer film formed thereafter, focus depth margin (DOF) during the photolithography is easily achieved, which is extremely preferable. It is also useful when a substrate having a static contact angle with respect to water of 50° or more is used as the substrate to be processed.

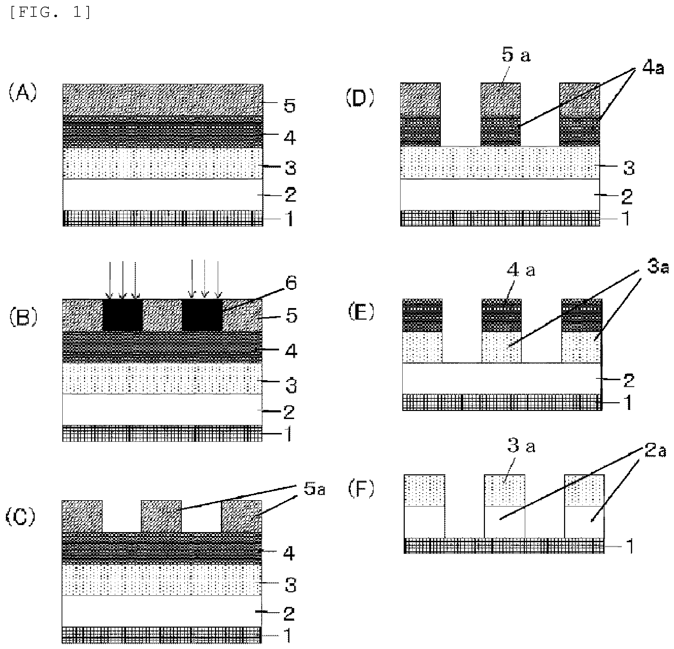

An example of the three-layer resist process will be specifically described as follows by using FIG. 1. In the case of the three-layer resist process, as illustrated in FIG. 1(A), a resist underlayer film 3 is formed on a layer 2 to be processed stacked on a substrate 1, then a resist intermediate film 4 is formed, and a resist upper layer film 5 is formed thereon.

Then, as illustrated in FIG. 1(B), a target portion 6 in the resist upper layer film is exposed, and PEB (post-exposure bake) and development are performed to form a resist upper layer film pattern 5a (FIG. 1(C)). While using this obtained resist upper layer film pattern 5a as a mask, the resist intermediate film 4 is etch-processed by using a CF-based gas to form a resist intermediate film pattern 4a (FIG. 1(D)). After the resist upper layer film pattern 5a is removed, while using this obtained resist intermediate film pattern 4a as a mask, the resist underlayer film 3 is etched with an oxygen-based or hydrogen-based plasma to form a resist underlayer film pattern 3a (FIG. 1(E)). Furthermore, after the resist intermediate film pattern 4a is removed, the layer 2 to be processed is processed by etching while using the resist underlayer film pattern 3a as a mask to form a pattern 2a (FIG. 1(F)).

When the inorganic hard mask intermediate film is used, the resist intermediate film 4 is the inorganic hard mask intermediate film. When the organic thin film is spread, the organic thin film layer is provided between the resist intermediate film 4 and the resist upper layer film 5. The organic thin film may be subsequently etched prior to the etching of the resist intermediate film 4. Alternatively, only the organic thin film can be etched, and then the etching apparatus can be changed, etc. to etch the resist intermediate film 4.

### Four-Layer Resist Process

The present invention can also be suitably used for the four-layer resist process using an organic thin film. In this case, a pattern can be formed on a substrate by at least: forming a resist underlayer film on a substrate by using the above resist underlayer film material; forming an inorganic hard mask intermediate film selected from a silicon oxide film, a silicon nitride film, and a silicon oxynitride film on the resist underlayer film; forming an organic thin film on the inorganic hard mask intermediate film; forming a resist upper layer film on the organic thin film by using a resist upper layer film material composed of a photoresist composition; exposing a pattern-circuit region in the resist upper layer film; then developing the exposed resist upper layer film with a developer to form a resist pattern in the resist upper layer film; etching the organic thin film and the inorganic hard mask intermediate film while using the obtained resist pattern as an etching mask; etching the resist underlayer film while using the obtained inorganic hard mask intermediate film pattern as an etching mask; and processing the substrate while using the obtained resist underlayer film pattern as a mask.

Although the photoresist film may be formed on the resist intermediate film as the resist upper layer film, the organic thin film may be formed on the resist intermediate film by spin-coating, and the photoresist film may be formed thereon, as above. When the SiON film is used as the resist intermediate film and an organic anti-reflective film (Bottom Anti-Reflective Coating: BARC) having an absorption group for the exposure wavelength is used as the organic thin film, the reflection can be inhibited by the two anti-reflective films of the SiON film and the organic thin film even with the immersion exposure having a high NA of more than 1.0. Another merit of forming the BARC is an effect of reducing bottom footing of the resist upper layer film pattern just on the SiON film. When an adhesive film (ADL) having excellent compatibility with the upper layer photoresist is used as the organic thin film, there is another merit that pattern collapse of the photoresist can be inhibited.

### <Method for Forming Resist Underlayer Film>

The present invention provides a method for forming a resist underlayer film as an organic planarizing film used in a semiconductor apparatus manufacturing process, comprising:
applying the above resist underlayer film material on a substrate to be processed by spin-coating; and
heat-treating the substrate coated with the resist underlayer film material within a range at a temperature of 100°C or higher and 600°C or lower for 10 to 600 seconds for curing to form a resist underlayer film (cured film).

The present invention also provides a method for forming a resist underlayer film as an organic planarizing film used in a semiconductor apparatus manufacturing process, comprising:
applying the above resist underlayer film material on a substrate to be processed by spin-coating; and
heat-treating the substrate coated with the resist underlayer film material in an atmosphere with an oxygen concentration of 1 vol% or more and 21 vol% or less for curing to form a resist underlayer film (cured film).

Alternatively, the present invention provides a method for forming a resist underlayer film as an organic planarizing film used in a semiconductor apparatus manufacturing process, comprising:
applying the above resist underlayer film material on a substrate to be processed by spin-coating; and
heat-treating the substrate coated with the resist underlayer film material in an atmosphere with an oxygen concentration of less than 1 vol% for curing to form a resist underlayer film (cured film).

In the inventive method for forming a resist underlayer film, the above resist underlayer film material is applied on the substrate to be processed by using a spin-coating method, etc. Using the spin-coating method, etc. can yield the good filling ability. After the spin-coating, baking is performed for evaporating the solvent to prevent mixing with the resist upper layer film or the resist intermediate film, and to promote the crosslinking reaction. The baking is performed within a temperature range of 100°C or higher and 600°C or lower, preferably 100°C or higher and 300°C or lower, more preferably 150°C or higher and 280°C or lower, and within a range for 10 seconds to 600 seconds, preferably 10 to 300 seconds. Appropriately regulating the baking temperature and time within the above ranges can yield the planarizing/filling ability and curing characteristic suitable for the use. When the baking temperature is 100°C or higher, the curing sufficiently proceeds and causes no mixing with the upper layer film or the intermediate film. When the baking temperature is 600°C or lower, pyrolysis of the base resin can be inhibited, and the film thickness is not decreased to yield a uniform film surface.

The atmosphere during the baking can be selected from any of an oxygen-containing atmosphere (oxygen concentration of 1 vol% to 21 vol%), such as being in air, and a non-oxygen atmosphere, such as being in nitrogen, as necessary. For example, when the substrate to be processed is easily oxidized in air, such a substrate to be processed can be heat-treated in the atmosphere having an oxygen concentration of less than 1 vol% (non-oxygen atmosphere) for forming a cured film to reduce substrate damage.

In the inventive method for forming a resist underlayer film, a substrate having a structure or step with 30 nm or more in height is also preferably used as the substrate to be processed. The inventive method for forming a resist underlayer film is particularly useful when forming a planarizing organic film without voids on the substrate having a structure or step with 30 nm or more in height. Furthermore, the inventive method for forming a resist underlayer film is also useful when using a substrate having a static contact angle with respect to water of 50° or more as the substrate to be processed.

### EXAMPLE

Hereinafter, the present invention will be specifically described with showing Examples and Comparative Examples, but the present invention is not limited by these descriptions. A molecular weight and a dispersion degree were measured by the following method. Determined were a weight-average molecular weight (Mw) in terms of polystyrene and a dispersion degree (Mw/Mn) by gel permeation chromatography (GPC) using tetrahydrofuran as an eluent. An introduction rate of a terminal group was calculated with ¹H-NMR.

### Synthesis Example: Synthesis of Compounds for Resist Underlayer Film Material

For synthesizing compounds (D1) to (D12) and comparative compound (R1) for the resist underlayer film materials, the following triple-bond-containing compounds: a compound group A (A1) to (A3), phenolic hydroxy group-containing carboxylic acid compounds: a compound group B (B1) to (B4), and epoxy compounds: a compound group C (C1) to (C5) were used.

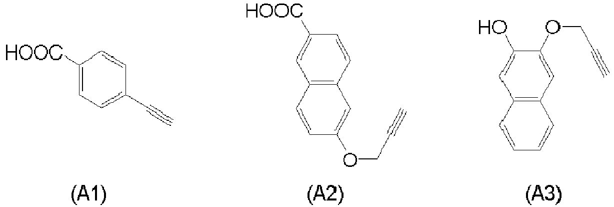

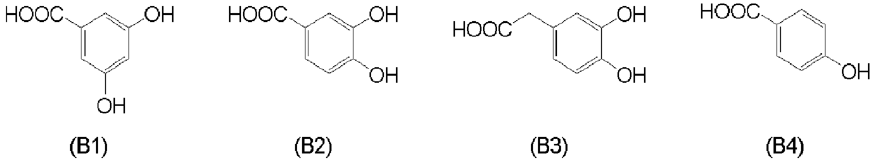

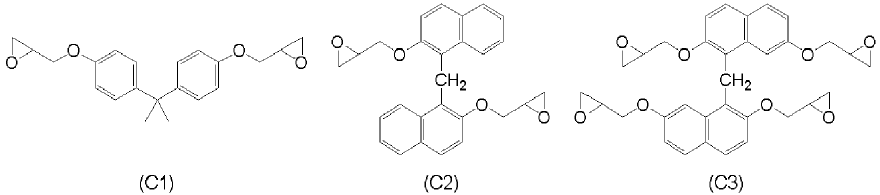

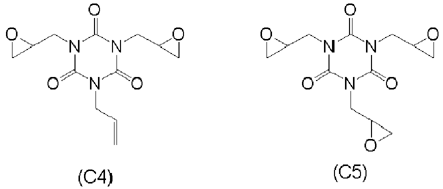

### Synthesis 1 Synthesis of Compound (D1)

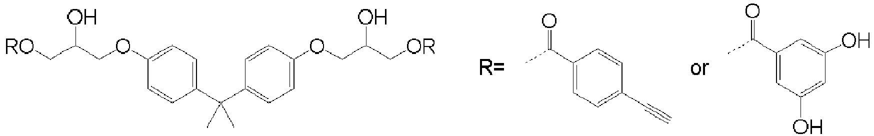

Under a nitrogen atmosphere, 12.44 g of the triple-bond-containing carboxylic acid compound (A1), 1.46 g of the phenolic hydroxy group-containing carboxylic acid compound (B1), 16.10 g of the epoxy compound (C1), and 60 g of 2-methoxy-1-propanol were stirred at an internal temperature of 100°C to form a homogeneous solution. Then, 1.00 g of benzyltriethylammonium chloride was added, and the mixture was stirred at an internal temperature of 110°C for 12 hours. After the mixture was cooled to a room temperature, 200 ml of methyl isobutyl ketone was added, and the organic layer was washed twice with 100 g of a 1 wt% aqueous ammonia solution, twice with 100 g of a 3% aqueous nitric acid solution, and five times with 100 g of ultrapure water in this order. The organic layer was dried and solidified under a reduced pressure to obtain a compound (D1).

The weight-average molecular weight (Mw) and the dispersion degree (Mw/Mn) were determined by GPC to demonstrate Mw = 980 and Mw/Mn = 1.03.

The terminal group ratio calculated with ¹H-NMR was the triple-bond-containing terminal group / the phenolic hydroxy group-containing terminal group = 90.8/9.2.

### Synthesis Examples 2 to 13: Synthesis of Compounds (D2) to (D12) and Comparative Compound (R1)

Compounds (D2) to (D12) and (R1) shown in Table 2 were obtained as products under the same condition as in Synthesis Example 1 except that the compound group A, compound group B, and compound group C shown in Table 1 were used. Of these compounds, a weight-average molecular weight (Mw), a dispersion degree (Mw/Mn), and a terminal group ratio (the triple-bond-containing terminal group / the phenolic hydroxy group-containing terminal group) were determined and shown in Table 2.

**[Table 1]**

| Synthesis Example | Compound group A | Compound group B | Compound group C | Product |
|---|---|---|---|---|
| 1 | A1: 12.44g | B1: 1.46g | C1: 16.10g | D1 |
| 2 | A2: 15.69g | B2: 1.19g | C1: 13.12g | D2 |
| 3 | A1: 9.52g | B1: 1.12g | C2: 14.92g | D3 |
| 4 | A2: 15.07g | B2: 1.15g | C2: 15.28g | D4 |
| 5 | A2: 16.27g | B2: 1.96g | C3: 11.77g | D5 |
| 6 | A2: 20.20g | B2: 1.28g | C4: 13.72g | D6 |
| 7 | A2: 12.14g | B3: 1.05g | C4: 8.42g | D7 |
| 8 | A3: 16.00g | B2: 1.38g | C4: 12.62g | D8 |
| 9 | A2: 19.48g | B2: 1.21g | C5: 9.31g | D9 |
| 10 | A2: 17.92g | B3: 2.66g | C5: 9.42g | D10 |
| 11 | A2: 19.78g | B4: 0.91g | C5: 9.31g | D11 |
| 12 | A3: 17.02g | B2: 1.31g | C5: 9.35g | D12 |
| 13 | A2: 21.52g | - | C5: 9.43g | R1 |

**[Table 2]**

| Synthesis Example | Compound | Terminal group ratio (triple-bond-containing group / phenolic hydroxy group-containing group) | Mw | Mw/Mn |
|---|---|---|---|---|
| 1 | 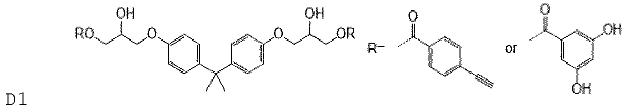 | 90.8 : 9.2 | 980 | 1.03 |
| 2 | 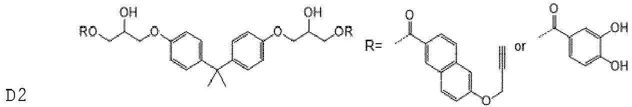 | 91.8 : 8.2 | 1120 | 1.05 |
| 3 | 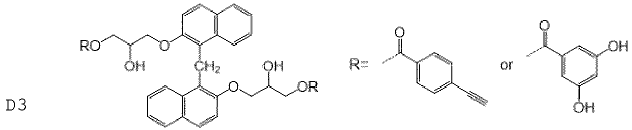 | 90.7 : 9.3 | 1240 | 1.23 |
| 4 | 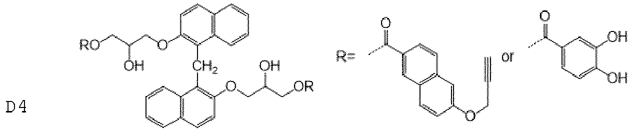 | 90.9 : 9.1 | 1310 | 1.25 |
| 5 | 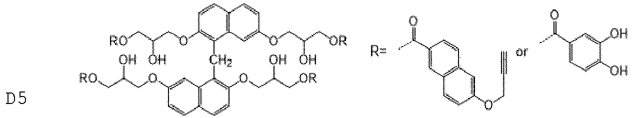 | 86.3 : 13.7 | 2250 | 1.34 |
| 6 | 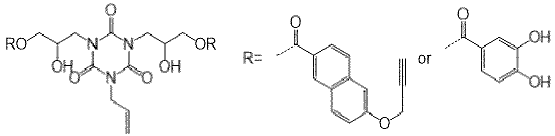 | 93.0 : 7.0 | 710 | 1.05 |
| | 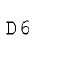 | | | |
| 7 | 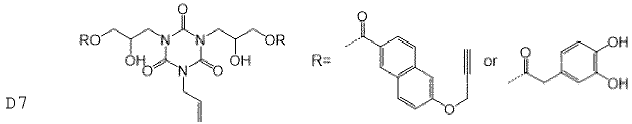 | 90.2 : 9.8 | 720 | 1.06 |
| 8 | 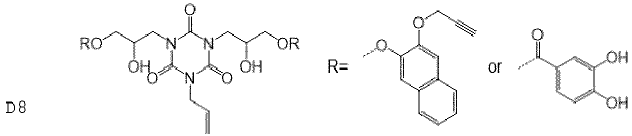 | 92.8 : 7.2 | 710 | 1.06 |
| 9 | 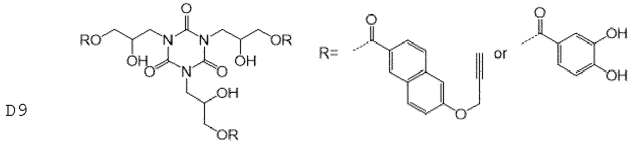 | 94.3 : 5.7 | 1070 | 1.05 |
| 10 | 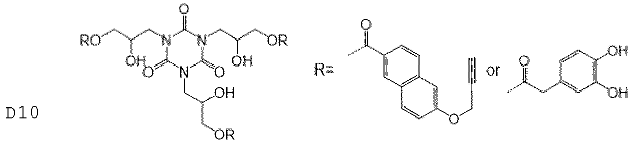 | 85.1 : 14.9 | 1220 | 1.06 |
| 11 | 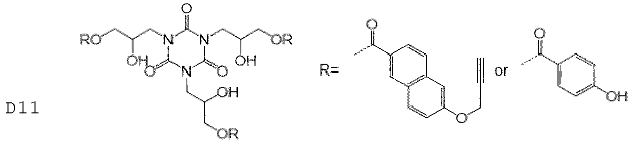 | 93.6 : 6.4 | 1030 | 1.05 |
| 12 | 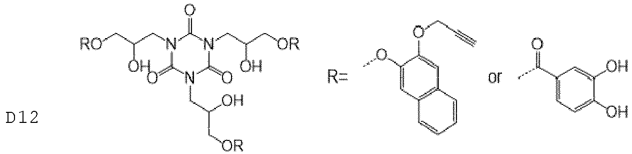 | 91.7 : 8.3 | 1110 | 1.06 |
| 13 | 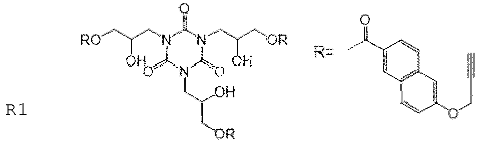 | 100.0 : 0.0 | 1100 | 1.036 |

### Synthesis Example 14: Synthesis of Comparative Compound (R2)

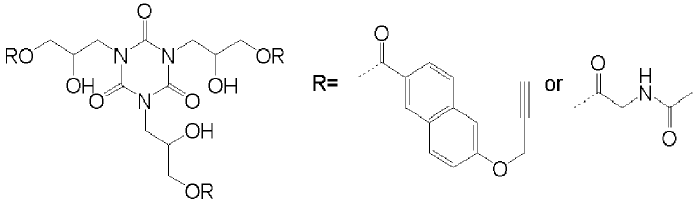

Under a nitrogen atmosphere, 19.86 g of the triple-bond-containing carboxylic acid compound (A2), 1.54 g of acetylglycine, 10.00 g of the epoxy compound (C5), and 60 g of 2-methoxy-1-propanol were stirred at an internal temperature of 100°C to form a homogeneous solution. Then, 1.00 g of benzyltriethylammonium chloride was added, and the mixture was stirred at an internal temperature of 110°C for 12 hours. After the mixture was cooled to a room temperature, 200 ml of methyl isobutyl ketone was added, and the organic layer was washed twice with 100 g of a 1 wt% aqueous ammonia solution, twice with 100 g of a 3% aqueous nitric acid solution, and five times with 100 g of ultrapure water in this order. The organic layer was dried and solidified under a reduced pressure to obtain a comparative compound (R2).

The weight-average molecular weight (Mw) and the dispersion degree (Mw/Mn) were determined by GPC to demonstrate Mw = 1100 and Mw/Mn = 1.04.

The terminal group ratio calculated with ¹H-NMR was the triple-bond-containing terminal group / the amide-group-containing terminal group = 87.5/12.5.

### Synthesis Example 15: Synthesis of Comparative Polymer (R3)

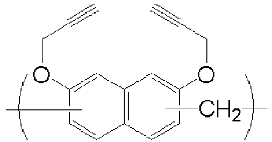

Under a nitrogen atmosphere, 78.8 g of 2,7-dipropargyloxynaphthalene, 21.6 g of a 37% formalin solution, and 250 g of 1,2-dichloroethane were used at a liquid temperature of 70°C to form a homogeneous solution. Then, 5 g of methanesulfonic acid was slowly added, and the mixture was stirred at a liquid temperature of 80°C for 12 hours. After the mixture was cooled to a room temperature, 500 g of methyl isobutyl ketone was added, and the organic layer was washed five times with 200 g of pure water and then the organic layer was dried and solidified under a reduced pressure. Into the residue, 300 mL of THF was added, and the polymer was reprecipitated with 2000 mL of hexane. The precipitated polymer was separated by filtration, and dried under a reduced pressure to obtain a comparative polymer (R3).

The weight-average molecular weight (Mw) and the dispersion degree (Mw/Mn) were determined by GPC to demonstrate Mw = 2700 and Mw/Mn = 1.54.

### Preparation of Resist Underlayer Film Materials (UDL-1 to 15 and Comparative UDL-1 to 6)

Used to dissolve were: the above compounds and polymers (D1) to (D12) and (R1) to (R3); (X1) as the crosslinker; (BG1) to (BG3) as the base generator; tripropylene glycol monomethyl ether (TPM): boiling point of 242°C and 1,6-diacetoxyhexane (1,6-DAH): boiling point of 260°C as the high boiling-point solvent; and a propylene glycol monomethyl ether acetate (PGMEA) containing 0.1 mass% of PF6320 (manufactured by OMNOVA Solutions Inc.) at proportions shown in Table 3. Then, the solution was filtered with a filter made of a fluororesin with 0.1 µm to prepare each of the resist underlayer film materials (UDL-1 to 15 and Comparative UDL-1 to 6).

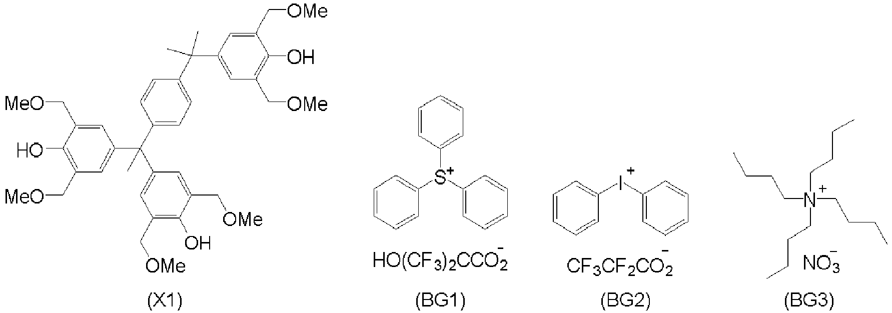

**[Table 3]**

| Resist underlayer film material | Compound or polymer (parts by mass) | Base generator (parts by mass) | Crosslinker (parts by mass) | High boiling-point solvent (parts by mass) | PGMEA (parts by mass) |
|---|---|---|---|---|---|
| UDL-1 | D1 (10) | BG1 (0.1) | - | - | 90 |
| UDL-2 | D2 (10) | BG2 (0.1) | - | - | 90 |
| UDL-3 | D3 (10) | BG1 (0.1) | - | - | 90 |
| UDL-4 | D4 (10) | BG1 (0.1) | - | - | 90 |
| UDL-5 | D5 (10) | BG3 (0.1) | - | - | 90 |
| UDL- 6 | D6 (10) | BG2 (0.1) | - | - | 90 |
| UDL-7 | D7 (10) | BG3 (0.1) | - | - | 90 |
| UDL-8 | D8 (10) | BG1 (0.1) | - | - | 90 |
| UDL-9 | D9 (10) | BG1 (0.1) | - | - | 90 |
| UDL-10 | D10 (10) | BG3 (0.1) | - | - | 90 |
| UDL-11 | D11 (10) | BG1 (0.1) | - | - | 90 |
| UDL-12 | D12 (10) | BG2 (0.1) | - | - | 90 |
| UDL-13 | D7 (10) | BG1 (0.1) | X1 (3) | - | 87 |
| UDL-14 | D2 (10) | BG1 (0.1) | - | 1,6-DAH (5) | 85 |
| UDL-15 | D9 (10) | BG1 (0.1) | - | TPM (5) | 85 |
| Comparative UDL-1 | R1 (10) | BG1 (0.1) | - | - | 90 |
| Comparative UDL-2 | R2 (10) | BG1 (0.1) | - | - | 90 |
| Comparative UDL-3 | R3 (10) | - | - | - | 90 |
| Comparative UDL-4 | R3 (10) | BG1 (0.1) | - | - | 90 |
| Comparative UDL-5 | D10 (10) | - | - | - | 90 |
| Comparative UDL-6 | D11 (10) | - | - | - | 90 |

### Example 1: Evaluation of Film Formability (Examples 1-1 to 1-15 and Comparative Examples 1-1 to 1-6)

The resist underlayer film materials (UDL-1 to 15 and Comparative UDL-1 to 6) prepared above were each applied on a Bare-Si substrate, a SiON-treated substrate, or a hexamethyldisilazane (HMDS)-treated substrate, shown in Table 4. The composition was baked at 250°C for 60 seconds to form a resist underlayer film with 100 nm in film thickness. The formed organic film was observed by using an optical microscope (ECLIPSE L200, manufactured by NIKON CORPORATION) to check absence of coating abnormality. The HMDS treatment was performed under two conditions of 90°C for 60 seconds and 120°C for 120 seconds. A water-contacting angle of each substrate was measured with a contact angle meter (DM-701R, manufactured by Kyowa Interface Science Co., Ltd.), and the Bare-Si substrate had a contact angle of less than 15°, the SiON-treated substrate had a contact angle of 46°, the HMDS-treated (90°C for 60 seconds) substrate had a contact angle of 58°, and the HMDS-treated (120°C for 120 seconds) substrate had a contact angle of 66°. The substrate in which the HMDS treatment was performed at the higher temperature for the longer time was more hydrophobic, and it is more difficult condition to achieve the film formability. In this evaluation, the film thickness was reduced to evaluate relative coatability, which is a strict evaluation condition to easily cause abnormal film formation.

**[Table 4]**

| | Resist underlayer film material | Bare-Si substrate | SiON-treated substrate | HMDS-treated substrate 90°C for 60s | HMDS-treated substrate 120°C for 120s |
|---|---|---|---|---|---|
| Example 1-1 | UDL-1 | No abnormality | No abnormality | No abnormality | Several pinhole defects |
| Example 1-2 | UDL-2 | No abnormality | No abnormality | No abnormality | No abnormality |
| Example 1-3 | UDL-3 | No abnormality | No abnormality | No abnormality | Several pinhole defects |
| Example 1-4 | UDL-4 | No abnormality | No abnormality | No abnormality | No abnormality |
| Example 1-5 | UDL-5 | No abnormality | No abnormality | No abnormality | No abnormality |
| Example 1-6 | UDL-6 | No abnormality | No abnormality | No abnormality | No abnormality |
| Example 1-7 | UDL-7 | No abnormality | No abnormality | No abnormality | No abnormality |
| Example 1-8 | UDL-8 | No abnormality | No abnormality | No abnormality | No abnormality |
| Example 1-9 | UDL-9 | No abnormality | No abnormality | No abnormality | No abnormality |
| Example 1-10 | UDL-10 | No abnormality | No abnormality | No abnormality | No abnormality |
| Example 1-11 | UDL-11 | No abnormality | No abnormality | No abnormality | Several pinhole defects |
| Example 1-12 | UDL-12 | No abnormality | No abnormality | No abnormality | No abnormality |
| Example 1-13 | UDL-13 | No abnormality | No abnormality | No abnormality | No abnormality |
| Example 1-14 | UDL-14 | No abnormality | No abnormality | No abnormality | No abnormality |
| Example 1-15 | UDL-15 | No abnormality | No abnormality | No abnormality | No abnormality |
| Comparative Example 1-1 | Comparative UDL-1 | No abnormality | Several pinhole defects | Several pinhole defects | Numerous pinhole defects |
| Comparative Example 1-2 | Comparative UDL-2 | No abnormality | Several pinhole defects | Several pinhole defects | Numerous pinhole defects |
| Comparative Example 1-3 | Comparative UDL-3 | No abnormality | No abnormality | No abnormality | No abnormality |
| Comparative Example 1-4 | Comparative UDL-4 | No abnormality | No abnormality | No abnormality | No abnormality |
| Comparative Example 1-5 | Comparative UDL-5 | No abnormality | No abnormality | No abnormality | Numerous pinhole defects |
| Comparative Example 1-6 | Comparative UDL-6 | No abnormality | Numerous pinhole defects | Numerous pinhole defects | Numerous pinhole defects |

As shown in Table 4, the inventive resist underlayer film material was able to form a uniform resist underlayer film without coating abnormality on the SiON-treated substrate and the HMDS-treated (90°C for 60 seconds) substrate. In Examples 1-1, 1-3, and 1-11, which had no catechol-type terminal structure, a slight amount of pinholes were generated on the HMDS-treated (120°C for 120 seconds) substrate. Meanwhile, other Examples, which had the catechol-type terminal structure, exhibited good film formability without dependency on the substrate. In Examples 1-1, 1-3, and 1-11, the film formability on the HMDS-treated (120°C for 120 seconds) substrate was improved compared with Comparative Examples 1-5 and 1-6. It can be confirmed that combining the phenolic hydroxy group-containing compound and the base generator has usefulness. In Comparative Examples 1-1 and 1-2, which had no action of the base generator during the film baking, numerous pinholes were generated on the HMDS-treated (120°C for 120 seconds) substrate, and no effect of improving the film formability was observed. Meanwhile, in Comparative Examples 1-3 and 1-4, which contained the polymer, the film was able to be formed on the SiON-treated substrate and the HMDS substrate regardless of the presence/absence of the base generator.

### Example 2: Evaluation of Edge Deterioration (Examples 2-1 to 2-15 and Comparative Examples 2-1 to 2-6)

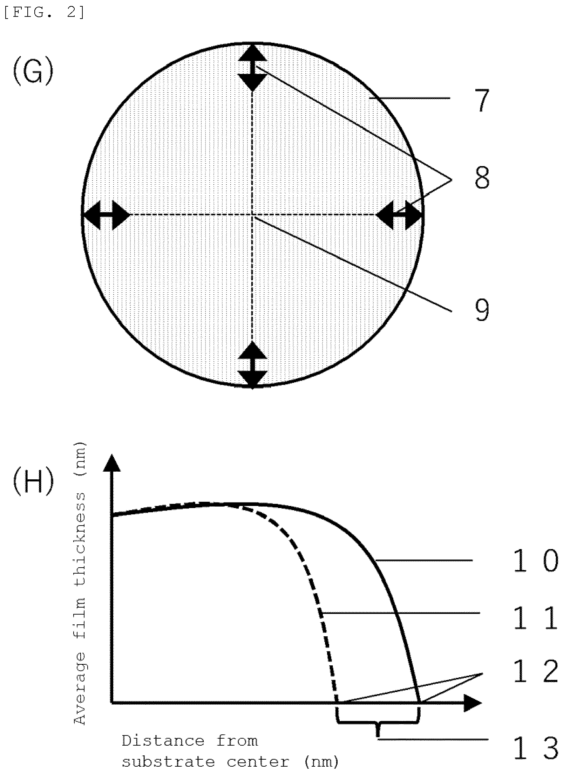

The resist underlayer film materials (UDL-1 to 15 and Comparative UDL-1 to 6) prepared above were each applied on a 12-inch Bare-Si substrate and HMDS-treated (120°C for 120 seconds) substrate with an edge-cut width of 2 mm, and the material was baked at 250°C for 60 seconds to form a resist underlayer film with 100 nm in film thickness (7 in FIG. 2(G)). The formed organic film was measured by using a film thickness measurement apparatus (Atlas-XP⁺, manufactured by Onto Innovation Inc.) at four positions of each substrate within a range of 145 mm to 149 mm in diameter from a substrate center 9 with each 0.1 mm (8 in FIG. 2(G)). FIG. 2(H) illustrates an average film thickness plot 10 on the Bare-Si substrate and an average film thickness plot 11 on the HMDS substrate. As illustrated herein, a point at which this average film thickness was 0 was specified as a film edge 12, and a difference in the film edge position on the Bare-Si substrate and HMDS-treated substrate was determined as an edge deterioration distance 13. Table 5 shows the results. A smaller edge deterioration distance 13 is considered to be excellent coatability on the HMDS substrate.

**[Table 5]**

| | Resist underlayer film material | Distance from substrate center to film edge | | Edge deterioration distance: |
|---|---|---|---|---|
| | | Bare-Si substrate: a (mm) | HMDS-treated substrate: b (mm) | a - b (mm) |
| Example 2-1 | UDL-1 | 148.0 | 147.7 | 0.3 |
| Example 2-2 | UDL-2 | 148.1 | 148.0 | 0.1 |
| Example 2-3 | UDL-3 | 148.1 | 147.7 | 0.4 |
| Example 2-4 | UDL-4 | 148.0 | 148.0 | 0.0 |
| Example 2-5 | UDL-5 | 148.0 | 148.0 | 0.0 |
| Example 2-6 | UDL-6 | 148.0 | 148.0 | 0.0 |
| Example 2-7 | UDL-7 | 147.9 | 147.9 | 0.0 |
| Example 2-8 | UDL-8 | 148.0 | 147.9 | 0.1 |
| Example 2-9 | UDL-9 | 148.0 | 148.0 | 0.0 |
| Example 2-10 | UDL-10 | 147.9 | 147.9 | 0.0 |
| Example 2-11 | UDL-11 | 148.0 | 147.6 | 0.4 |
| Example 2-12 | UDL-12 | 148.0 | 148 | 0.0 |
| Example 2-13 | UDL-13 | 148.1 | 148.1 | 0.0 |
| Example 2-14 | UDL-14 | 148.1 | 148.1 | 0.0 |
| Example 2-15 | UDL-15 | 148.0 | 148.0 | 0.0 |
| Comparative Example 2-1 | Comparative UDL-1 | 148.0 | <145.0 | >3.0 mm |
| Comparative Example 2-2 | Comparative UDL-2 | 148.0 | <145.0 | >3.0 mm |
| Comparative Example 2-3 | Comparative UDL-3 | 147.9 | 147.9 | 0.0 |
| Comparative Example 2-4 | Comparative UDL-4 | 148.1 | 148.0 | 0.1 |
| Comparative Example 2-5 | Comparative UDL-5 | 148.0 | 146.5 | 1.5 |
| Comparative Example 2-6 | Comparative UDL-6 | 148.1 | 145.8 | 2.3 |

As shown in Table 5, the inventive resist underlayer film material had an edge deterioration distance of approximately 0.1 mm or less in Examples having the catechol-type terminal structure, and it is considered that there is almost no deterioration in film edge with considering an error of the film thickness measurement. In Examples 2-1, 2-3, and 2-11, which had no catechol-type terminal structure, the edge deterioration distance of 0.4 mm or less, which was slight deterioration, but the edge deterioration was obviously improved compared with Comparative Example 2-6. It can be confirmed that combining the phenolic hydroxy group-containing compound and the base generator has usefulness. In Comparative Examples 2-1 and 2-2, which had no action of the base generator during the film baking, the film edge on the HMDS-treated substrate was considerably deteriorated, and the film edge was not able to be observed within the measurement range. Meanwhile, in Comparative Examples 2-3 and 2-4, which contained the polymer, there was no deterioration in film edge on the HMDS substrate regardless of the presence/absence of the base generator.

### Example 3: Evaluation of Filling Ability (Examples 3-1 to 3-15 and Comparative Examples 3-1 to 3-6)

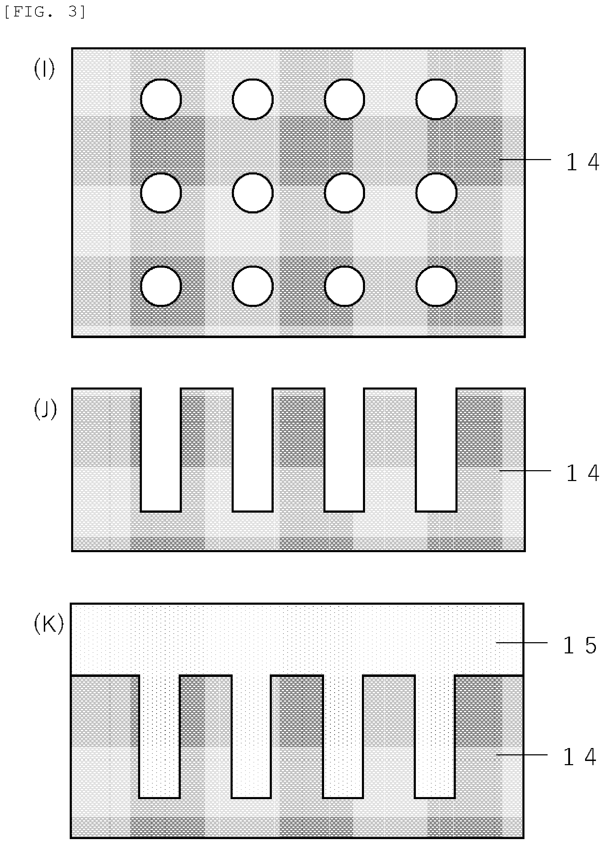

The resist underlayer film materials (UDL-1 to 15 and Comparative UDL-1 to 6) prepared above were each applied on a SiO₂ wafer substrate having a dense hole pattern (hole diameter: 0.16 µm, hole depth: 0.50 µm, and distance between centers of adjacent two holes: 0.32 µm), and baked at 250°C for 60 seconds to form a resist underlayer film. The used substrate was a base substrate 14 (SiO₂ wafer substrate) having the dense hole pattern as illustrated in FIG. 3(I) (overhead view) and FIG. 3(J) (sectional view). A cross-sectional shape of the obtained each wafer substrate was observed by using a scanning electron microscope (SEM) to check whether voids (cavities) are absent inside the holes and filled with the resist underlayer film 15. Table 6 shows the results. When a resist underlayer film material having poor filling ability is used, voids are generated inside the holes in this evaluation. When a resist underlayer film material having good filling ability is used, a void is absent inside the holes as illustrated in FIG.3(K) and filled with the resist underlayer film in this evaluation.

**[Table 6]**

| | Resist underlayer film material | Presence/absence of void |
|---|---|---|
| Example 3-1 | UDL-1 | Absence |
| Example 3-2 | UDL-2 | Absence |
| Example 3-3 | UDL-3 | Absence |
| Example 3-4 | UDL-4 | Absence |
| Example 3-5 | UDL-5 | Absence |
| Example 3-6 | UDL-6 | Absence |
| Example 3-7 | UDL-7 | Absence |
| Example 3-8 | UDL-8 | Absence |
| Example 3-9 | UDL-9 | Absence |
| Example 3-10 | UDL-10 | Absence |
| Example 3-11 | UDL-11 | Absence |
| Example 3-12 | UDL-12 | Absence |
| Example 3-13 | UDL-13 | Absence |
| Example 3-14 | UDL-14 | Absence |
| Example 3-15 | UDL-15 | Absence |
| Comparative Example 3-1 | Comparative UDL-1 | Absence |
| Comparative Example 3-2 | Comparative UDL-2 | Absence |
| Comparative Example 3-3 | Comparative UDL-3 | Presence |
| Comparative Example 3-4 | Comparative UDL-4 | Presence |
| Comparative Example 3-5 | Comparative UDL-5 | Absence |
| Comparative Example 3-6 | Comparative UDL-6 | Absence |

As shown in Table 6, any of the inventive resist underlayer film material can fill the hole pattern without voids, and found to have excellent filling ability. Meanwhile, in Comparative Examples 3-3 and 3-4, filling was failed presumably due to insufficient thermal flowability since the material contains the polymer.

### Example 4: Evaluation of Planarizing Ability (Examples 4-1 to 4-15 and Comparative Examples 4-1 to 4-6)

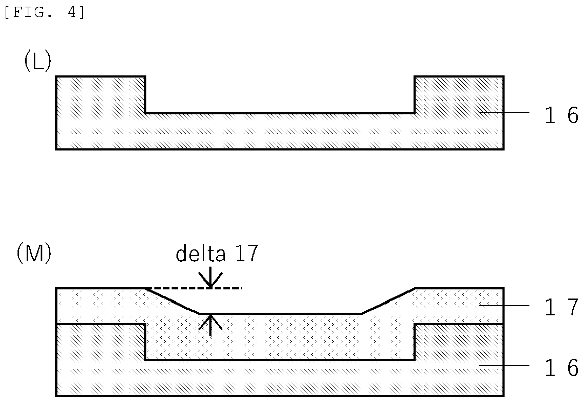

The resist underlayer film materials (UDL-1 to 15 and Comparative UDL-1 to 6) prepared above were each applied on a base substrate 16 (SiO₂ wafer substrate) having a giant isolated trench pattern (FIG. 4(L), trench width: 10 µm, trench depth: 0.10 µm). The material was baked at 250°C for 60 seconds. Then, a step on a resist underlayer film 17 between the trenched portion and the non-trenched portion (delta 17 in FIG. 4(M)) was observed by using NX10 atomic force microscope (AFM), manufactured by Park Systems Corporation. Table 7 shows the results. In this evaluation, the smaller the step, the better the planarizing ability. In this evaluation, the trench pattern with 0.10 µm in depth is planarized by using the resist underlayer film material with a film thickness of approximately 0.2 µm, which is a strict evaluation condition to evaluate relative planarizing ability.

**[Table 7]**

| | Resist underlayer film material | Step (nm) |
|---|---|---|
| Example 4-1 | UDL-1 | 35 |
| Example 4-2 | UDL-2 | 20 |
| Example 4-3 | UDL-3 | 30 |
| Example 4-4 | UDL-4 | 30 |
| Example 4-5 | UDL-5 | 35 |
| Example 4-6 | UDL-6 | 20 |
| Example 4-7 | UDL-7 | 15 |
| Example 4-8 | UDL-8 | 20 |
| Example 4-9 | UDL-9 | 25 |
| Example 4-10 | UDL-10 | 25 |
| Example 4-11 | UDL-11 | 45 |
| Example 4-12 | UDL-12 | 25 |
| Example 4-13 | UDL-13 | 25 |
| Example 4-14 | UDL-14 | 10 |
| Example 4-15 | UDL-15 | 15 |
| Comparative Example 4-1 | Comparative UDL-1 | 40 |
| Comparative Example 4-2 | Comparative UDL-2 | 20 |
| Comparative Example 4-3 | Comparative UDL-3 | 80 |
| Comparative Example 4-4 | Comparative UDL-4 | 80 |
| Comparative Example 4-5 | Comparative UDL-5 | 25 |
| Comparative Example 4-6 | Comparative UDL-6 | 45 |

As shown in Table 7, the inventive resist underlayer film material yields a small step between the trenched portion and non-trenched portion on the resist underlayer film compared with Comparative Examples 4-3 and 4-4, which contains the polymer, and it is found to have excellent planarizing ability. Comparing Example 4-10 and Comparative Example 4-5, or Example 4-11 and Comparative Example 4-6 found no change in planarization, and it can be confirmed that adding the base generator does not deteriorate the planarizing ability.

### Example 5: Patterning Test (Examples 5-1 to 5-10 and Comparative Examples 5-1 to 5-6)

UDL-2, 6 to 10, 12 to 15, and Comparative UDL-1 to 6, prepared as above, were each applied on an HMDS-treated (120°C for 120 seconds) SiO₂ substrate having a formed SiO₂ film with 200 nm in film thickness and having a trench pattern (trench width: 10 µm, trench depth: 0.10 µm). The material was baked at 250°C for 60 seconds in air so that the film thickness was 200 nm on a Bare Si substrate to form a resist underlayer film. A silicon-containing resist intermediate film material (SOG-1) was applied thereon, and baked at 220°C for 60 seconds to form a resist intermediate film with 35 nm in film thickness. Then, a resist upper layer film material (SL resist for ArF) was applied and baked at 105°C for 60 seconds to form a resist upper layer film with 100 nm in film thickness. On the resist upper layer film, an immersion protective film (TC-1) was applied and baked at 90°C for 60 seconds to form a protective film with 50 nm in film thickness.

The resist upper layer film material (SL resist for ArF) was prepared by: dissolving a polymer (RP 1), an acid generator (PAG 1), and a base compound (Amine 1) in a solvent containing 0.1 mass% of FC-430 (manufactured by Sumitomo 3M Limited.) at proportions in Table 8; and filtering the solution with a filter made of a fluororesin with 0.1 µm.

**[Table 8]**

| | Polymer (parts by mass) | Acid generator (parts by mass) | Base compound (parts by mass) | Solvent (parts by mass) |
|---|---|---|---|---|
| SL resist for ArF | RP 1 (100) | PAG 1 (6.6) | Amine 1 (0.8) | PGMEA (2500) |

The structural formulae of the used polymer (RP 1), acid generator (PAG 1), and base compound (Amine 1) are shown below.

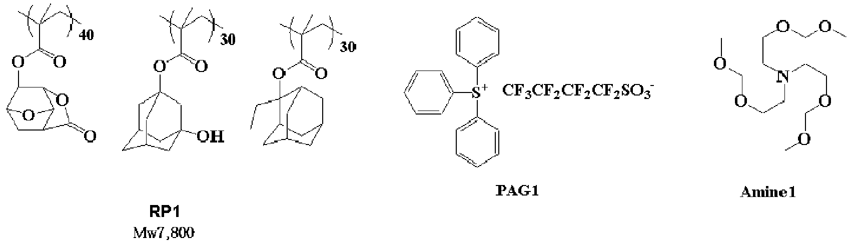

The immersion protective film material (TC-1) was prepared by: dissolving a protective film polymer (PP 1) in an organic solvent at proportions in Table 9; and filtering the solution with a filter made of a fluororesin with 0.1 µm.

**[Table 9]**

| | Polymer (parts by mass) | Organic solvent (parts by mass) |
|---|---|---|
| TC-1 | PP 1 (100) | Diisoamyl ether (2700) |
| | | 2-Methyl-1-butanol (270) |

The structural formula of the used polymer (PP1) is shown below.

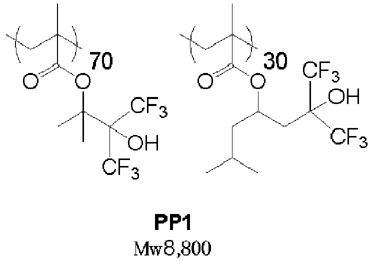

The silicon-containing resist intermediate film material (SOG-1) was prepared by: dissolving a polymer represented by a silicon-containing intermediate film polymer for ArF (SiP 1) and a crosslinking catalyst (CAT 1) in an organic solvent containing 0.1 mass% of FC-4430 (manufactured by Sumitomo 3M Limited.) at proportions in Table 10; and filtering the solution with a filter made of a fluororesin with a pore diameter of 0.1 µm to prepare the silicon-containing resist intermediate film material (SOG-1).

**[Table 10]**

| | Polymer (parts by mass) | Thermally crosslinking catalyst (parts by mass) | Organic solvent (parts by mass) |
|---|---|---|---|
| SOG-1 | SiP 1 (100) | CAT 1 (1) | Propylene glycol monoethyl ether (4000) |

The structural formulae of the used silicon-containing intermediate film polymer for ArF (SiP 1) and crosslinking catalyst (CAT 1) are shown below.

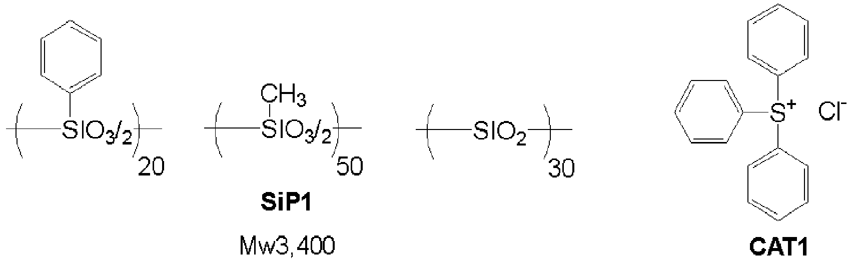

Then, the film was exposed by using an ArF immersion exposure apparatus (manufactured by NIKON CORPORATION; NSR-S610C, NA 1.30, σ 0.98/0.65, 35°-dipole s-polarized illumination, 6% halftone phase-shifting mask) with changing the exposure dose, baked at 100°C for 60 seconds (PEB), and developed with a 2.38 mass% aqueous solution of tetramethylammonium hydroxide (TMAH) for 30 seconds to obtain positive-type line-and-space patterns with 100 nm in pitch and 50 nm to 30 nm in resist line width.

Then, the silicon-containing intermediate film was processed by dry etching using an etching apparatus "Telius", manufactured by Tokyo Electron Ltd., while using the resist pattern as a mask, the underlayer film was processed while using the silicon-containing intermediate film as a mask, and the SiO₂ film was processed while using the underlayer film as a mask.

The etching conditions were as follows.

The condition of transferring the resist pattern to the SOG film.
Chamber pressure: 10.0 Pa
RF power: 1,500 W
CF₄ gas flow rate: 15 sccm
O₂ gas flow rate: 75 sccm
Time: 15 sec

The condition of transferring the SOG film pattern to the underlayer film.
Chamber pressure: 2.0 Pa
RF power: 500 W
Ar gas flow rate: 75 sccm
O₂ gas flow rate: 45 sccm
Time: 120 sec

The condition of transferring the underlayer film pattern to the SiO₂ film.
Chamber pressure: 2.0 Pa
RF power: 2,200 W
C₅F₁₂ gas flow rate: 20 sccm
C₂F₆ gas flow rate: 10 sccm
Ar gas flow rate: 300 sccm
O₂ gas flow rate: 60 sccm
Time: 90 sec

A cross section of the pattern was observed with an electron microscope (S-4700), manufactured by Hitachi, Ltd., to compare the shape. Table 11 summarizes the results.

**[Table 11]**

| | Resist underlayer film material | Pattern shape after substrate-transferring etching |
|---|---|---|
| Example 5-1 | UDL-2 | Vertical |
| Example 5-2 | UDL-6 | Vertical |
| Example 5-3 | UDL-7 | Vertical |
| Example 5-4 | UDL-8 | Vertical |
| Example 5-5 | UDL-9 | Vertical |
| Example 5-6 | UDL-10 | Vertical |
| Example 5-7 | UDL-12 | Vertical |
| Example 5-8 | UDL-13 | Vertical |
| Example 5-9 | UDL-14 | Vertical |
| Example 5-10 | UDL-15 | Vertical |
| Comparative Example 5-1 | Comparative UDL-1 | Collapsed |
| Comparative Example 5-2 | Comparative UDL-2 | Collapsed |
| Comparative Example 5-3 | Comparative UDL-3 | Collapsed |
| Comparative Example 5-4 | Comparative UDL-4 | Collapsed |
| Comparative Example 5-5 | Comparative UDL-5 | Collapsed |
| Comparative Example 5-6 | Comparative UDL-6 | Collapsed |

As the results of the inventive resist underlayer film materials (Examples 5-1 to 5-10) shown in Table 11, the resist upper layer film pattern in any cases was finally transferred favorably to the substrate, and the inventive resist underlayer film material has been confirmed to be suitably used for fine processing with the multilayer resist method. Meanwhile, in Comparative Examples 5-1, 5-2, 5-5, and 5-6, as shown in the results of the evaluation of the film formability of Example 1, the pinhole generated during the film formation caused pattern collapse during the pattern processing, resulting in failure to form a pattern. Comparative Examples 5-3 and 5-4, which had poor filling ability and planarizing ability as shown in Examples 3 and 4, caused pattern collapse during the pattern processing, resulting in failure to form a pattern.

The above results have revealed that: the inventive resist underlayer film material, which has good film formability and excellent filling/planarizing ability, is extremely useful for the organic film material used for the multilayer resist method; the inventive patterning process using this material can form a fine pattern with high precision even on a body to be processed being a stepped substrate. Furthermore, the inventive resist underlayer film material need not contain an acid generator, can prevent a problem caused by a decomposed product of the acid generator such as pattern defect, and can yield the maximum effect of the base generator.

The present specification includes the following aspects.
[1]: A resist underlayer film material, comprising:
   (A) a compound or resin having a phenolic hydroxy group;
   (B) a base generator; and
   (C) an organic solvent.
[2]: The resist underlayer film material according to [1], wherein the component (A) has a weight-average molecular weight of 3,000 or less in terms of polystyrene.
[3]: The resist underlayer film material according to [1] or [2], wherein the base generator (B) is a compound to exhibit basicity by pyrolysis.
[4]: The resist underlayer film material according to any one of [1] to [3], wherein the base generator (B) is any one represented by the following general formulae (1), (2), and (3),

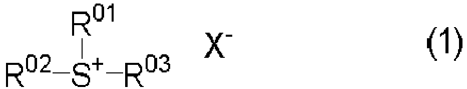

   R⁰⁴-|⁺-R⁰⁵ X⁻ (2)

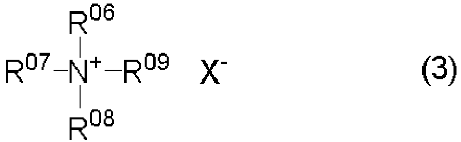

   wherein R⁰¹ to R⁰³ each independently represent a linear, branched, or cyclic alkyl group or alkenyl group having 1 to 10 carbon atoms, optionally substituted with a heteroatom or optionally having an interposed heteroatom, or represent an aryl group or aralkyl group having 6 to 18 carbon atoms, optionally substituted with a heteroatom or optionally having an interposed heteroatom; any two of R⁰¹, R⁰², and R⁰³ are optionally bonded to each other to form a ring together with the sulfur atom in the formula; X⁻ represents an organic or inorganic anion to be a counterion, X⁻ excluding OH⁻; R⁰⁴ and R⁰⁵ each independently represent an aryl group having 6 to 20 carbon atoms, and a part or all of hydrogen atoms thereof are optionally substituted with a linear, branched, or cyclic alkyl group or alkoxy group having 1 to 10 carbon atoms; R⁰⁴ and R⁰⁵ are optionally bonded to each other to form a ring together with the iodine atom in the formula; R⁰⁶, R⁰⁷, R⁰⁸, and R⁰⁹ each independently represent a hydrogen atom, or a linear, branched, or cyclic alkyl group or alkenyl group having 1 to 20 carbon atoms, optionally substituted with a heteroatom or optionally having an interposed heteroatom, or represent an aryl group or aralkyl group having 6 to 18 carbon atoms, optionally substituted with a heteroatom or optionally having an interposed a heteroatom; any two or more of R⁰⁶, R⁰⁷, R⁰⁸, and R⁰⁹ are optionally bonded to each other to form a ring together with the nitrogen atom in the formula.
[5]: The resist underlayer film material according to [4], wherein X⁻ in the general formulae (1), (2), and (3) represents an anion selected from the group consisting of a chloride ion, a bromide ion, an iodide ion, a fluoride ion, a cyanide ion, a nitride ion, a nitrite ion, and any anions represented by the following general formulae (4), (5), and (6),

   R¹⁰-COO⁻ (4)

   R¹¹-SO₃⁻ (5)

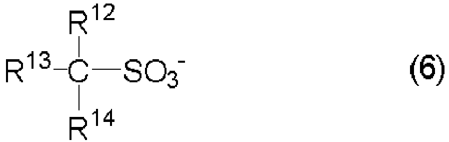

   wherein R¹⁰ represents a linear, branched, or cyclic hydrocarbon group having 1 to 20 carbon atoms selected from an alkyl group, an alkenyl group, an aralkyl group, and an aryl group, the hydrocarbon group optionally having an ether group, an ester group, or a carbonyl group, and optionally substituted one or more of hydrogen atoms thereof with a halogen atom, a hydroxy group, a carboxyl group, an amino group, and a cyano group; R¹¹ represents an aryl group having 1 to 20 carbon atom, and optionally substituted one or more of hydrogen atoms thereof with a halogen atom, a hydroxy group, a carboxyl group, an amino group, and a cyano group; R¹², R¹³, and R¹⁴ each independently represent a hydrogen atom, a halogen atom other than a fluorine atom, or a linear, branched, or cyclic hydrocarbon group having 1 to 20 carbon atoms selected from an alkyl group, an alkenyl group, an aralkyl group, and an aryl group, the hydrocarbon group optionally having an ether group, an ester group, or a carbonyl group, and optionally substituted one or more of hydrogen atoms thereof with a halogen atom, a hydroxy group, a carboxyl group, an amino group, and a cyano group; and two or more of R¹², R¹³, and R¹⁴ are optionally bonded to each other to form a ring.
[6]: The resist underlayer film material according to [4] or [5], wherein a conjugate acid of X⁻ , X-H, in the general formulae (1), (2), and (3) has a boiling point of 200°C or lower.
[7]: The resist underlayer film material according to any one of [1] to [6], wherein the compound (A) having a phenolic hydroxy group is represented by the following general formula (7), 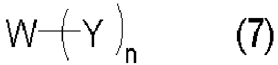
   wherein W represents an n-valent organic group having 2 to 50 carbon atoms; Y represents a terminal group structure represented by the following general formula (8) or general formula (9); proportions of structures represented by the formula (8) and (9) satisfy relationships of a + b = 1.0, 0.70 ≤ a ≤ 0.99, and 0.01 ≤ b ≤ 0.30, where "a" represents a proportion of the structure represented by the formula (8) and "b" represents a proportion of the structure represented by the formula (9); and "n" represents an integer of 1 to 10, 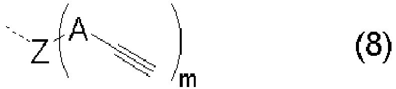
   wherein a broken line represents a bond; Z represents an (m + 1)-valent aromatic group having 6 to 20 carbon atoms; A represents a single bond or -O-(CH₂)ₚ-; "m" represents an integer of 1 to 5; and "p" represents an integer of 1 to 10, 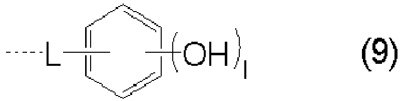
   wherein a broken line represents a bond; L represents a single bond or -(CH₂)ᵣ-; "l" represents 2 or 3; and "r" represents an integer of 1 to 5.
[8]: The resist underlayer film material according to [7], wherein A in the general formula (8) represents -OCH₂-.
[9]: The resist underlayer film material according to [7] or [8], wherein the general formula (8) is any one of the following formulae (10), (11), and (12), 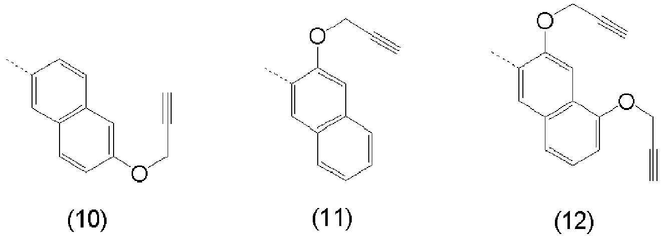 wherein a broken line represents a bond.
[10]: The resist underlayer film material according to any one of [7] to [9], wherein the general formula (9) is the following formula (13) or (14), 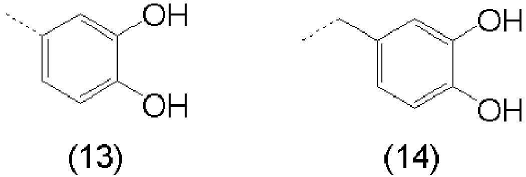 wherein a broken line represents a bond.
[11]: The resist underlayer film material according to any one of [7] to [10], wherein W in the general formula (7) is represented by the following general formula (15), 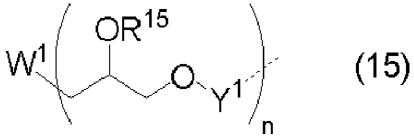 wherein a broken line represents a bond; R¹⁵ represents a hydrogen atom, or one hydrocarbon group of an alkyl group or acyl group, the group having 1 to 20 carbon atoms and optionally having an oxygen atom or a nitrogen atom; W¹ represents an n-valent organic group having 1 to 47 carbon atoms; Y¹ represents a single bond or a carbonyl group; and "n" represents an integer of 1 to 10.
[12]: The resist underlayer film material according to [11], wherein W¹ in the general formula (15) represents a structure represented by any one of the following formulae, 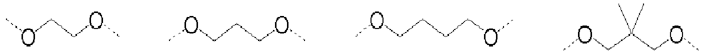 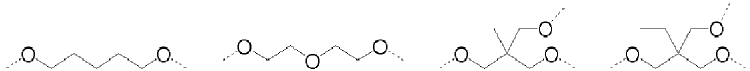 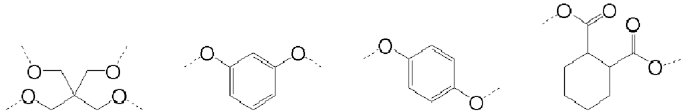 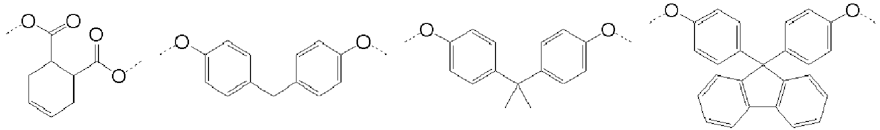 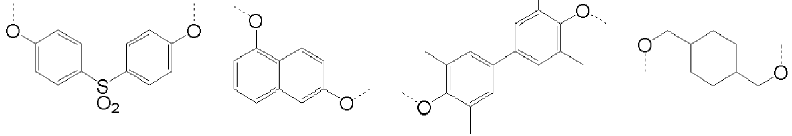 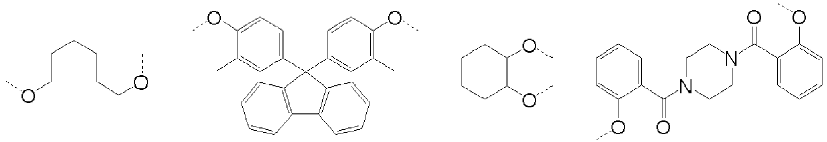 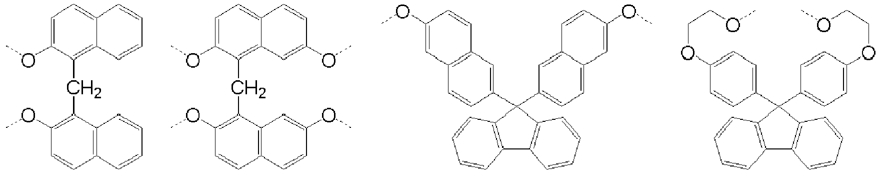 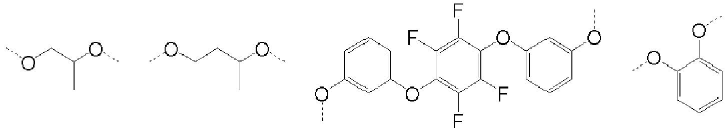 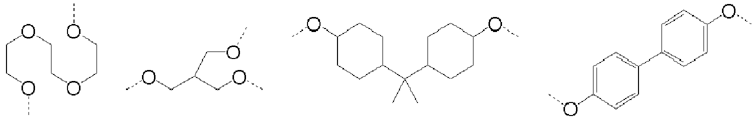 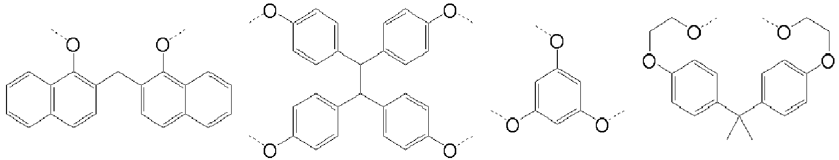 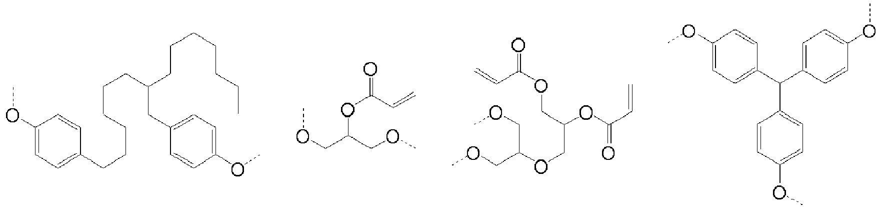 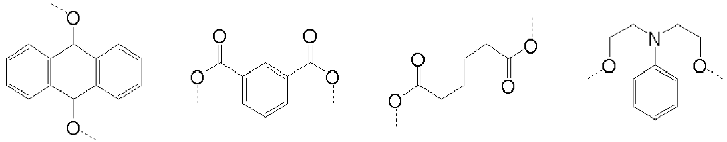 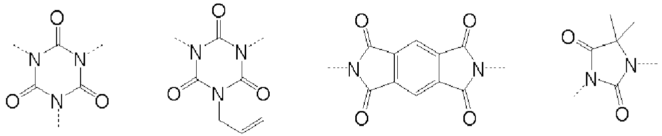 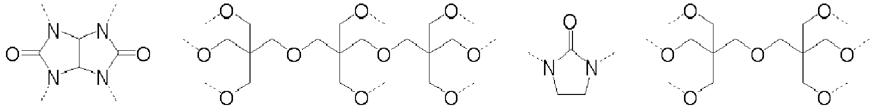 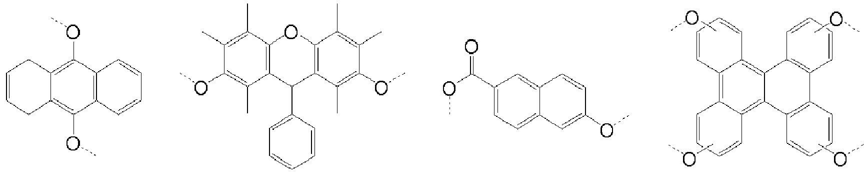 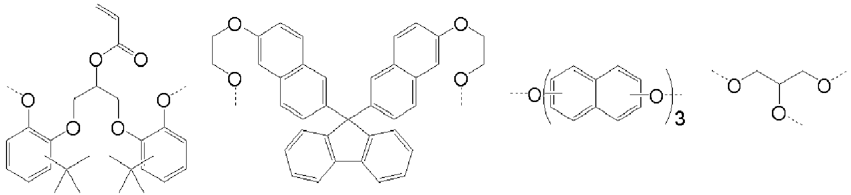 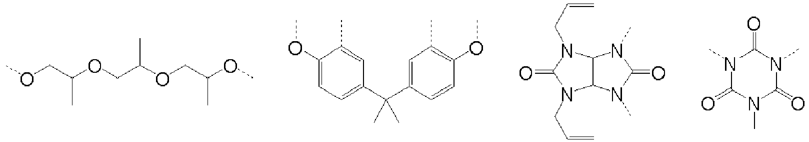 wherein a broken line represents a bond.
[13]: The resist underlayer film material according to any one of [1] to [12], wherein the organic solvent (C) is a mixture of one or more kinds of organic solvents having a boiling point of lower than 180°C and one or more kinds of organic solvents having a boiling point of 180°C or higher.
[14]: The resist underlayer film material according to any one of [1] to [13], further comprising one or more of (D) a surfactant, (E) a crosslinker, (F) a plasticizer, and (G) a colorant.
[15]: The resist underlayer film material according to [14], wherein the crosslinker (E) is a compound represented by the following general formula (16), 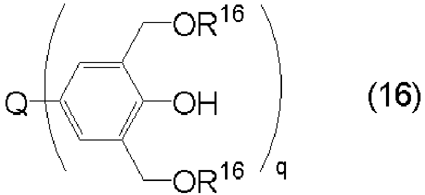 wherein Q represents a single bond or a q-valent hydrocarbon group having 1 to 20 carbon atoms; R¹⁶ represents a hydrogen atom or an alkyl group having 1 to 20 carbon atoms; and "q" represents an integer of 1 to 5.
[16]: A patterning process for forming a pattern on a substrate to be processed, comprising steps of:
   (I-1) applying the resist underlayer film material according to any one of [1] to [15] on a substrate to be processed, and then heat-treating the material to form a resist underlayer film;
   (I-2) forming a resist upper layer film on the resist underlayer film by using a photoresist material;
   (I-3) pattern-exposing the resist upper layer film, and then developing the exposed resist upper layer film with a developer to form a pattern in the resist upper layer film;
   (I-4) transferring the pattern to the resist underlayer film by dry etching while using the patterned resist upper layer film as a mask; and
   (I-5) forming a pattern on the substrate to be processed by processing the substrate while using the patterned resist underlayer film as a mask.
[17]: A patterning process for forming a pattern on a substrate to be processed, comprising steps of:
   (II-1) applying the resist underlayer film material according to any one of [1] to [15] on a substrate to be processed, and then heat-treating the material to form a resist underlayer film;
   (II-2) forming a resist intermediate film on the resist underlayer film;
   (II-3) forming a resist upper layer film on the resist intermediate film by using a photoresist material;
   (II-4) pattern-exposing the resist upper layer film, and then developing the exposed resist upper layer film with a developer to form a pattern in the resist upper layer film;
   (II-5) transferring the pattern to the resist intermediate film by dry etching while using the patterned resist upper layer film as a mask;
   (II-6) transferring the pattern to the resist underlayer film by dry etching while using the resist intermediate film having the transferred pattern as a mask; and
   (II-7) forming a pattern on the substrate to be processed by processing the substrate while using the resist underlayer film having the transferred pattern as a mask.
[18]: A patterning process for forming a pattern on a substrate to be processed, comprising steps of:
   (III-1) applying the resist underlayer film material according to any one of [1] to [15] on a substrate to be processed, and then heat-treating the material to form a resist underlayer film;
   (III-2) forming an inorganic hard mask intermediate film selected from a silicon oxide film, a silicon nitride film, and a silicon oxynitride film on the resist underlayer film;
   (III-3) forming an organic thin film on the inorganic hard mask intermediate film;
   (III-4) forming a resist upper layer film on the organic thin film by using a photoresist material;
   (III-5) pattern-exposing the resist upper layer film, and then developing the exposed resist upper layer film with a developer to form a pattern in the resist upper layer film;
   (III-6) transferring the pattern to the organic thin film and the inorganic hard mask intermediate film by dry etching while using the patterned resist upper layer film as a mask;
   (III-7) transferring the pattern to the resist underlayer film by dry etching while using the inorganic hard mask intermediate film having the transferred pattern as a mask; and
   (III-8) forming a pattern on the substrate to be processed by processing the substrate while using the resist underlayer film having the transferred pattern as a mask.
[19]: The patterning process according to [18], wherein the inorganic hard mask intermediate film is formed by a CVD method or an ALD method.
[20]: The patterning process according to any one of [16] to [19], wherein a substrate having a structure or step with 30 nm or more in height is used as the substrate to be processed.
[21]: The patterning process according to any one of [16] to [20], wherein a substrate having a static contact angle with respect to water of 50° or more is used as the substrate to be processed.
[22]: A method for forming a resist underlayer film as an organic planarizing film used in a semiconductor apparatus manufacturing process, comprising:
   applying the resist underlayer film material according to any one of [1] to [15] on a substrate to be processed by spin-coating; and
   heat-treating the substrate coated with the resist underlayer film material within a range at a temperature of 100°C or higher and 600°C or lower for 10 to 600 seconds for curing to form a resist underlayer film.
[23]: A method for forming a resist underlayer film as an organic planarizing film used in a semiconductor apparatus manufacturing process, comprising:
   applying the resist underlayer film material according to any one of [1] to [15] on a substrate to be processed by spin-coating; and
   heat-treating the substrate coated with the resist underlayer film material in an atmosphere with an oxygen concentration of 1 vol% or more and 21 vol% or less for curing to form a resist underlayer film.
[24]: A method for forming a resist underlayer film as an organic planarizing film used in a semiconductor apparatus manufacturing process, comprising:
   applying the resist underlayer film material according to any one of [1] to [15] on a substrate to be processed by spin-coating; and
   heat-treating the substrate coated with the resist underlayer film material in an atmosphere with an oxygen concentration of less than 1 vol% for curing to form a resist underlayer film.
[25]: The method for forming a resist underlayer film according to any one of [22] to [24], wherein a substrate having a structure or step with 30 nm or more in height is used as the substrate to be processed.
[26]: The method for forming a resist underlayer film according to any one of [22] to [25], wherein a substrate having a static contact angle with respect to water of 50° or more is used as the substrate to be processed.

It should be noted that the present invention is not limited to the above-described embodiments. The embodiments are just examples, and any examples that substantially have the same feature and demonstrate the same functions and effects as those in the technical concept disclosed in claims of the present invention are included in the technical scope of the present invention.
The present invention also refers to the following numbered embodiments, wherein the term "claim" means "embodiment":
1. A resist underlayer film material, comprising:
   (A) a compound or resin having a phenolic hydroxy group;
   (B) a base generator; and
   (C) an organic solvent.
2. The resist underlayer film material according to claim 1, wherein the component (A) has a weight-average molecular weight of 3,000 or less in terms of polystyrene.
3. The resist underlayer film material according to claim 1, wherein the base generator (B) is a compound to exhibit basicity by pyrolysis.
4. The resist underlayer film material according to claim 3, wherein the base generator (B) is any one represented by the following general formulae (1), (2), and (3),

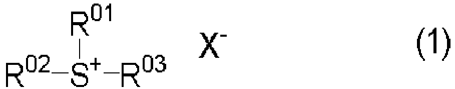

   R⁰⁴-|⁺-R⁰⁵ X⁻ (2)

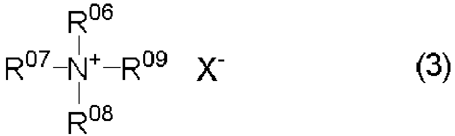

   wherein R⁰¹ to R⁰³ each independently represent a linear, branched, or cyclic alkyl group or alkenyl group having 1 to 10 carbon atoms, optionally substituted with a heteroatom or optionally having an interposed heteroatom, or represent an aryl group or aralkyl group having 6 to 18 carbon atoms, optionally substituted with a heteroatom or optionally having an interposed heteroatom; any two of R⁰¹, R⁰², and R⁰³ are optionally bonded to each other to form a ring together with the sulfur atom in the formula; X⁻ represents an organic or inorganic anion to be a counterion, X⁻ excluding OH⁻; R⁰⁴ and R⁰⁵ each independently represent an aryl group having 6 to 20 carbon atoms, and a part or all of hydrogen atoms thereof are optionally substituted with a linear, branched, or cyclic alkyl group or alkoxy group having 1 to 10 carbon atoms; R⁰⁴ and R⁰⁵ are optionally bonded to each other to form a ring together with the iodine atom in the formula; R⁰⁶, R⁰⁷, R⁰⁸, and R⁰⁹ each independently represent a hydrogen atom, or a linear, branched, or cyclic alkyl group or alkenyl group having 1 to 20 carbon atoms, optionally substituted with a heteroatom or optionally having an interposed heteroatom, or represent an aryl group or aralkyl group having 6 to 18 carbon atoms, optionally substituted with a heteroatom or optionally having an interposed a heteroatom; any two or more of R⁰⁶, R⁰⁷, R⁰⁸, and R⁰⁹ are optionally bonded to each other to form a ring together with the nitrogen atom in the formula.
5. The resist underlayer film material according to claim 4, wherein X⁻ in the general formulae (1), (2), and (3) represents an anion selected from the group consisting of a chloride ion, a bromide ion, an iodide ion, a fluoride ion, a cyanide ion, a nitride ion, a nitrite ion, and any anions represented by the following general formulae (4), (5), and (6),

   R¹⁰-COO⁻ (4)

   R¹¹-SO₃⁻ (5)

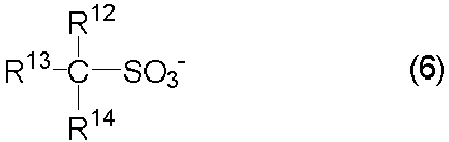

   wherein R¹⁰ represents a linear, branched, or cyclic hydrocarbon group having 1 to 20 carbon atoms selected from an alkyl group, an alkenyl group, an aralkyl group, and an aryl group, the hydrocarbon group optionally having an ether group, an ester group, or a carbonyl group, and optionally substituted one or more of hydrogen atoms thereof with a halogen atom, a hydroxy group, a carboxyl group, an amino group, and a cyano group; R¹¹ represents an aryl group having 1 to 20 carbon atom, and optionally substituted one or more of hydrogen atoms thereof with a halogen atom, a hydroxy group, a carboxyl group, an amino group, and a cyano group; R¹², R¹³, and R¹⁴ each independently represent a hydrogen atom, a halogen atom other than a fluorine atom, or a linear, branched, or cyclic hydrocarbon group having 1 to 20 carbon atoms selected from an alkyl group, an alkenyl group, an aralkyl group, and an aryl group, the hydrocarbon group optionally having an ether group, an ester group, or a carbonyl group, and optionally substituted one or more of hydrogen atoms thereof with a halogen atom, a hydroxy group, a carboxyl group, an amino group, and a cyano group; and two or more of R¹², R¹³, and R¹⁴ are optionally bonded to each other to form a ring.
6. The resist underlayer film material according to claim 4, wherein a conjugate acid of X⁻, X-H, in the general formulae (1), (2), and (3) has a boiling point of 200°C or lower.
7. The resist underlayer film material according to claim 1, wherein the compound (A) having a phenolic hydroxy group is represented by the following general formula (7), 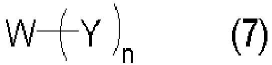
   wherein W represents an n-valent organic group having 2 to 50 carbon atoms; Y represents a terminal group structure represented by the following general formula (8) or general formula (9); proportions of structures represented by the formula (8) and (9) satisfy relationships of a + b = 1.0, 0.70 ≤ a ≤ 0.99, and 0.01 ≤ b ≤ 0.30, where "a" represents a proportion of the structure represented by the formula (8) and "b" represents a proportion of the structure represented by the formula (9); and "n" represents an integer of 1 to 10, 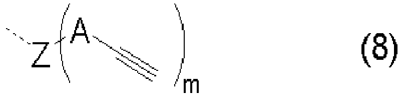
   wherein a broken line represents a bond; Z represents an (m + 1)-valent aromatic group having 6 to 20 carbon atoms; A represents a single bond or -O-(CH₂)ₚ-; "m" represents an integer of 1 to 5; and "p" represents an integer of 1 to 10, 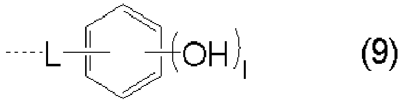
   wherein a broken line represents a bond; L represents a single bond or -(CH₂)ᵣ-; "l" represents 2 or 3; and "r" represents an integer of 1 to 5.
8. The resist underlayer film material according to claim 7, wherein A in the general formula (8) represents -OCH₂-.
9. The resist underlayer film material according to claim 7, wherein the general formula (8) is any one of the following formulae (10), (11), and (12), 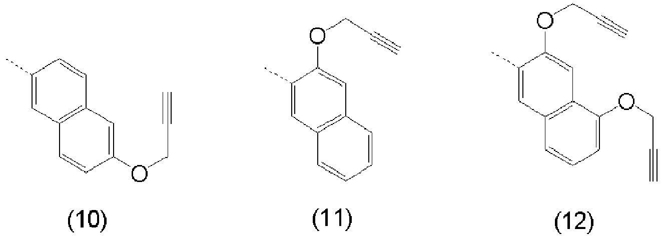 wherein a broken line represents a bond.
10. The resist underlayer film material according to claim 7, wherein the general formula (9) is the following formula (13) or (14), 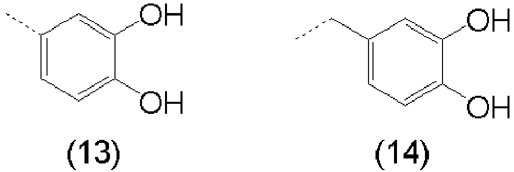 wherein a broken line represents a bond.
11. The resist underlayer film material according to claim 7, wherein W in the general formula (7) is represented by the following general formula (15), 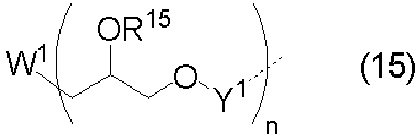 wherein a broken line represents a bond; R¹⁵ represents a hydrogen atom, or one hydrocarbon group of an alkyl group or acyl group, the group having 1 to 20 carbon atoms and optionally having an oxygen atom or a nitrogen atom; W¹ represents an n-valent organic group having 1 to 47 carbon atoms; Y¹ represents a single bond or a carbonyl group; and "n" represents an integer of 1 to 10.
12. The resist underlayer film material according to claim 11, wherein W¹ in the general formula (15) represents a structure represented by any one of the following formulae, 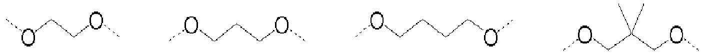 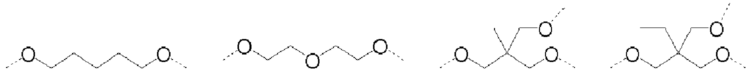 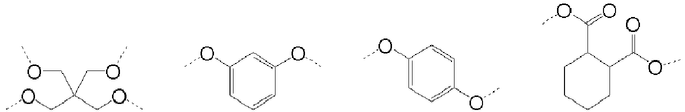 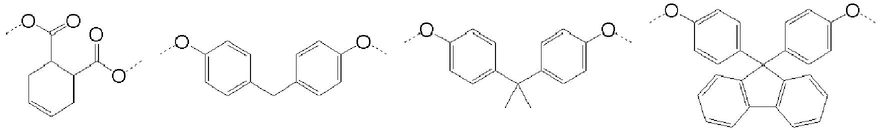 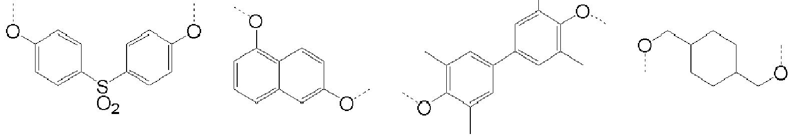 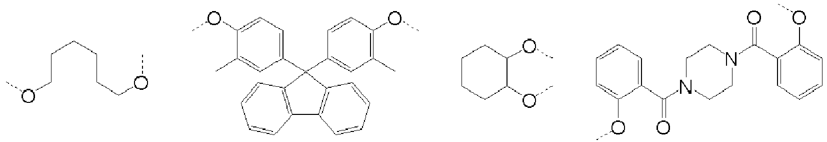 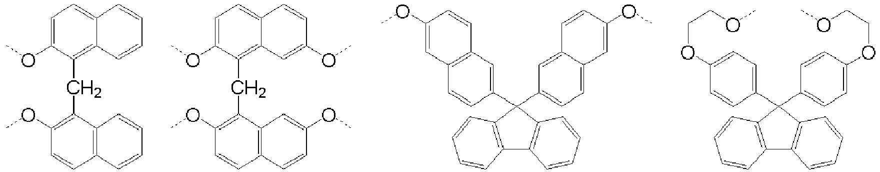 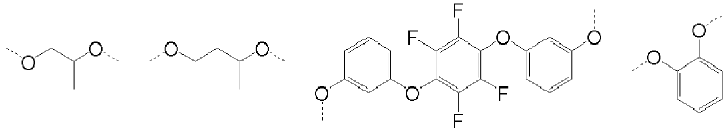 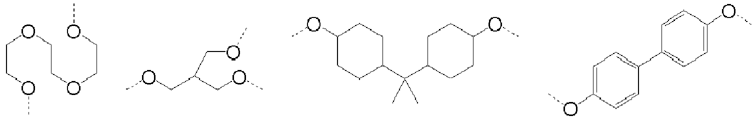 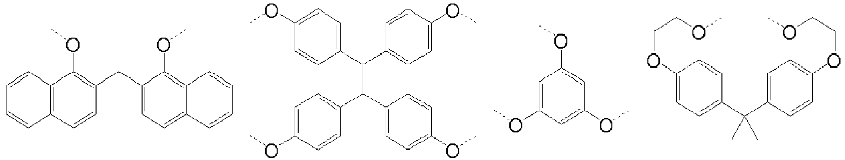 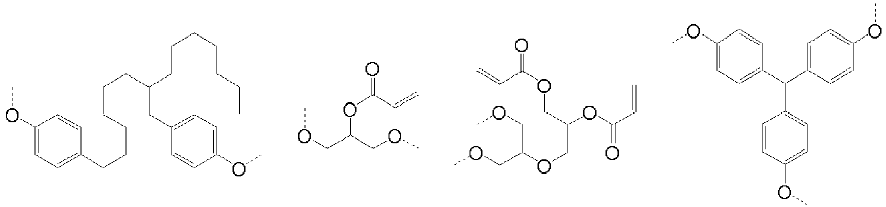 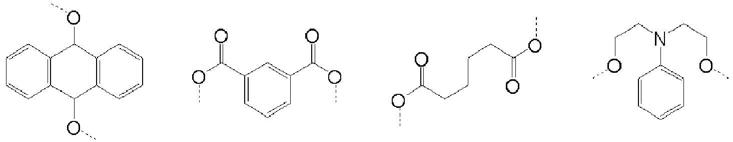 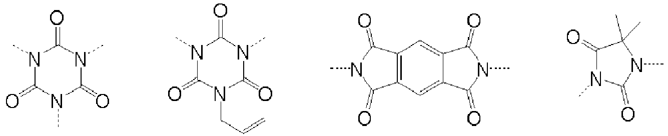 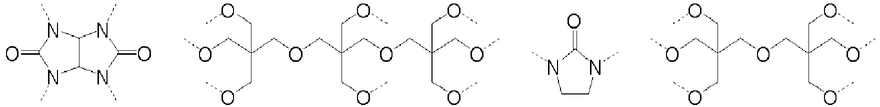 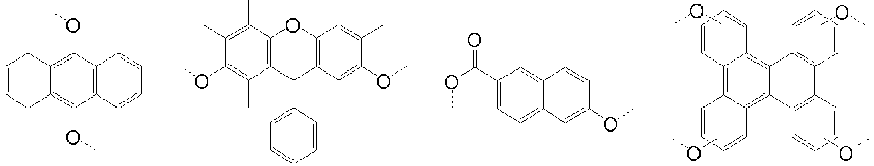 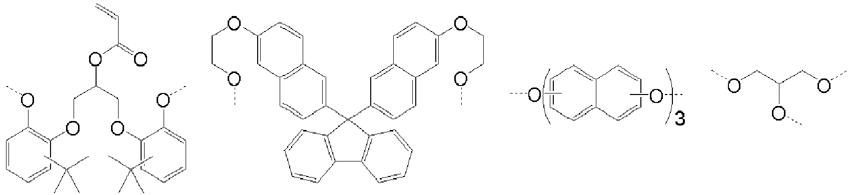 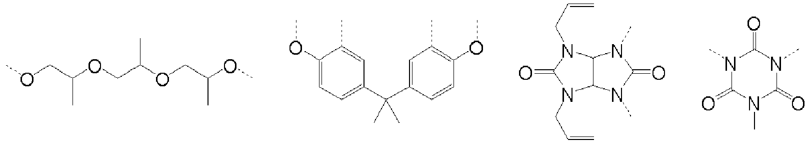 wherein a broken line represents a bond.
13. The resist underlayer film material according to claim 1, wherein the organic solvent (C) is a mixture of one or more kinds of organic solvents having a boiling point of lower than 180°C and one or more kinds of organic solvents having a boiling point of 180°C or higher.
14. The resist underlayer film material according to claim 1, further comprising one or more of (D) a surfactant, (E) a crosslinker, (F) a plasticizer, and (G) a colorant.
15. The resist underlayer film material according to claim 14, wherein the crosslinker (E) is a compound represented by the following general formula (16), 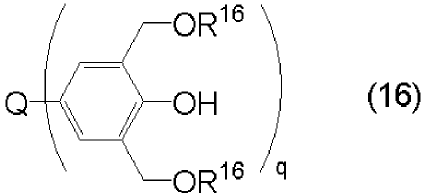 wherein Q represents a single bond or a q-valent hydrocarbon group having 1 to 20 carbon atoms; R¹⁶ represents a hydrogen atom or an alkyl group having 1 to 20 carbon atoms; and "q" represents an integer of 1 to 5.
16. A patterning process for forming a pattern on a substrate to be processed, comprising steps of:
   (I-1) applying the resist underlayer film material according to any one of claims 1 to 15 on a substrate to be processed, and then heat-treating the material to form a resist underlayer film;
   (I-2) forming a resist upper layer film on the resist underlayer film by using a photoresist material;
   (I-3) pattern-exposing the resist upper layer film, and then developing the exposed resist upper layer film with a developer to form a pattern in the resist upper layer film;
   (I-4) transferring the pattern to the resist underlayer film by dry etching while using the patterned resist upper layer film as a mask; and
   (I-5) forming a pattern on the substrate to be processed by processing the substrate while using the patterned resist underlayer film as a mask.
17. A patterning process for forming a pattern on a substrate to be processed, comprising steps of:
   (II-1) applying the resist underlayer film material according to any one of claims 1 to 15 on a substrate to be processed, and then heat-treating the material to form a resist underlayer film;
   (II-2) forming a resist intermediate film on the resist underlayer film;
   (II-3) forming a resist upper layer film on the resist intermediate film by using a photoresist material;
   (II-4) pattern-exposing the resist upper layer film, and then developing the exposed resist upper layer film with a developer to form a pattern in the resist upper layer film;
   (II-5) transferring the pattern to the resist intermediate film by dry etching while using the patterned resist upper layer film as a mask;
   (II-6) transferring the pattern to the resist underlayer film by dry etching while using the resist intermediate film having the transferred pattern as a mask; and
   (II-7) forming a pattern on the substrate to be processed by processing the substrate while using the resist underlayer film having the transferred pattern as a mask.
18. A patterning process for forming a pattern on a substrate to be processed, comprising steps of:
   (III-1) applying the resist underlayer film material according to any one of claims 1 to 15 on a substrate to be processed, and then heat-treating the material to form a resist underlayer film;
   (III-2) forming an inorganic hard mask intermediate film selected from a silicon oxide film, a silicon nitride film, and a silicon oxynitride film on the resist underlayer film;
   (III-3) forming an organic thin film on the inorganic hard mask intermediate film;
   (III-4) forming a resist upper layer film on the organic thin film by using a photoresist material;
   (III-5) pattern-exposing the resist upper layer film, and then developing the exposed resist upper layer film with a developer to form a pattern in the resist upper layer film;
   (III-6) transferring the pattern to the organic thin film and the inorganic hard mask intermediate film by dry etching while using the patterned resist upper layer film as a mask;
   (III-7) transferring the pattern to the resist underlayer film by dry etching while using the inorganic hard mask intermediate film having the transferred pattern as a mask; and
   (III-8) forming a pattern on the substrate to be processed by processing the substrate while using the resist underlayer film having the transferred pattern as a mask.
19. The patterning process according to claim 18, wherein the inorganic hard mask intermediate film is formed by a CVD method or an ALD method.
20. The patterning process according to claim 16, wherein a substrate having a structure or step with 30 nm or more in height is used as the substrate to be processed.
21. The patterning process according to claim 16, wherein a substrate having a static contact angle with respect to water of 50° or more is used as the substrate to be processed.
22. A method for forming a resist underlayer film as an organic planarizing film used in a semiconductor apparatus manufacturing process, comprising:
   applying the resist underlayer film material according to any one of claims 1 to 15 on a substrate to be processed by spin-coating; and
   heat-treating the substrate coated with the resist underlayer film material within a range at a temperature of 100°C or higher and 600°C or lower for 10 to 600 seconds for curing to form a resist underlayer film.
23. A method for forming a resist underlayer film as an organic planarizing film used in a semiconductor apparatus manufacturing process, comprising:
   applying the resist underlayer film material according to any one of claims 1 to 15 on a substrate to be processed by spin-coating; and
   heat-treating the substrate coated with the resist underlayer film material in an atmosphere with an oxygen concentration of 1 vol% or more and 21 vol% or less for curing to form a resist underlayer film.
24. A method for forming a resist underlayer film as an organic planarizing film used in a semiconductor apparatus manufacturing process, comprising:
   applying the resist underlayer film material according to any one of claims 1 to 15 on a substrate to be processed by spin-coating; and
   heat-treating the substrate coated with the resist underlayer film material in an atmosphere with an oxygen concentration of less than 1 vol% for curing to form a resist underlayer film.
25. The method for forming a resist underlayer film according to claim 22, wherein a substrate having a structure or step with 30 nm or more in height is used as the substrate to be processed.
26. The method for forming a resist underlayer film according to claim 22, wherein a substrate having a static contact angle with respect to water of 50° or more is used as the substrate to be processed.

## Claims

1. A resist underlayer film material, comprising:
(A) a compound or resin having a phenolic hydroxy group;
(B) a base generator; and
(C) an organic solvent.

2. The resist underlayer film material according to claim 1, wherein the component (A) has a weight-average molecular weight of 3,000 or less in terms of polystyrene.

3. The resist underlayer film material according to claim 1 or 2, wherein the base generator (B) is a compound to exhibit basicity by pyrolysis.

4. The resist underlayer film material according to anyone of claims 1 to 3, wherein the base generator (B) is any one represented by the following general formulae (1), (2), and (3), 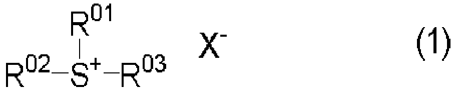
R⁰⁴_|+-R⁰⁵ X⁻ (2) 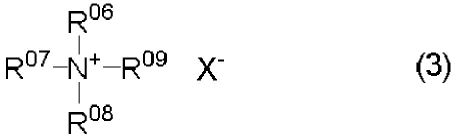
wherein R⁰¹ to R⁰³ each independently represent a linear, branched, or cyclic alkyl group or alkenyl group having 1 to 10 carbon atoms, optionally substituted with a heteroatom or optionally having an interposed heteroatom, or represent an aryl group or aralkyl group having 6 to 18 carbon atoms, optionally substituted with a heteroatom or optionally having an interposed heteroatom; any two of R⁰¹, R⁰², and R⁰³ are optionally bonded to each other to form a ring together with the sulfur atom in the formula; X- represents an organic or inorganic anion to be a counterion, X-excluding OH-; R⁰⁴ and R⁰⁵ each independently represent an aryl group having 6 to 20 carbon atoms, and a part or all of hydrogen atoms thereof are optionally substituted with a linear, branched, or cyclic alkyl group or alkoxy group having 1 to 10 carbon atoms; R⁰⁴ and R⁰⁵ are optionally bonded to each other to form a ring together with the iodine atom in the formula; R⁰⁶, R⁰⁷, R⁰⁸, and R⁰⁹ each independently represent a hydrogen atom, or a linear, branched, or cyclic alkyl group or alkenyl group having 1 to 20 carbon atoms, optionally substituted with a heteroatom or optionally having an interposed heteroatom, or represent an aryl group or aralkyl group having 6 to 18 carbon atoms, optionally substituted with a heteroatom or optionally having an interposed a heteroatom; any two or more of R⁰⁶, R⁰⁷, R⁰⁸, and R⁰⁹ are optionally bonded to each other to form a ring together with the nitrogen atom in the formula; preferably
a)
wherein X- in the general formulae (1), (2), and (3) represents an anion selected from the group consisting of a chloride ion, a bromide ion, an iodide ion, a fluoride ion, a cyanide ion, a nitride ion, a nitrite ion, and any anions represented by the following general formulae (4), (5), and (6),
R¹⁰-COO⁻ (4)
R¹¹-SO₃⁻ (5) 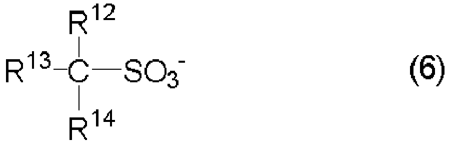
wherein R¹⁰ represents a linear, branched, or cyclic hydrocarbon group having 1 to 20 carbon atoms selected from an alkyl group, an alkenyl group, an aralkyl group, and an aryl group, the hydrocarbon group optionally having an ether group, an ester group, or a carbonyl group, and optionally substituted one or more of hydrogen atoms thereof with a halogen atom, a hydroxy group, a carboxyl group, an amino group, and a cyano group; R¹¹ represents an aryl group having 1 to 20 carbon atom, and optionally substituted one or more of hydrogen atoms thereof with a halogen atom, a hydroxy group, a carboxyl group, an amino group, and a cyano group; R¹², R¹³, and R¹⁴ each independently represent a hydrogen atom, a halogen atom other than a fluorine atom, or a linear, branched, or cyclic hydrocarbon group having 1 to 20 carbon atoms selected from an alkyl group, an alkenyl group, an aralkyl group, and an aryl group, the hydrocarbon group optionally having an ether group, an ester group, or a carbonyl group, and optionally substituted one or more of hydrogen atoms thereof with a halogen atom, a hydroxy group, a carboxyl group, an amino group, and a cyano group; and two or more of R¹², R¹³, and R¹⁴ are optionally bonded to each other to form a ring; or
b)
wherein a conjugate acid of X⁻, X-H, in the general formulae (1), (2), and (3) has a boiling point of 200°C or lower.

5. The resist underlayer film material according to anyone of claims 1 to 4, wherein the compound (A) having a phenolic hydroxy group is represented by the following general formula (7), 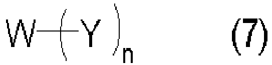
wherein W represents an n-valent organic group having 2 to 50 carbon atoms; Y represents a terminal group structure represented by the following general formula (8) or general formula (9); proportions of structures represented by the formula (8) and (9) satisfy relationships of a + b = 1.0, 0.70 ≤ a ≤ 0.99, and 0.01 ≤ b ≤ 0.30, where "a" represents a proportion of the structure represented by the formula (8) and "b" represents a proportion of the structure represented by the formula (9); and "n" represents an integer of 1 to 10, 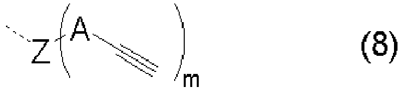
wherein a broken line represents a bond; Z represents an (m + 1)-valent aromatic group having 6 to 20 carbon atoms; A represents a single bond or -O-(CH₂)ₚ-; "m" represents an integer of 1 to 5; and "p" represents an integer of 1 to 10, 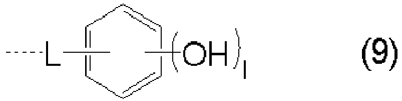
wherein a broken line represents a bond; L represents a single bond or -(CH₂)ᵣ-; "l" represents 2 or 3; and "r" represents an integer of 1 to 5;
preferably
a)
wherein A in the general formula (8) represents -OCH₂-; or
b)
wherein the general formula (8) is any one of the following formulae (10), (11), and (12), 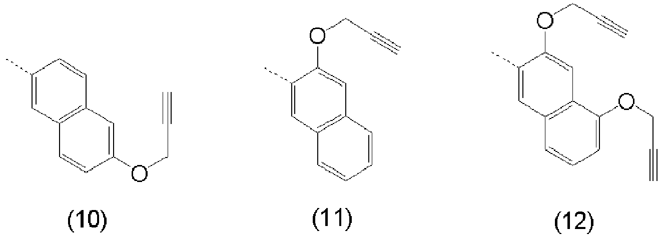 wherein a broken line represents a bond; or
c)
wherein the general formula (9) is the following formula (13) or (14), 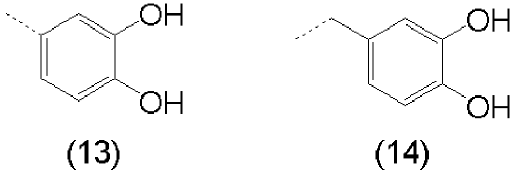 wherein a broken line represents a bond; or
d)
wherein W in the general formula (7) is represented by the following general formula (15), 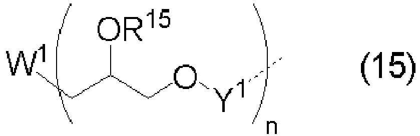 wherein a broken line represents a bond; R¹⁵ represents a hydrogen atom, or one hydrocarbon group of an alkyl group or acyl group, the group having 1 to 20 carbon atoms and optionally having an oxygen atom or a nitrogen atom; W¹ represents an n-valent organic group having 1 to 47 carbon atoms; Y¹ represents a single bond or a carbonyl group; and "n" represents an integer of 1 to 10.

6. The resist underlayer film material according to claim 5d, wherein W¹ in the general formula (15) represents a structure represented by any one of the following formulae, 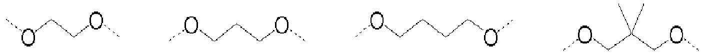 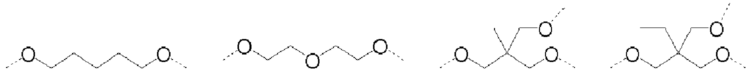 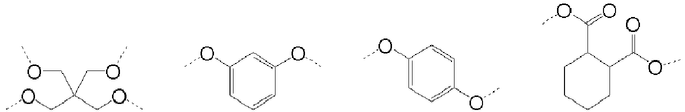 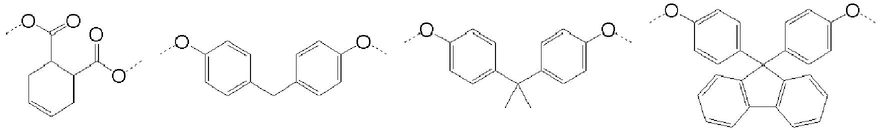 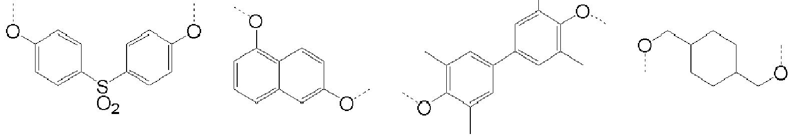 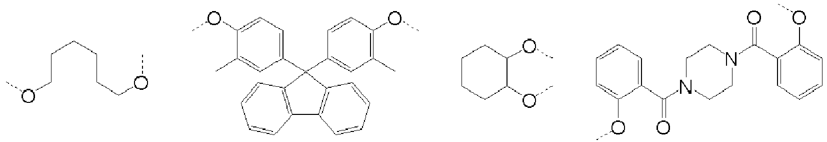 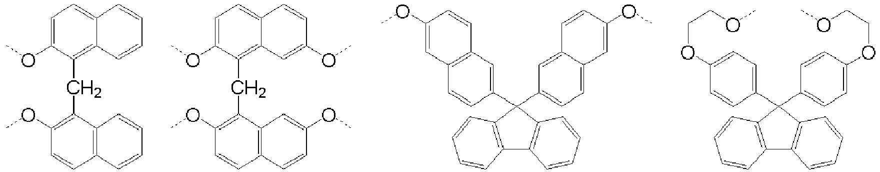 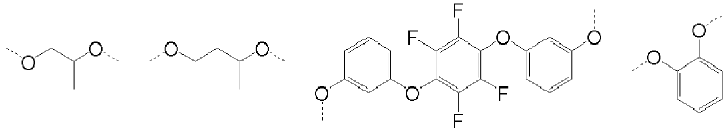 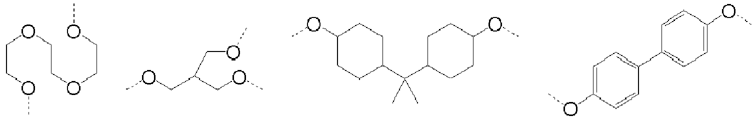 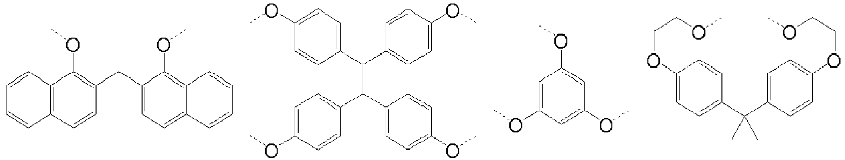 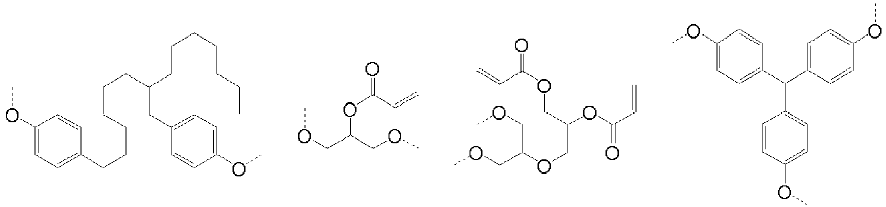 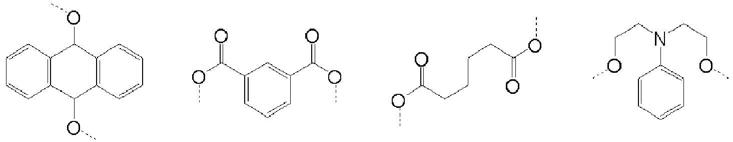 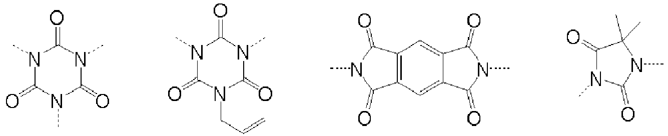 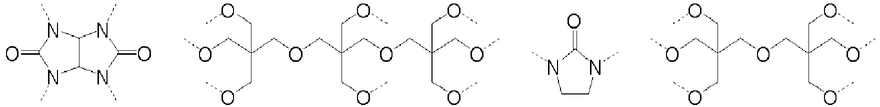 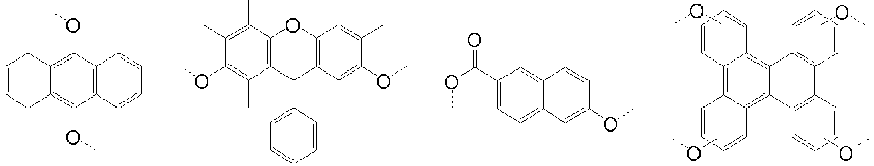 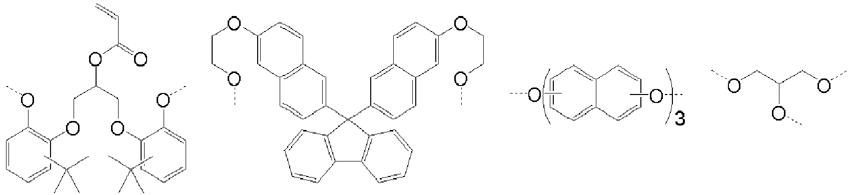 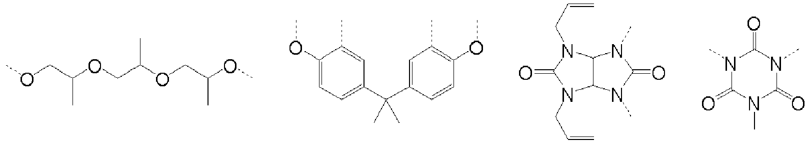 wherein a broken line represents a bond.

7. The resist underlayer film material according to anyone of claims 1 to 6, wherein the organic solvent (C) is a mixture of one or more kinds of organic solvents having a boiling point of lower than 180°C and one or more kinds of organic solvents having a boiling point of 180°C or higher.

8. The resist underlayer film material according to anyone of claims 1 to 7, further comprising one or more of (D) a surfactant, (E) a crosslinker, (F) a plasticizer, and (C) a colorant; preferably
wherein the crosslinker (E) is a compound represented by the following general formula (16), 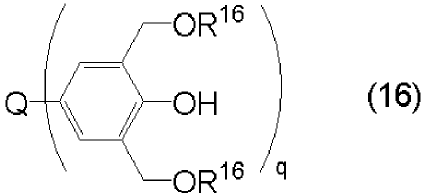 wherein Q represents a single bond or a q-valent hydrocarbon group having 1 to 20 carbon atoms; R¹⁶ represents a hydrogen atom or an alkyl group having 1 to 20 carbon atoms; and "q" represents an integer of 1 to 5.

9. A patterning process for forming a pattern on a substrate to be processed, comprising steps of:
a)
(I-1) applying the resist underlayer film material according to any one of claims 1 to 8 on a substrate to be processed, and then heat-treating the material to form a resist underlayer film;
(1-2) forming a resist upper layer film on the resist underlayer film by using a photoresist material;
(1-3) pattern-exposing the resist upper layer film, and then developing the exposed resist upper layer film with a developer to form a pattern in the resist upper layer film;
(1-4) transferring the pattern to the resist underlayer film by dry etching while using the patterned resist upper layer film as a mask; and
(1-5) forming a pattern on the substrate to be processed by processing the substrate while using the patterned resist underlayer film as a mask; or
b)
(II-1) applying the resist underlayer film material according to any one of claims 1 to 8 on a substrate to be processed, and then heat-treating the material to form a resist underlayer film;
(II-2) forming a resist intermediate film on the resist underlayer film;
(II-3) forming a resist upper layer film on the resist intermediate film by using a photoresist material;
(II-4) pattern-exposing the resist upper layer film, and then developing the exposed resist upper layer film with a developer to form a pattern in the resist upper layer film;
(II-5) transferring the pattern to the resist intermediate film by dry etching while using the patterned resist upper layer film as a mask;
(II-6) transferring the pattern to the resist underlayer film by dry etching while using the resist intermediate film having the transferred pattern as a mask; and
(II-7) forming a pattern on the substrate to be processed by processing the substrate while using the resist underlayer film having the transferred pattern as a mask; or
c)
(III-1) applying the resist underlayer film material according to any one of claims 1 to 8 on a substrate to be processed, and then heat-treating the material to form a resist underlayer film;
(III-2) forming an inorganic hard mask intermediate film selected from a silicon oxide film, a silicon nitride film, and a silicon oxynitride film on the resist underlayer film;
(III-3) forming an organic thin film on the inorganic hard mask intermediate film;
(III-4) forming a resist upper layer film on the organic thin film by using a photoresist material;
(III-5) pattern-exposing the resist upper layer film, and then developing the exposed resist upper layer film with a developer to form a pattern in the resist upper layer film;
(III-6) transferring the pattern to the organic thin film and the inorganic hard mask intermediate film by dry etching while using the patterned resist upper layer film as a mask;
(III-7) transferring the pattern to the resist underlayer film by dry etching while using the inorganic hard mask intermediate film having the transferred pattern as a mask; and
(III-8) forming a pattern on the substrate to be processed by processing the substrate while using the resist underlayer film having the transferred pattern as a mask.

10. The patterning process according to claim 9c, wherein the inorganic hard mask intermediate film is formed by a CVD method or an ALD method.

11. The patterning process according to anyone of claims 9a to 10, wherein a substrate having a structure or step with 30 nm or more in height is used as the substrate to be processed.

12. The patterning process according to anyone of claims 9a to 11, wherein a substrate having a static contact angle with respect to water of 50° or more is used as the substrate to be processed.

13. A method for forming a resist underlayer film as an organic planarizing film used in a semiconductor apparatus manufacturing process, comprising:
applying the resist underlayer film material according to any one of claims 1 to 8 on a substrate to be processed by spin-coating; and
a)
heat-treating the substrate coated with the resist underlayer film material within a range at a temperature of 100°C or higher and 600°C or lower for 10 to 600 seconds for curing to form a resist underlayer film; or
b)
heat-treating the substrate coated with the resist underlayer film material in an atmosphere with an oxygen concentration of 1 vol% or more and 21 vol% or less for curing to form a resist underlayer film; or
c)
heat-treating the substrate coated with the resist underlayer film material in an atmosphere with an oxygen concentration of less than 1 vol% for curing to form a resist underlayer film.

14. The method for forming a resist underlayer film according to anyone of claims 13a to 13c, wherein a substrate having a structure or step with 30 nm or more in height is used as the substrate to be processed.

15. The method for forming a resist underlayer film according to anyone of claims 13a to 14, wherein a substrate having a static contact angle with respect to water of 50° or more is used as the substrate to be processed.
